(19) Europäisches Patentamt
European Patent Office
Office européen des brevets

(11) EP 1 705 522 A2

(12) **EUROPEAN PATENT APPLICATION**

(43) Date of publication:
**27.09.2006 Bulletin 2006/39**

(51) Int Cl.:
***G03F 7/213*** *(2006.01)*

(21) Application number: **06005779.1**

(22) Date of filing: **21.03.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **22.03.2005 JP 2005081804**
**16.08.2005 JP 2005235800**
**19.08.2005 JP 2005238733**

(71) Applicant: **FUJI PHOTO FILM CO., LTD.**
**Minami-Ashigara-shi, Kanagawa (JP)**

(72) Inventors:
- **Goto, Takahiro**
  **Yoshida-cho**
  **Haibara-gun**
  **Shizuoka (JP)**
- **Inno, Toshifumi**
  **Yoshida-cho**
  **Haibara-gun**
  **Shizuoka (JP)**

(74) Representative: **HOFFMANN EITLE**
**Patent- und Rechtsanwälte**
**Arabellastrasse 4**
**81925 München (DE)**

(54) **Plate-making method of lithographic printing plate precursor**

(57) A plate-making method of a lithographic printing plate precursor, which comprises exposing a lithographic printing plate precursor comprising a support and a photosensitive layer by utilizing an inner drum exposure apparatus having mounted thereon a light source having an oscillation wavelength in a range from 360 to 450 nm, wherein the photosensitive layer comprises a photosensitive composition comprising: a sensitizing dye capable of absorbing light at 360 to 450 nm; a polymerization initiator; a polymenzable compound; and a binder polymer, wherein the inner drum exposure apparatus produces a light beam spot shape of a light beam emitted from the light source in which the light beam is divided into an ordinary ray and an extraordinary ray parallel to each other at an equivalent light quantity, and two beam spots of the ordinary and extraordinary ray are adjacently arrayed in a sub-scanning direction so as to partially overlap with each other.

*FIG. 1*

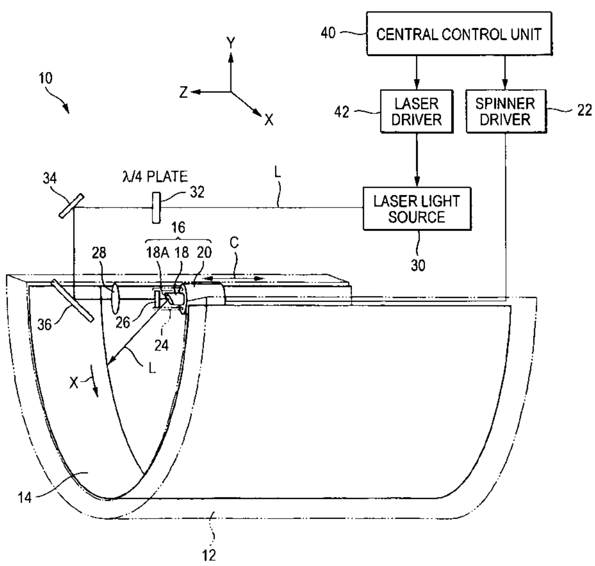


EP 1 705 522 A2

Printed by Jouve, 75001 PARIS (FR)

## Description

## Backgroud of the Invention

1. Field of the Invention

The present invention relates to a plate-making method of a lithographic printing plate precursor. More specifically, the present invention relates to a plate-making method of a lithographic printing plate precursor suitable for high-precision AM screen printing or FM screen printing with a screen ruling of 200 or more.

2. Description of the Related Art

A lithographic printing plate conventionally has a constitution such that a photosensitive resin layer is provided on a support having a hydrophilic surface, and as for the plate-making method therefor, a desired printing plate is usually obtained by performing surface exposure (mask exposure) through a lith film and removing the non-image area with a developer. However, with recent progress of digitization technology, a computer-to-plate (CTP) technique of scanning highly directive light such as laser light on the plate surface according to the digitized image information, thereby effecting the exposure process directly on the plate surface without intervention of a lith film, has been developed. Also, a photosensitive lithographic printing plate suitable for this technique is being developed.

Such a photosensitive lithographic printing plate precursor suitable for exposure with laser light includes a photosensitive lithographic printing plate using a polymerizable photosensitive layer. By selecting a photopolymerization initiator or a polymerization initiation system (hereinafter simply referred to as an "initiator" or an "initiation system"), the polymerizable photosensitive layer can be easily made to have high sensitivity as compared with other conventional photosensitive layers.

As for the laser light source, for example, a semiconductor layer or FD-YAG laser of 405 nm or 830 nm is used. In recent years, from the standpoint of handleability, a CTP system having mounted thereon a blue-violet semiconductor laser of 405 mm is widespread.

However, when image-drawing on the above-described photosensitive lithographic printing plate precursor is performed by the blue-violet laser light of 405 nm, the sharpness at the edge part of the image depends on the energy distribution shape of laser light and due to shortage of exposure amount, an insufficiently polymerized region is formed. As a result, the sharpness at the edge part of the image is impaired and reduction in the resolution is incurred. Furthermore, such insufficiently polymerized edge part of the image gives rise to removal failure in the development process step depending on the alkali concentration of developer or the condition of developing brush, and the produced printing plate comes to have large in-plane fluctuation of the dot area.

Furthermore, the support used for such a printing plate is a support in which irregularities are formed on the surface by an electrolytic treatment or a brush treatment so as to secure hydrophilicity, and therefore, the image quality and sharpness are more impaired due to scattering of reflected light at the laser exposure, as a result, reproducibility of the shadow part greatly decreases.

On the other hand, demands for high-precision AM screen printing or FM screen printing are recently increasing in the field of CTP, and resolution of the lithographic printing plate precursor has now come to be an important performance.

An FM (frequency modulated) screen is a screen where fine dots of about 20 microns are randomly disposed irrespective of a screen angle or ruling and the density gradation is expressed by the dot density per unit area. This FM screen printed matter is advantageous in that neither moire nor rosette pattern is produced, tone jump in the midtone part near 50% does not occur and by virtue of small dot, overlapping of dots with each other is reduced so that the reproduced colors can look clear.

On the other hand, an AM (amplitude modulation) screen is a screen where dots are regularly arranged at a certain angle and the density gradation is expressed by the dot size per unit area. The AM screen ruling in Japan is 175 lines per inch. Those using a ruling of 200 lines per inch or more are generally called a high-precision screen.

The high-precision printed matter is characterized, for example, by reduced Moire or rosette pattern, improved image texture, elevated realistic feeling, and enhanced reproduction of details.

However, in the plate-making method of drawing an image on the above-described photosensitive lithographic printing plate precursor with laser light of 405 nm, reproducibility of the shadow part is decreased, and a printing plate suitable for the FM screen or high-precision AM screen printing can be hardly provided.

JP-A-2003-43703 (the term "JP-A" as used herein means an "unexamined published Japanese patent application") discloses a photosensitive lithographic printing plate in which an intermediate layer containing a polymer compound with a structural unit having a sulfonic acid group in the side chain is provided on a support, and a polymerizable photosensitive layer is provided thereon. However, this is still insufficient as a printing material suitable for high-precision AM screen printing or FM screen printing. In particular, flat tint unevenness in the FM screen printing is serious, and an

FM screen can be hardly used.

Also, JP-A-10-133132 discloses an inner drum exposure apparatus widely used as the exposure apparatus, where a light beam such as laser beam is introduced to the photosensitive surface of a lithographic printing plate precursor disposed on the inner circumferential surface of a cylindrical drum, thereby performing scanning exposure process (inner surface scanning-type light beam scanning exposure apparatus). Such an inner drum exposure apparatus is constituted to form an image by focusing light emitted from a single transverse-mode laser light source on the surface to be scanned and therefore, the beam spot shape is Gauss-distributed. In the case of recording a picture element by the exposure with a Gauss-distributed beam spot, the half-value width of beam spot is designed to be nearly the same as or larger than the picture element size so as not to form a gap between scanning beams. Accordingly, in the image formed by the recording of an FM screen where the recorded picture element has a long peripheral length, fluctuation in the density or area is readily generated depending on light power variation or development conditions such as brush pressure of automatic developing machine or temperature or pH of developer. That is, the conventional inner drum exposure apparatus has a problem that an FM screen can be hardly utilized.

## Summary of the Invention

An object of the present invention is to provide a plate-making method of a lithographic printing plate precursor allowing for writing by a blue laser and capable of giving a printing plate where a high-quality halftone dot of an FM screen can be stably obtained.

As a result of intensive investigations to attain the above-described object, the present inventors have found that the object can be attained when a specific composition is used as the photosensitive composition for forming the photosensitive layer of a lithographic printing plate precursor and at the same time, the exposure is performed by an exposure apparatus of producing a beam spot shape such that a light beam is divided in parallel into an ordinary ray and an extraordinary ray at an equivalent light quantity and two beam spots are adjacently arrayed in the sub-scanning direction to partially overlap. The present invention has been accomplished based on this finding.

That is, the present invention is as follows.

(1) A plate-making method of a lithographic printing plate precursor, which comprises exposing a lithographic printing plate precursor comprising a support and a photosensitive layer by utilizing an inner drum exposure apparatus having mounted thereon a light source having an oscillation wavelength in a range from 360 to 450 nm,
wherein the photosensitive layer comprises a photosensitive composition comprising: a sensitizing dye capable of absorbing light at 360 to 450 nm; a polymerization initiator; a polymerizable compound; and a binder polymer,
wherein the inner drum exposure apparatus produces a light beam spot shape of a light beam emitted from the light source in which the light beam is divided into an ordinary ray and an extraordinary ray parallel to each other at an equivalent light quantity, and two beam spots of the ordinary ray and the extraordinary ray are adjacently arrayed in a sub-scanning direction so as to partially overlap with each other, and
wherein the lithographic printing plate precursor is loaded on the inner drum exposure apparatus and then subjected to image recording by exposure with the light beam spot shape.
(2) The plate-making method as described in (1) above,
wherein the image recording at the exposure is performed by utilizing an FM screen.
(3) The plate-making method as described in (1) or (2) above,
wherein a wet or dry development process is performed after the image recording.
(4) The plate-making method as described in (3) above,
wherein wet development by alkali development or water development is performed at the development process.
(5) The plate-making method as described in any of (1) to (4) above,
wherein the lithographic printing plate precursor further comprises a protective layer on the photosensitive layer.
(6) A plate-making method of a lithographic printing plate precursor, which comprises: exposing a lithographic printing plate precursor comprising a support and a photosensitive layer by utilizing an inner drum exposure apparatus having mounted thereon a light source having an oscillation wavelength in a range from 360 to 450 nm; and then removing a photosensitive layer in an unexposed area by rubbing the plate surface with a rubbing member in a presence of a developer at a pH of 2 to 10 in an automatic processor equipped with a rubbing member,
wherein the photosensitive layer comprises a photosensitive composition comprising: a sensitizing dye capable of absorbing light at 360 to 450 nm; a polymerization initiator; a polymerizable compound; and a hydrophobic binder polymer,
wherein the inner drum exposure apparatus produces a light beam spot shape of a light beam emitted from the light source in which the light beam is divided into an ordinary ray and an extraordinary ray parallel to each other at an equivalent light quantity, and two beam spots of the ordinary ray and the extraordinary ray are adjacently arrayed in a sub-scanning direction so as to partially overlap with each other, and

wherein the lithographic printing plate precursor is loaded on the inner drum exposure apparatus and then subjected to image recording by exposure with the light beam spot shape.

(7) The plate-making method as described in (6) above,
wherein the image recording at the exposure is performed by utilizing an FM screen.

(8) The plate-making method as described in (6) or (7) above,
wherein the lithographic printing plate precursor further comprises a protective layer on the photosensitive layer.

(9) The plate-making method as described in any of (6) to (8) above,
wherein the hydrophobic binder polymer has an acid value of 0.3 meq/g or less.

(10) The plate-making method as described in any of (6) to (9) above,
wherein the hydrophobic binder polymer is at least one member selected from a (meth)acrylic copolymer having a crosslinking group in a side chan and a polyurethane resin having a crosslinking group in a side chain.

(11) The plate-making method as described in any of (6) to (10) above,
wherein constituent components of the photosensitive layer are partially or entirely enclosed in a microcapsule.

(12) The plate-making method as described in any of (6) to (11) above,
wherein the rubbing member comprises at least two rotating brush rollers.

(13) The plate-making method as described in any of (6) to (12) above,
wherein a pH of the developer is from 3 to 8.

(14) The plate-making method as described in any of (1) to (13) above,
wherein the polymerization initiator is a hexaarylbiimidazole.

The operation of mode of the present invention is presumed as follows.

In the plate-making method of a lithographic printing plate precursor of the present invention, the light beam is made to be more rectangular instead of its original Gauss distribution, so that the light beam used for exposure can be divided in parallel into an ordinary ray and an extraordinary ray at an equivalent light quantity and the beam spots can be adjacently arrayed in the sub-scanning direction to partially overlap. The image exposed with a rectangular beam is less susceptible to fluctuation of exposure conditions and development conditions. By combining an exposure apparatus capable of such an exposure operation with a lithographic printing plate precursor having a photosensitive layer formed of a specific photosensitive composition, a high-quality halftone dot can be stably obtained free from governance by various development conditions and the like.

## Brief Description of the Drawings

Fig. 1 is a schematic structural view showing the inner drum exposure apparatus according to the first embodiment;
Fig. 2 is a schematic structural view showing the main parts of the spinner mirror unit in the inner drum exposure apparatus according to the first embodiment;
Fig. 3 is an explanatory view showing the operation of the optical device of uniaxial crystal used in the inner drum exposure apparatus according to the first embodiment;
Fig. 4 is an explanatory view showing the light quantity distribution of the beam spot beam-split by the inner drum exposure apparatus according to the first embodiment;
Fig. 5 is an explanatory view showing the light quantity distribution of the Gauss-distributed beam spot shape conventionally used in general, for comparison with the light quantity distribution of the beam spot beam-split by the inner drum exposure apparatus according to the first embodiment;
Fig. 6 is a schematic structural view showing the inner drum exposure apparatus according to the second embodiment;
Figs. 7A, 7B and 7C are each a view for explaining the principle according to the second embodiment;
Figs. 8A and 8B are each a view for explaining the principle according to the second embodiment;
Fig. 9 is an explanatory view showing the scanning lines on a recording medium according to the second embodiment;
Figs. 10A and 10B are each a view showing the trajectory of the light beam on a surface conjugate with a recording medium according to the second embodiment;
Fig. 11 is a circuit block diagram for the driving of an acoustooptic device used in the inner drum exposure apparatus according to the second embodiment; and
Fig. 12 is an explanatory view showing the structure of an automatic developing machine.

## Detailed Description of the Invention

The plate-making method of a lithographic printing plate precursor of the present invention is described in detail

below.

The plate-making method of a lithographic printing plate precursor of the present invention is a plate-making method comprising exposing a lithographic printing plate precursor having at least a photosensitive layer on a support by using an inner drum exposure apparatus having mounted thereon a light source having an oscillation wavelength in the range from 360 to 450 nm, wherein the photosensitive layer is formed of a photosensitive composition comprising a sensitizing dye capable of absorbing light at 360 to 450 nm, a polymerization initiator, a polymerizable compound and a binder polymer, the light source of the exposure apparatus emits a light beam of producing a light beam spot shape such that a light beam is divided in parallel into an ordinary ray and an extraordinary ray at an equivalent light quantity and the two beam spots are adjacently arrayed in the sub-scanning direction to partially overlap, and the lithographic printing plate precursor is loaded on the inner drum exposure apparatus and then subjected to image recording by exposure having the light beam spot shape.

<Lithographic Printing Plate Precursor>

The lithographic printing plate precursor for use in the present invention comprises a support having thereon a photosensitive layer formed of a photosensitive composition comprising a sensitizing dye capable of absorbing light at 360 to 450 nm, a polymerization initiator, a polymerizable compound and a binder polymer.

These members constituting the lithographic printing plate precursor each is described below.

[Photosensitive Layer]

The photosensitive layer of the lithographic printing plate precursor according to the present invention is a polymerizable negative-working photosensitive layer formed of a photosensitive composition comprising, as essential components, a sensitizing dye capable of absorbing light at 360 to 450 nm, a polymerization initiator, a polymerizable compound (hereinafter sometimes referred to as an "addition-polymerizable compound") and a binder polymer and, if desired, further containing a coloring agent and other optional components.

The polymerizable negative-working photosensitive layer for use in the present invention responds to light at 360 to 450 nm and therefore, can be sensitized by a blue laser useful for CTP. The sensitizing dye capable of absorbing light at 360 to 450 nm enters into an electron-excited state with high sensitivity upon irradiation (exposure) by a blue laser, and electron transfer, energy transfer or the like according to this electron-excited state acts on the polymerization initiator present together in the photosensitive layer to cause the polymerization initiator to undergo a chemical change and produce a radical. Then, the polymerizable compound undergoes a polymerization reaction by the effect of the produced radical, as a result, the exposed area is cured and works out to an image area.

In the lithographic printing plate precursor for use in the present invention, an intermediate layer (undercoat layer) may be provided for the purpose of enhancing the adhesion between the photosensitive layer and the support or improving the anti-fouling property. Also, a protective layer (sometimes called an "overcoat layer") may be further provided on the photosensitive layer, because the exposure is performed in the air. The protective layer prevents a low molecular compound such as oxygen and basic substance present in the air, which inhibits the image forming reaction generated upon exposure in the photosensitive layer, from mingling into the photosensitive layer and enables exposure in the air.

In the lithographic printing plate precursor for use in the present invention, the photosensitive layer contains a sensitizing dye capable of absorbing light at 360 to 450 nm, so that this printing plate precursor can be suitably used particularly for the plate making of directly drawing an image with blue laser light having an oscillation wavelength in the range from 360 to 450 nm and can express high image-forming property as compared with conventional lithographic printing plate precursors.

Each component constituting the photosensitive composition forming the photosensitive layer of the lithographic printing plate precursor according to the present invention is described below.

(Sensitizing dye capable of absorbing light at 360 to 450 nm)

The sensitizing dye capable of absorbing light at 360 to 450 nm used in the photosensitive composition for use in the present invention is preferably a sensitizing dye having an absorption maximum in the wavelength region of 360 to 450 nm. Examples of the sensitizing dye having an absorption maximum in the wavelength region of 360 to 450 nm include merocyanine dyes represented by the following formula (II), benzopyranes represented by the following formulae (III), coumarins, aromatic ketones represented by the following formula (IV), and anthracenes represented by the following formula (V).

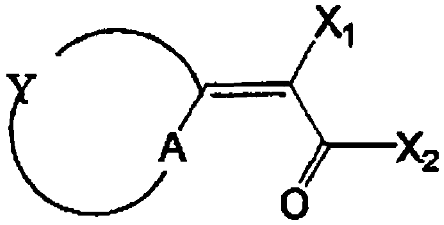 (II)

In formula (II), A represents a sulfur atom or $NR_6$, $R_6$ represents a monovalent non-metallic atomic group, Y represents a non-metallic atomic group necessary for forming a basic nucleus of the dye together with adjacent A and the adjacent carbon atom, and $X_1$ and $X_2$ each independently represents a monovalent non-metallic atomic group or $X_1$ and $X_2$ may be combined with each other to form an acidic nucleus of the dye.

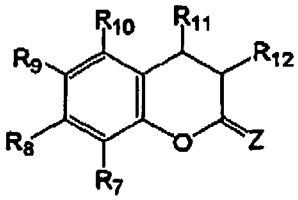 (III) 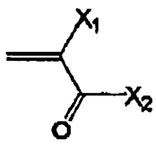 (I')

In formula (III), =Z represents an oxo group, a thioxo group, an imino group or an alkylydene group represented by the partial structural formula (I') described above, $X_1$ and $X_2$ have the same meanings as defined in formula (II), and $R_7$ to $R_{12}$ each independently represents a monovalent non-metallic atomic group.

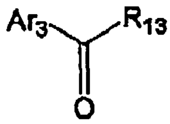 (IV)

In formula (IV), $Ar_3$ represents an aromatic group which may have a substituent or a heteroaromatic group which may have a substituent, and $R_{13}$ represents a monovalent non-metallic atomic group. More preferably, $R_{13}$ represents an aromatic group or a heteroaromatic group or $Ar_3$ and $R_{13}$ may be combined with each other to form a ring.

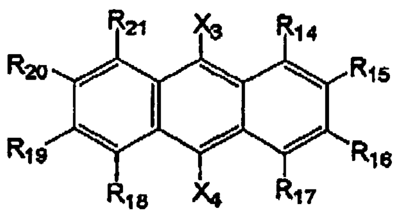 (V)

In formula (V), $X_3$, $X_4$ and $R_{14}$ to $R_{21}$ each independently represents a monovalent non-metallic atomic group. More preferably, $X_3$ and $X_4$ each independently represents an electron-donating group having a negative Hammett substituent constant.

In formulae (II) to (V), preferred examples of the monovalent non-metallic atomic group represented by $X_1$ to $X_4$ and $R_4$ to $R_{21}$ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl

group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxy-carbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a phenyl group, a cyanophenyl group, a sulfophenyl group, a sulfonatophenyl group, a phosphonophenyl group or a phosphonatophenyl group), a heteroaryl group (for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine), an alkenyl group (for example, a vinyl group, a 1-propenyl group, a 1-butenyl group, a cinnamyl group or a 2-chloro-1-ethenyl group), an alkynyl group (for example, an ethynyl group, a 1-propynyl group, a 1-butynyl group or a trimethylsilylethynyl group), a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diaryl-carbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-diallcylureido group, an N'-arylureido group, an N',N'-diarylureido group, an N'-alkyl N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonyiamino group, an N-alkyl-N-aryloxycarbonylamino group, an N-axyl-N-alkoxycarbonylamino group, an N-aryl-N-aryloxycarbonylamino group, an acyl group, a carboxy group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an allrylsulfonyl group, an arylsulfonyl group, a sulfo group ($-SO_3H$) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and its conjugated base group (hereinafter referred to as a "phosphonato group"), a dialkylphosphono group ($-PO_3(alkyl)_2$), a diarylphosphono group ($-PO_3(aryl)_2$), an alkylarylphosphono group ($-PO_3(alkyl)(aryl)$, a monoalkylphosphono group ($-PO_3H(alkyl)$) and its conjugated base group (hereinafter referred to as an "alkylphosphonato group"), a monoarylphosphono group ($-PO_3H(aryl)$) and its conjugated base group (hereinafter referred to as an "arylphosphonato group"), a phosphonooxy group ($-OPO_3H_2$) and its conjugated base group (hereinafter referred to as a "phosphonatooxy goup"), a dialkylphosphonooxy group ($-OPO_3(alkyl)_2$), a diarylphosphonooxy group ($-OPO_3(aryl)_2$), an alkylarylphosphonooxy group ($-OPO_3(alkyl)(aryl)$), a monoallcylphosphonooxy group ($-OPO_3H(alkyl)$) and its conjugated base group (hereinafter referred

to as an "alkylphosphonatooxy group"), a monoarylphosphonooxy group (-$OPO_3H$(aryl)) and its conjugated base group (hereinafter referred to as an "arylphosphonatooxy group"), a cyano group, and a nitro group. Of the substituents, a hydroxy group, an alkyl group, an aryl group, a halogen atom, an alkoxy group and an acyl group are particularly preferred.

In formula (II), the basic nucleus of the dye formed by Y together with the adjacent A and the adjacent carbon atom includes, for example, a 5-membered, 6-membered or 7-membered, nitrogen-containing or sulfur-containing heterocyclic ring, and is preferably a 5-membered or 6-membered heterocyclic ring.

As the nitrogen-containing heterocyclic ring, those which are known to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenylthiazole) or 4-(2-thienyl)thiazole); benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxyznethylenebenzothiazole, 5-hydroxybenzothiazole, 6-hydroxybenzothiazole, 6-dimethylaminobenzothiazole or 5-ethoxycarbonylbenzothiazole); naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole); thianaphtheno-7',6',4,5-thiazoles (for example, 4'-methoxythianaphtheno-7',6',4,5-thiazole); oxazoles (for example, 4-methyloxazole, 5-methyloxazole, 4-phenyloxazole, 4,5-diphenyloxazole, 4-ethyloxazole, 4,5-dimethyloxazole or 5-phenyloxazole); benzoxazoles (for example, benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole or 6-hydroxybenzoxazole); naphthoxazoles (for example, naphth[1,2]oxazole or naphth[2,1]oxazole); selenazoles (for example, 4-methylselenazole or 4-phenylselenazole); benzoselenazoles (for example, benzoselenazole, 5-chlorobenzoselenazole, 5-methoxybenzoselenazole, 5-hydroxybenzoselenazole or tetrahydrobenzoselenazole); naphthoselenazoles (for example, naphtho[1,2]selenazole or naphtho[2,1] selenazole); thiazolines (for example, thiazoline or 4-methylthiazoline); 2-quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline); 4-quinolines (for example, quinoline, 6-methoxyquinoline, 7-methylquinoline or 8-methylquinoline); 1-isoquinolines (for example, isoquinoline or 3,4-dihydroisoquinoline); 3-isoquinolines (for example, isoquinoline); benzimidazoles (for example, 1,3-diethylbenzimidazole or 1-ethyl-3-phenylbenzimidazole); 3,3-dialkylindolenines (for example, 3,3-dimethylindolenine, 3,3,5-trimethylindolenine or 3,3,7-trimethylindolenine); 2-pyridines (for example, pyridine or 5-methylpyridine); and 4-pyridines (for example, pyridine).

Examples of the sulfur-containing heterocyclic ring include dithiol partial structures in dyes described in JP-A-3-296759.

Specific examples thereof include benzodithiols (for example, benzodithiol, 5-tert-butylbenzodithiol or 5-methylbenzodithiol); naphthodithiols (for example, naphtho[1,2]dithiol or naphtho[2,1]dithiol); and dithiols (for example, 4,5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol).

In the description with respect to the heterocyclic ring above, for convenience and by convention, the names of heterocyclic mother skeletons are used. In the case of constituting the basic nucleus partial structure in the sensitizing dye, the heterocyclic ring is introduced in the form of a substituent of alkylydene type where a degree of unsaturation is decreased one step. For example, a benzothiazole skeleton is introduced as a 3-substituted-2(3H)-benzothiazolilydene group.

Of the sensitizing dyes having an absorption maximum in a wavelength range of 360 to 450 nm, dyes represented by formula (I) shown below are more preferred in view of high sensitivity.

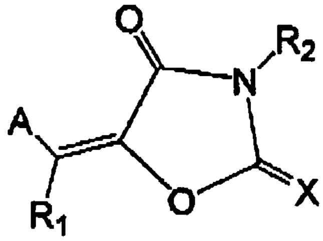

(I)

In formula (I), A represents an aromatic ring group which may have a substituent or a hetero ring group which may have a substituent, X represents an oxygen atom, a sulfur atom or $-N(R_3)-$, $R_1$, $R_2$ and $R_3$ each independently represents a monovalent non-metallic atomic group, or A and $R_1$ or $R_2$ and $R_3$ may be combined with each other to form an aliphatic or aromatic ring.

The formula (I) will be described in more detail below. $R_1$, $R_2$ and $R_3$ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heteroaryl group, a substituted or unsubstituted alkoxy group, a substituted or unsubstituted alkylthio group, a hydroxy group or a halogen atom.

Preferred examples of $R_1$, $R_2$ and $R_3$ will be specifically described below. Preferred examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl goup. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group, a monovalent non-metallic atomic group exclusive of a hydrogen atom is used. Preferred examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N, N-diarylamino group, an N-alkyl-N-arylamino group, an acyloxy group, a carbamoyloxy group, an N-alkylearbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and its conjugated base group (hereinafter referred to as a "phosphonato group"), a dialkylphosphono group ($-PO_3(alkyl)_2$), a diarylphosphono group ($-PO_3(aryl)_2$), an alkylarylphosphono group ($-PO_3(alkyl)(aryl)$), a monoalkylphosphono group ($-PO_3H(alkyl)$) and its conjugated base group (hereinafter referred to as an "alkylphosphonato goup"), a monoarylphosphono group ($-PO_3H(aryl)$) and its conjugated base group (hereinafter referred to as an "arylphosphonato group"), a phosphonooxy group ($-OPO_3H_2$) and its conjugated base group (hereinafter referred to as a "phosphonatooxy group"), a dialkylphosphonooxy group ($-OPO_3(alkyl)_2$), a diarylphosphonooxy group ($-OPO_3(aryl)_2$), an alkylarylphosphonooxy group ($-OPO_3(alkyl)(aryl)$), a monoalkylphosphonooxy group ($-OPO_3H(alkyl)$) and its conjugated base group (hereinafter referred to as an "alkylphosphonatooxy group"), a monoarylphosphonooxy group ($-OPO_3H(aryl)$) and its conjugated base group (hereinafter referred to as an "arylphosphonatooxy goup"), a cyano group, a nitro group, an aryl group, a heteroaryl group, an alkenyl group and an alkynyl group.

In the substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a phenyl group, a cyanophenyl group, a sulfophenyl group, a sulfonatophenyl group, a phosphonophenyl group and a phosphonatophenyl group.

Preferred examples of the aromatic heteroaryl group represented by any one of $R_1$, $R_2$ and $R_3$ include a monocyclic or polycyclic aromatic ring containing at least one of a nitrogen atom, an oxygen atom and a sulfur atom.

Examples of especially preferred aromatic heterocyclic group include thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane and phenoxazine. These groups may be benzo-fused or may have a substituent.

Also, preferred examples of the alkenyl group represented by any one of $R_1$, $R_2$ and $R_3$ include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl goup and a trimethylsilylethynyl group. Examples of $G_1$ in the acyl group ($G_1CO$-) include a hydrogen atom and the above-described alkyl group and aryl group. Of the substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N, N-dialkylsulfamoyl group, an N-arylsulfamoyl group, an N-alkyl-N-arylsulfamoyl group, a phosphono group, a phosphonato group, a dialkylphosphonato group, a diarylphosphono group, a monoalkylphosphono group, an alkylphosphonato group, a monoarylphosphono group, an arylphosphonato group, a phosphonooxy group, a phosphonatooxy group, an aryl group and an alkenyl group are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferred alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferred substituted alkyl group represented by any one of $R_1$, $R_2$ and $R_3$, which is obtained by combining the above-described substituent with an alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxy-carbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatoltexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferred examples of the aryl group represented by any one of $R_1$, $R_2$ and $R_3$ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferable.

Specific examples of the preferred substituted aryl group represented by any one of $R_1$, $R_2$ and $R_3$ include aryl groups having a monovalent non-metallic atomic group exclusive of a hydrogen atom as a substituent on the ring-forming carbon atom of the above-described aryl group. Preferred examples of the substituent include the above-described alkyl groups and substituted alkyl groups, and the substituents described for the above-described substituted alkyl group. Specific examples of the preferred substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a znethoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamo-yloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N, N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allyl group, a 1-propenylmethyl group, a 2-butenyl group, a 2-methylallylphenyl group, a 2-methylpropenylphenyl group, a 2-propenylphenyl group, a 2-butynylphenyl group and a 3-butynylphenyl group.

Next, A in formula (I) will be described below. A represents an aromatic ring group which may have a substituent or hetero ring group which may have a substituent. Specific examples of the aromatic ring group which may have a substituent or hetero ring group which may have a substituent include those described for any one of $R_1$, $R_2$ and $R_3$ in formula (I).

The sensitizing dye represented by formula (I) according to the invention is obtained by a condensation reaction of the above-described acidic nucleus or an active methyl group-containing acidic nucleus with a substituted or unsubstituted, aromatic ring or hetero ring and can be synthesized with reference to JP-B-59-28329.

Preferred specific examples (D1) to (D41) of the compound represented by formula (I) are set forth below. Also, when isomers with respect to a double bond connecting an acidic nucleus and a basic nucleus are present, the invention should not be construed as being limited to any one of the isomers.

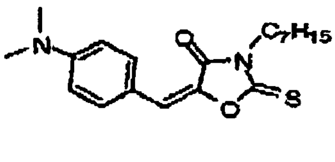

(D1)

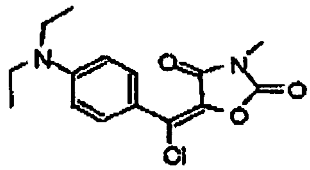

(D2)

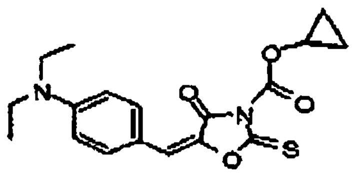

(D3)

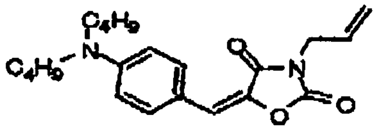

(D4)

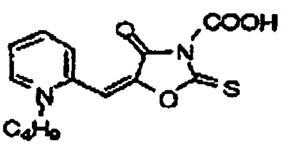

(D5)

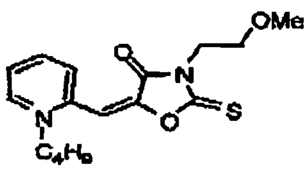

(D6)

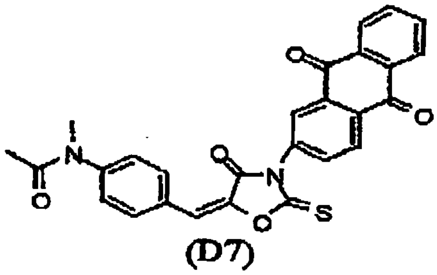

(D7)

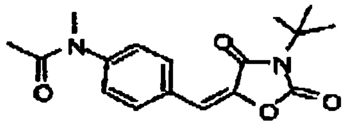

(D8)

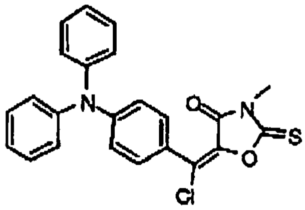

(D9)

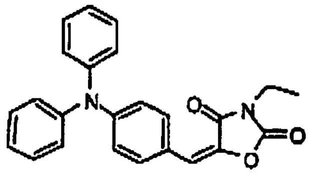

(D10)

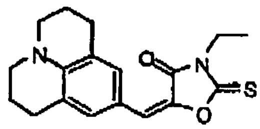

(D11)

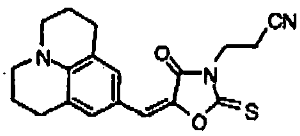

(D12)

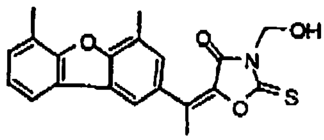

(D13)

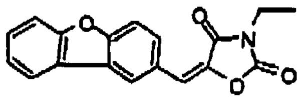

(D14)

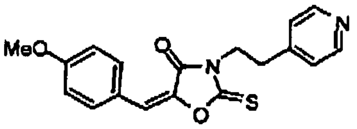

(D15)

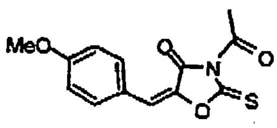

(D16)

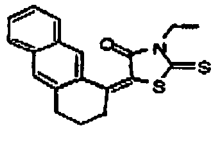

(D17)

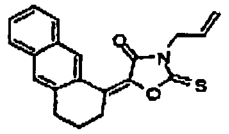

(D18)

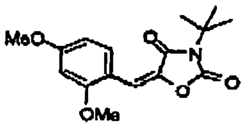

(D19)

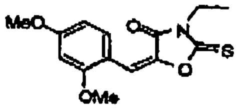

(D20)

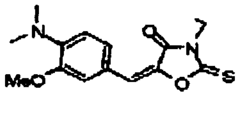

(D21)

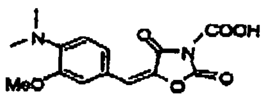

(D22)

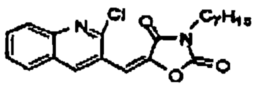

(D23)

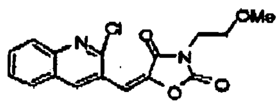

(D24)

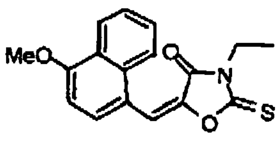

(D25)

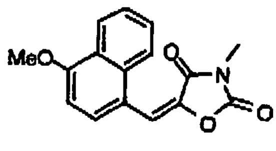

(D26)

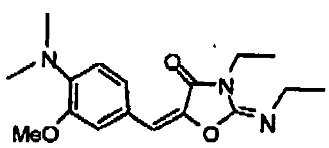

(D27)

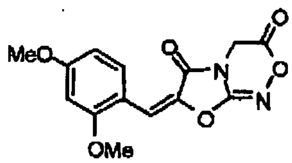

(D28)

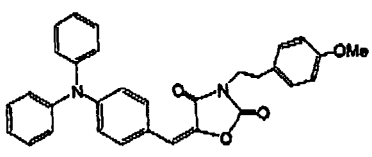

(D29)

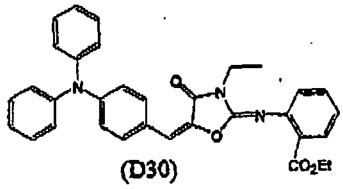

(D30)

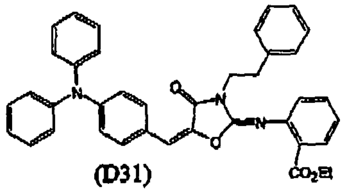

(D31)

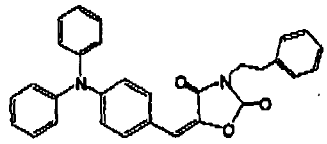

(D32)

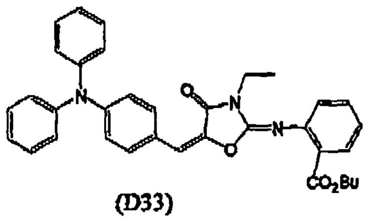

(D33)

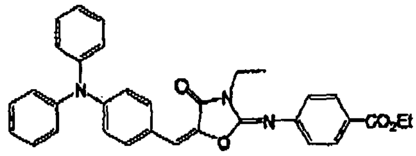

(D34)

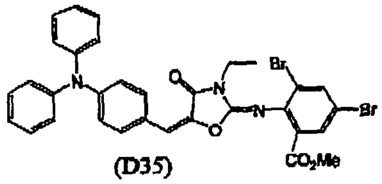

(D35)

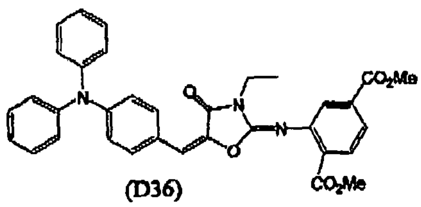

(D36)

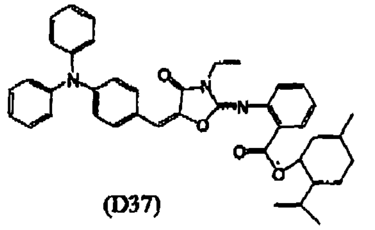

(D37)

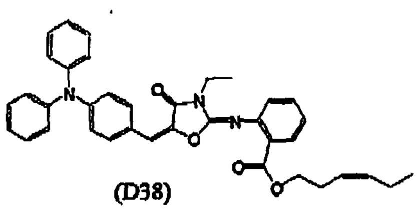

(D38)

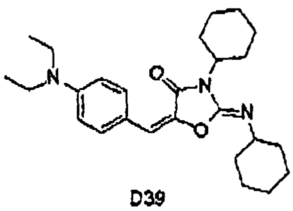

D39

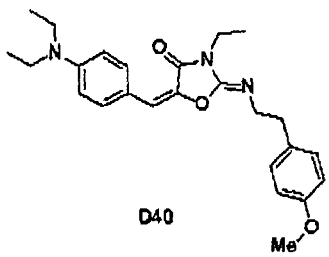

D40

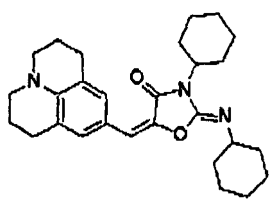

D41

The sensitizing dye capable of absorbing light at 360 to 450 nm is preferably used in an amount of 1.0 to 10.0

mass%, more preferably from 1.5 to 5.0 mass%, based on all components in the photosensitive composition. (In this specification, mass ratio is equal to weight ratio.)

[Polymerization Initiator]

The polymerization initiator for use in the present invention is a compound capable of generating a radical by the effect of light or heat energy and thereby initiating or accelerating the polymerization of a monomer having a polymerizable unsaturated group. Such a radical generator may be appropriately selected from a known polymerization initiator, a compound having a bond with a small bond-dissociation energy, and the like.

For example, in the case of using light near 400 nm as the light source, benzyl, benzoyl ether, Michler's ketone, anthraquinone, thioxanthone, acridine, phenazine, benzophenone and the like are widely used.

Also in the case of using light at 400 nm or more as the light source, various photopolymerization initiators have been proposed and examples thereof include a certain kind of photo-reducing dye such as Rose Bengale, eosine and erythrosine described in U.S. Patent 2,850,445; a system comprising a combination of a dye and a photopolymerization initiator, such as a composite initiator system of a dye and an amine (see, JP-B-44-20189 (the term "JP-B" as used herein means an "examined Japanese patent publication")); a system using a hexaarylbiimidazole, a radical generator and a dye in combination (see, JP-B-45-37377); a system of a hexaarylbiimidazole and a p-dialkylaminobenzylidene ketone (see, JP-B-47-2528 and JP-A-54-155292); a system of a cyclic cis-α-dicarbonyl compound and a dye (see, JP-A-48-84183); a system of a cyclic triazine and a merocyanine dye (see, JP-A-54-151024); a system of a 3-ketocoumarin and an activator (see, JP-A-52-112681 and JP-A-58-15503); a system of a biimidazole, a styrene derivative and a thiol (see, JP-A-59-140203); a system of an organic peroxide and a dye (see, JP-A-59-1504, JP-A-59-140203, JP-A-59-189340, JP-A-62-174203, JP-B-62-1641 and U.S. Patent 4,766,055); a system of a dye and an active halogen compound (see, JP-A-63-178105, JP-A-63-258903 and JP-A-2-63054); a system of a dye and a borate compound (see, JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348 and JP-A-1-138204); and a system of a dye having a rhodanine ring, and a radical generator (see, JP-A-2-179643 and JP-A-2-244050).

Examples of the compound capable of generating a radical include an organohalogen compound, a carbonyl compound, an organic peroxide, an azo-based polymerization initiator, an azide compound, a metallocene compound, a hexaarylbiimidazole compound, an organoboron compound, a disulfone compound, an oxime ester compound and an onium salt compound.

Specific examples of the organohalogen compound include the compounds described in Wakabayashi et al., Bull. Chem. Soc. Japan, 42, 2924 (1969), U.S. Patent 3,905,815, JP-B-46-4605, JP-A-48-36281, JP-A-53-133428, JP-A-55-32070, JP-A-60-239736, JP-A-61-169835, JP-A-61-169837, JP-A-62-58241, JP-A-62-212401, JP-A-63-70243, JP-A-63-298339, and M.P. Hutt, Journal of Heterocyclic Chemistry, 1 (No. 3) (1970). In particular, an oxazole compound substituted with a trihalomethyl group, and an S-triazine compound are preferred.

An s-triazine derivative and an oxadiazole derivative where at least one mono-, di- or tri-halogenated methyl group is bonded to the s-txiazine ring or bonded to the oxadiazole ring, respectively, are more preferred. Specific examples thereof include 2,4,6-tris(monochloro-methyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(p-i-propyloxystyryl)-4,6-bis(trichloromethyl)-s-triazine, 2-(p-tolyl)-4,6-bis (trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine, and the following compounds.

(I)-1

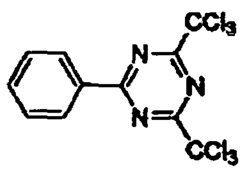

(I)-2

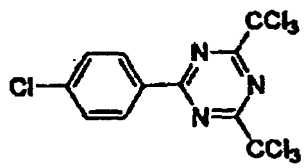

(I)-3
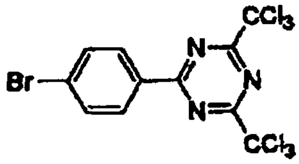

(I)-4
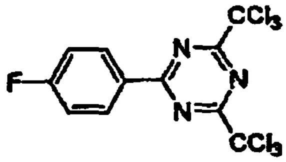

(I)-5
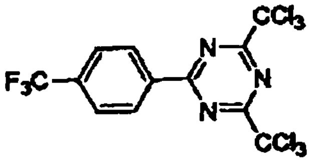

(I)-6
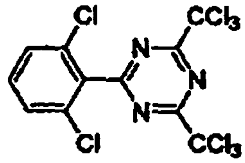

(I)-7
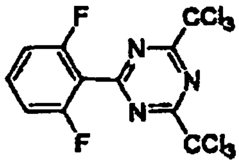

(I)-8
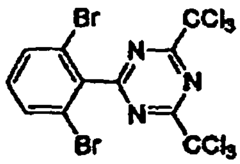

(I)-9
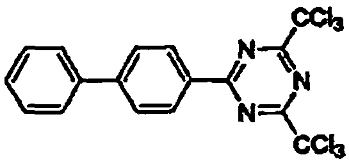

(I)-10
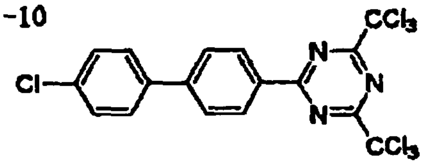

(I)-11
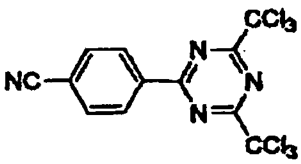

(I)-12
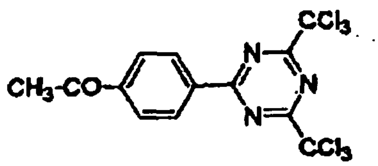

(I)-13
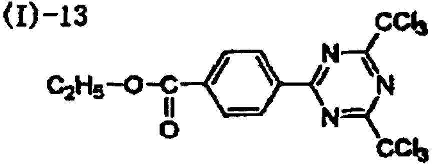

(I)-14
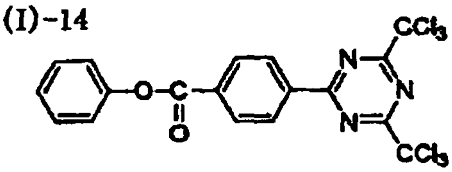

(I)-15
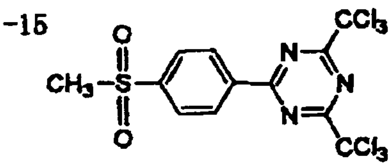

(I)-16
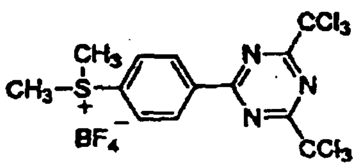

(I)-17

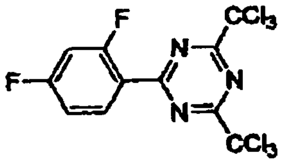

(I)-18

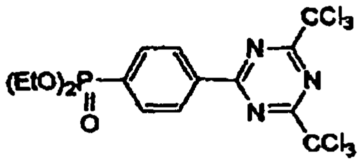

(I)-19

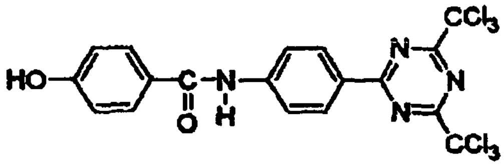

(I)-20

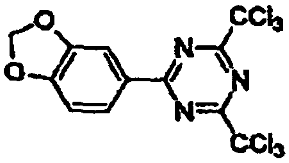

(I)-21

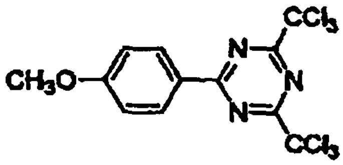

(I)-22

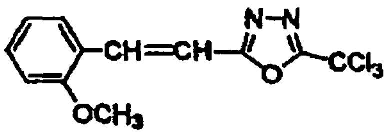

(I)-23

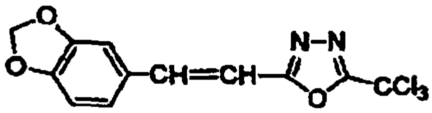

(I)-24

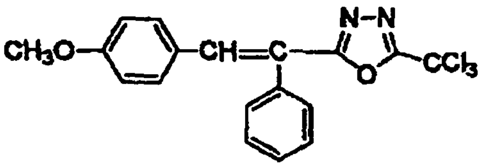

(I)-25

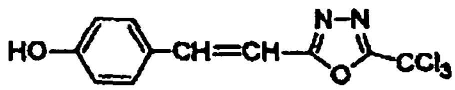

(I)-26

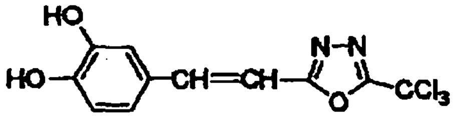

(I)-27

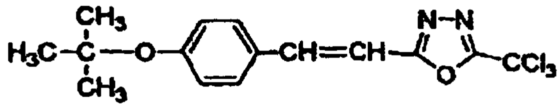

Examples of the carbonyl compound include benzophenone; a benzophenone derivative such as Michler's ketone, 2-methylbenzophenone, 3-methylbenzophenone, 4-methylbenzophenone, 2-chlorobenzophenone, 4-bromobenzophenone and 2-carboxybenzophenone; an acetophenone derivative such as 2,2-dimethoxy-2-phenylacetophenone, 2,2-diethoxyacetophenane, 1-hydroxycyclohexyl phenyl ketone, α-hydroxy-2-methylphenylpropanone, 1-hydroxy-1-methylethyl-(p-isopropylphenyl) ketone, 1-hydroxy-1-(p-dodecylphenyl) ketone, 2-methyl-(4'-(methylthio)phenyl)-2-morpholino-1-propanone and 1,1,1-trichloromethyl-(p-butylphenyl) ketone; thioxanthone; a thioxanthone derivative such as 2-ethylthioxanthone, 2-isopropylthioxanthone, 2-chlorothioxanthone, 2,4-dimethylthioxanthone, 2,4-diethylthioxanthone and 2,4-diisopropylthioxanthone; and a benzoic acid ester derivative such as ethyl p-dimetbylannnobenzoate and ethyl p-diethylaminobenzoate.

Examples of the azo compound which can be used include azo compounds described in JP-A-8-108621.

Examples of the organic peroxide include trimethylcyclohexanone peroxide, acetylacetone peroxide, 1,1-bis (tert-butylperoxy)-3,3,5-trimethylcyclohexane, 1,1-bis(tert-butylperoxy)cyclohexane, 2,2-bis(tert-butylperoxy)butane, tert-butyl hydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di (tert-butylperoxy)hexane, 2,5-oxanoyl peroxide, succinic peroxide, benzoyl peroxide, 2,4-dichlorobenzoyl peroxide, diisopropyl peroxydicarbonate, di-2-ethylhexyl peroxydicarbonate, di-2-ethoxyethyl peroxydicarbonate, dimethoxyisopropyl peroxycarbonate, di(3-methyl-3-methoxybutyl) peroxydicarbornate, tert-butyl peroxyacetate, tert-butyl peroxypivalate, tert-butyl peroxyneodecanoate, tert-butyl peroxyoctanoate, tert-butyl peroxylaurate, tert-carbonate, 3,3',4,4'-tetra(tert-butylperoxycarbonyl)benzophenone, 3,3',4,4'-tetra(tert-hexylperoxycarbonyl)benzophenone, 3,3',4,4'-tetra(p-isopropyl-cumylperoxycarbonyl)benzophenone, carbonyl di(tert-butylperoxydihydrogendiphthalate) and carbonyl di(tert-hexylperoxydihydrogendiphthalate).

Examples of the metallocene compound include various titanocene compounds described in JP-A-59-152396, JP-A-61-151197, JP-A-63-41484, JP-A-2-249, JP-A-2-4705 and JP-A-5-83588, such as dicyclopentadienyl-Ti-bis-phenyl, dicyclopentadienyl-Ti-bis-2,6-difluorophen-1-yl, dicyclopentadienyl-Ti-bis-2,4-difluorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-trifluorophen-1-yl, dimethylcyclopentadienyl-Ti-bis-2,3,5,6-tetrafluorophen-1-yl and dimethylcyclopentadienyl-Ti-bis-2,3,4,5,6-pentafluorophen-1-yl and bis(cyclopentadienyl)-bis(2,6-difluoro-3-(pyr-1-yl)phenyl)titanium; and iron-arene complexes described in JP-A-1-304453 and JP-A-1-152109.

Examples of the hexaarylbiimidazole compound include various compounds described in JP-B-6-29285 and U.S. Patents 3,479,185, 4,311,783 and 4,622,286, such as 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4,5,5'-tetraphenylbiimidazole, 2,2'-bis(o-chlorophenyl)-4,4',5,5'-tetra(m-xnethoxyphenyl)biimidazole, 2,2'-bis(o,o'-dichlorophenyl)-4,4',5,5'-tetraphenylbiiwidawle, 2,2'-bis(o-nitrophenyl)-4,4',5,5'-tetraphenylbiimidazole, 2,2'-bis(o-methylphenyl)-4,4',5,5'-tetraphenylbiirnidazole and 2,2'-bis(o-trifluorophenyl)-4,4',5,5'-tetraphenylbiimidazole.

Production process of the hexaarylbiimidazole compound is described in the specification of Germany Patent No. 1,470,154, and the its use in a composition capable of photopolymerization is described in European Patent No. 24,629, 107,792, U.S. Patent No. 4,410,621, European Patent No. 215,453 and Germany Patent No. 3,211,312.

Examples of the organoboron compound include organoborates described in JP-A-62-143044, JP-A-62-150242, JP-A-9-188685, JP-A-9-188686, JP-A-9-188710, JP-A-2000-131837,JP-A-2002-107916, Japanese Patent 2764769, JP-A-2002-116539 and Martin Kunz, Rad Tech '98. Proceeding April 19-22, 1998, Chicago; organoboron sulfonium complexes and organoboron oxosulfonium complexes, described in JP-A-6-157623, JP-A-6-175564 and JP-A-6-175561; organoboron iodonium complexes described in JP-A-6-175554 and JP-A-6-175553; organoboron phosphonium complexes described in JP-A-9-188710; and organoboron transition metal coordination complexes described in JP-A-6-348011, JP-A-7-128785, JP-A-7-140589, JP-A-7-306527 and JP-A-7-292014.

Examples of the disulfone compound include compounds described in JP-A-61-166544 and JP-A-2003-328465.

Examples of the oxime ester compound include compounds described in J.C.S. Perkin II, 1653-1660 (1979), J.C.S. Perkin II, 156-162 (1979), Journal of Photopolymer Science and Technology, 202-232 (1995), JP-A-2000-66385 and JP-A-2000-80068. Specific examples thereof include the compounds shown by the following structural formulae.

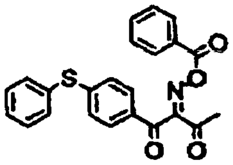
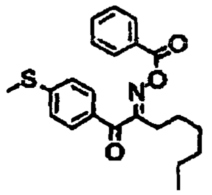
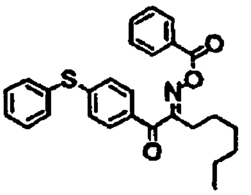
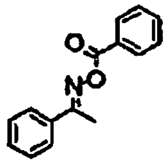
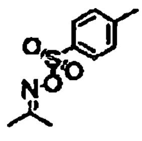

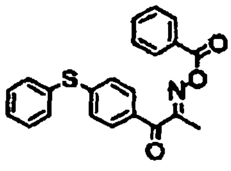
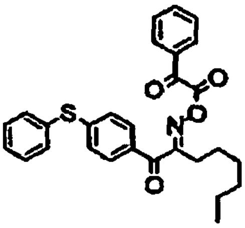
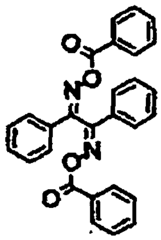
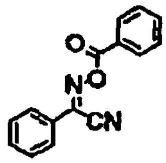
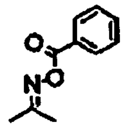

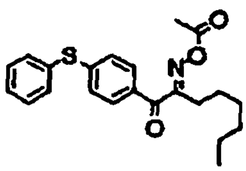
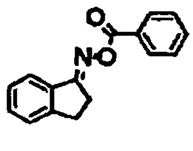
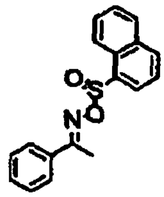
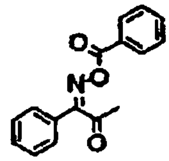
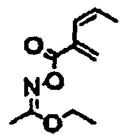

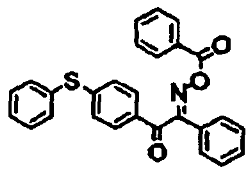
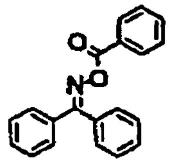
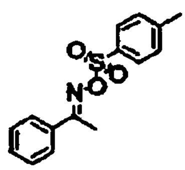
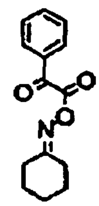
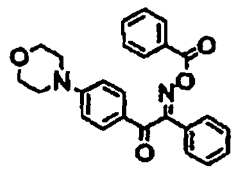

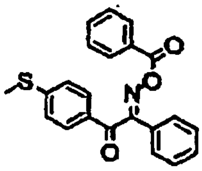
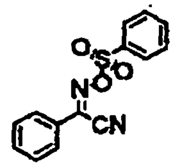

Examples of the onium salt compound include onium salts such as diazonium salts described in S.I. Schlesinger,

Photogr. Sci. Eng., 18, 387 (1974) and T.S. Bal et al., Polymer, 21, 423 (1980), ammonium salts described in U.S. Patent 4,069,055 and JP-A-4-365049, phosphonium salts described in U.S. Patents 4,069,055 and 4,069,056, iodonium salts described in European Patent 104,143, U.S. Patents 339,049 and 410,201, JP-A-2-150848 and JP-A-2-296514, sulfonium salts described in European Patents 370,693, 390,214, 233,567, 297,443 and 297,442, U.S. Patents 4,933,377, 161,811, 410,201, 339,049, 4,760,013, 4,734,444 and 2,833,827, and German Patents 2,904,626, 3,604,580 and 3,604,581, selenonium salts described in J.V. Crivello et al., Macromolecules, 10 (6), 1307 (1977) and J.V. Crivello et al., J. Polymer Sci., Polymer Chem. Ed., 17, 1047 (1979), and arsonium salts described in C.S. Wen et al., Teh. Proc. Conf. Rad. Curing ASIA, p. 478, Tokyo, Oct. (1988).

In the present invention, such an onium salt acts as an ionic radical polymerization initiator but not as an acid generator.

The onium salt suitably used in the present invention is an onium salt represented by any one of the following formulae (RI-I) to (RI-III):

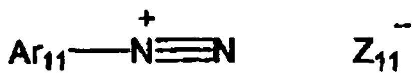
(RI-I)

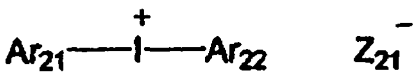
(RI-II)

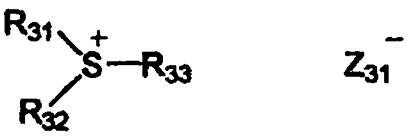
(RI-III)

In formula (RI-I), $Ar_{11}$ represents an aryl group having a carbon number of 20 or less, which may have from 1 to 6 substituent(s), and preferred examples of the substituent include an alkyl group having a carbon number of 1 to 12, an alkenyl group having a carbon number of 1 to 12, an alkynyl group having a carbon number of 1 to 12, an aryl group having a carbon number of 1 to 12, an alkoxy group having a carbon number of 1 to 12, an aryloxy group having a carbon number of 1 to 12, a halogen atom, an alkylamino group having a carbon number of 1 to 12, a dialkylamino group having a carbon number of 1 to 12, an alkylamido or arylamido group having a carbon number of 1 to 12, a carbonyl group, a carboxyl group, a cyano group, a sulfonyl group, a thioalkyl group having a carbon number of 1 to 12, and a thioaryl group having a carbon number of 1 to 12. $Z_{11}^-$ represents a monovalent anion, and specific examples thereof include halogen ion, perchlorate ion, hexafluorophosphate ion, tetrafluoroborate ion, sulfonate ion, sulfinate ion, thiosulfonate ion and sulfate ion. Among these, in view of stability, preferred are perchlorate ion, hexafluorophosphate ion, tetrafluoroborate ion, sulfonate ion and sulfinate ion.

In formula (RI-II), $Ar_{21}$ and $Ar_{22}$ each independently represents an aryl group having a carbon number of 20 or less, which may have from 1 to 6 substituent(s), and preferred examples of the substituent include an alkyl group having a carbon number of 1 to 12, an alkenyl group having a carbon number of 1 to 12, an alkynyl group having a carbon number of 1 to 12, an aryl group having a carbon number of 1 to 12, an alkoxy group having a carbon number of 1 to 12, an aryloxy group having a carbon number of 1 to 12, a halogen atom, an alkylamino group having a carbon number of 1 to 12, a dialkylamino group having a carbon number of 1 to 12, an alkylamido or arylamido group having a carbon number of 1 to 12, a carbonyl group, a carboxyl group, a cyano group, a sulfonyl group, a thioalkyl group having a carbon number of 1 to 12, and a thioaryl group having a carbon number of 1 to 12. $Z_{21}^-$ represents a monovalent anion, and specific examples thereof include halogen ion, perchlorate ion, hexafluorophosphate ion, tetrafluoroborate ion, sulfonate ion, sulfinate ion, thiosulfonate ion and sulfate ion. Among these, in view of stability and reactivity, preferred are perchlorate ion, hexafluorophosphate ion, tetrafluoroborate ion, sulfonate ion, sulfinate ion and carboxylate ion.

In formula (RI-III), $R_{31}$, $R_{32}$ and $R_{33}$ each independently represents an aryl, alkyl, alkenyl or alkynyl group having a carbon number of 20 or less, which may have from 1 to 6 substituent(s), and in view of reactivity and stability, preferably an aryl group. Examples of the substituent include an alkyl group having a carbon number of 1 to 12, an alkenyl group having a carbon number of 1 to 12, an alkynyl group having a carbon number of 1 to 12, an aryl group having a carbon number of 1 to 12, an alkoxy group having a carbon number of 1 to 12, an aryloxy group having a carbon number of 1 to 12, a halogen atom, an alkylamino group having a carbon number of 1 to 12, a dialkylamino group having a carbon number of 1 to 12, an alkylamido or arylamido group having a carbon number of 1 to 12, a carbonyl group, a carboxyl group, a cyano group, a sulfonyl group, a thioalkyl group having a carbon number of 1 to 12, and a thioaryl group having a carbon number of 1 to 12. $Z_{31}$ represents a monovalent anion, and specific examples thereof include

halogen ion, perchlorate ion, hexafluorophosphate ion, tetrafluoroborate ion, sulfonate ion, sulfinate ion, thiosulfonate ion and sulfate ion. Among these, in view of stability and reactivity, preferred are perchlorate ion, hexafluorophosphate ion, tetrafluoroborate ion, sulfonate ion, sulfinate ion and carboxylate ion. The carboxylate ion described in JP-A-2001-343742 is more preferred, and the carboxylate ion described in JP-A-2002-148790 is still more preferred.

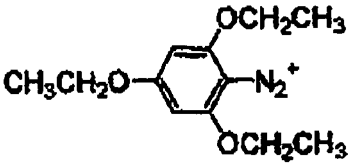 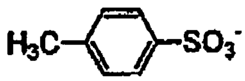 (N-1)

$PF_6^-$ (N-2)

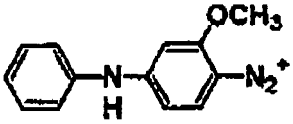 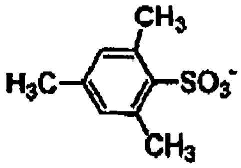 (N-3)

$ClO_4^-$ (N-4)

$PF_6^-$ (N-5)

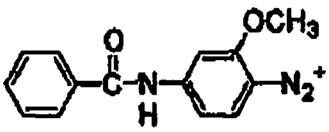 $CF_3SO_3^-$ (N-6)

$BF_4^-$ (N-7)

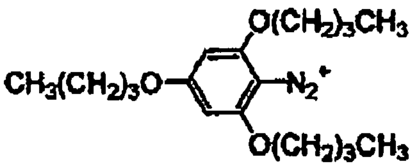 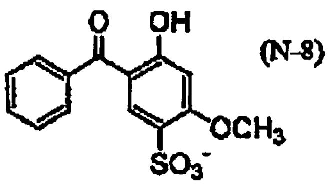 (N-8)

$ClO_4^-$ (N-9)

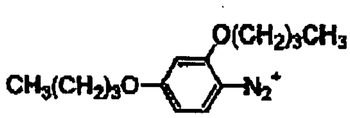 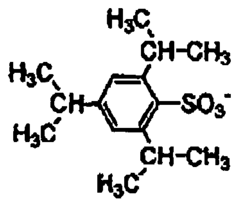 (N-10)

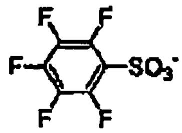 (N-11)

$PF_6^-$ (N-12)

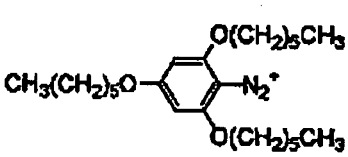 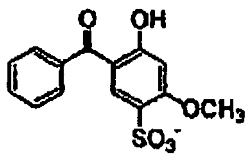 (N-13)

$ClO_4^-$ (N-14)

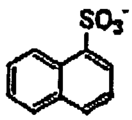 (N-15)

$PF_6^-$ (N-16)

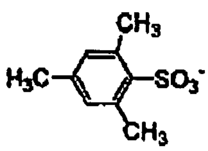 (N-17)

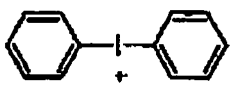 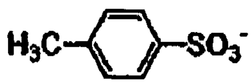 (I-1)

$PF_6^-$ (I-2)

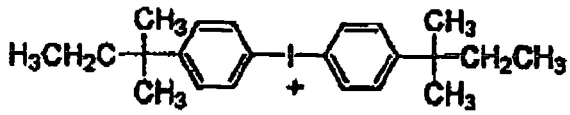

$PF_6^-$ (I-3)

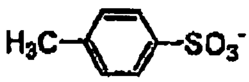 (I-4)

$ClO_4^-$ (I-5)

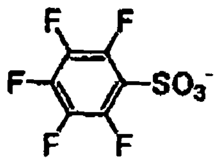 (I-6)

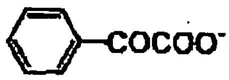 (I-7)

$CF_3SO_3^-$ (I-8)

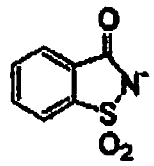 (I-9)

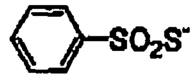 (I-10)

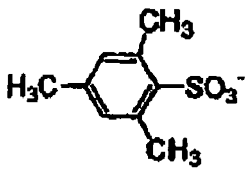 (I-11)

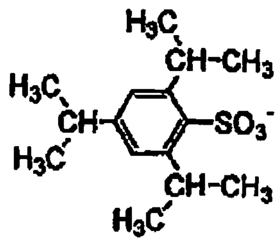 (I-12)

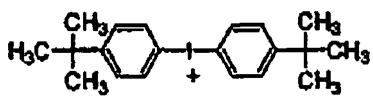 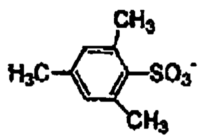 (I-13)

$ClO_4^-$ (I-14)

$PF_6^-$ (I-15)

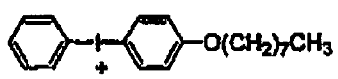 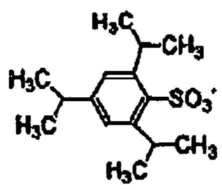 (I-16)

$CF_3COO^-$ (I-17)

$CF_3SO_3^-$ (I-18)

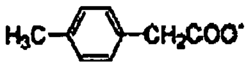 (I-19)

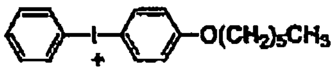 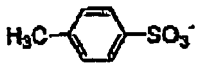 (I-20)

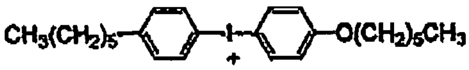 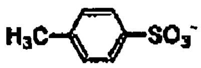 (I-21)

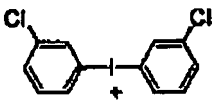

$BF_4^-$ (I-22)

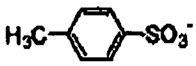 (I-23)

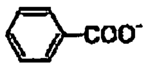 (I-18)

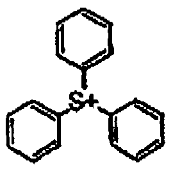

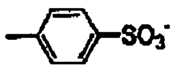 (S-1)

$PF_6^-$ (S-2)

$ClO_4^-$ (S-3)

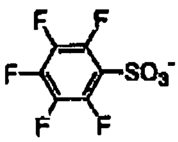 (S-4)

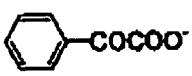 (S-5)

$CF_3so_3^-$ (S-6)

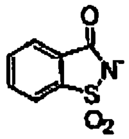

(S-7)

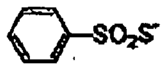

(S-8)

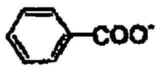

(S-9)

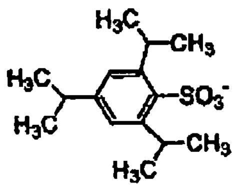

(S-10)

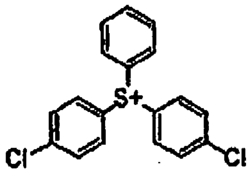

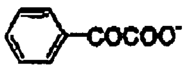

(S-11)

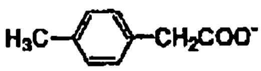

(S-12)

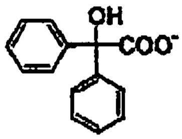

(S-13)

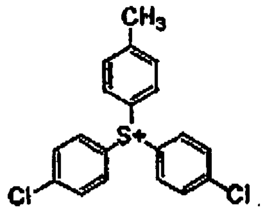

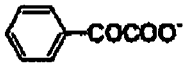

(S-14)

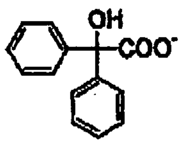

(S-15)

$BF_4^-$ (S-16)

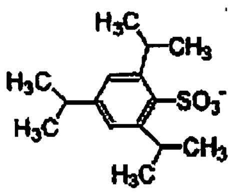

(S-17)

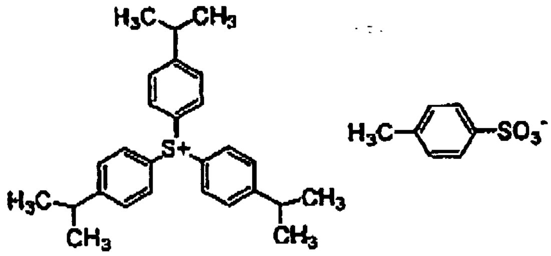

(S-18)

solid contents constituting the photosensitive layer.

[Polymerizable Compound]

The polymerizable compound contained in the photosensitive composition is an addition-polymerizable compound having an ethylenically unsaturated double bond and may be arbitrarily selected from compounds having at least one, preferably two or more, ethylenically unsaturated double bond group(s). Such compounds are widely known in this industrial field and these known compounds can be used in the present invention without any particular limitation. These compounds have a chemical mode such as monomer, prepolymer (that is, dimer, trimer or oligomer) or a mixture or copolymer thereof.

Examples of the monomer and a copolymer thereof include an unsaturated carboxylic acid (e.g., acrylic acid, methacrylic acid, itaconic acid, crotonic acid, isocrotonic acid, maleic acid), and esters and amides thereof. For example, an ester of an unsaturated carboxylic acid and an aliphatic polyhydric alcohol compound, and an amide of an unsaturated carboxylic acid and an aliphatic polyvalent amine compound, are preferred. Also, an addition reaction product of an unsaturated carboxylic acid ester or amide having a nucleophilic substituent such as hydroxyl group, amino group or mercapto group with a monofunctional or polyfunctional isocyanate or epoxy, and a dehydrating condensation reaction product with a monofunctional or polyfunctional carboxylic acid may be suitably used. Furthermore, an addition reaction product of an unsaturated carboxylic acid ester or amide having an electrophilic substituent such as isocyanate group or epoxy group with a monofunctional or polyfunctional alcohol, amine or thiol, and a displacement reaction product of an unsaturated carboxylic acid ester or amide having a desorptive substituent such as halogen group or tosyloxy group with a monofunctional or polyfunctional alcohol, amine or thiol may also be suitably used. In addition, compounds where the unsaturated carboxylic acid of the above-described compounds is replaced by an unsaturated phosphonic acid, a styrene, a vinyl ether or the like, may also be used.

Specific examples of the monomer of the ester between an aliphatic polyhydric alcohol compound and an unsaturated carboxylic acid include acrylates, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethyleneoxide (EO) triacrylate modification or polyester acrylate oligomer;
methacrylates, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl] dimethylmethane or bis-[p-(methacryloxyethoxy)phenyl]dimethylmethane; itaconates, for example, ethylene glydcol diitaconate, propylene glycol diitaconate, 1,3-butanediol diitaconate, 1,4-butanediol diitaconate, tetramethylene glycol diitaconate, pentaerythritol diitaconate or sorbitol tetraitaconate; crotonatates, for example, ethylene glycol dicrotonate, tetramethylene glycol dicrotonate, pentaerythritol dicrotonate or sorbitol tetradicrotonate; isocrotonates, for example, ethylene glycol diisocrotonate, pentaerythritol diisocrotonate or sorbitol tetraisocrotonate; and maleates, for example, ethylene glycol dimaleate, triethylene glycol dimaleate, pentaerythritol dimaleate or sorbitol tetramaleate. Further, mixtures of the ester monomers are exemplified.

Other examples of the ester which can be suitably used include aliphatic alcohol-based esters described in JP-B-51-47334 and JP-A-57-196231, those having an aromatic skeleton described in JP-A-59-5240, JP-A-59-5241 and JP-A-2-226149, and those containing an amino group described in JP-A-1-165613. These ester monomers may also be used as a mixture.

Also, specific examples of the monomer of the amide between an aliphatic polyamine compound and an unsaturated carboxylic acid include methylenebisacrylamide, methylenebismethacryiamide, 1,6-hexamethylenebisacrylamide, 1,6-hexaznethylenebismethacrylamide, diethylenetriaminetrisacrylamide, xylylenebisacrylamide and xylylenebismethacrylamide. Other preferred examples of the amide-type monomer include those having a cyclohexylene structure described in JP-B-54-21726.

A urethane-based addition-polymerizable compound produced by using an addition reaction of an isocyanate with a hydroxyl group is also preferred, and specific examples thereof include a vinyl urethane compound having two or more polymerizable vinyl groups within one molecule described in JP-B-48-41708, which is obtained by adding a vinyl monomer having a hydroxyl group represented by the following formula (A) to a polyisocyanate compound having two or more isocyanate groups within one molecule:

$$CH_2{=}C(R_4)COOCH_2CH(R_5)OH \qquad (A)$$

(wherein $R_4$ and $R_5$ each represents H or $CH_3$).

In addition, urethane acrylates described in JP-A-51-37193, JP-B-2-32293 and JP-B-2-16765, and urethane compounds having an ethylene oxide-type skeleton described in JP-B-58-49860, JP-B-56-17654, JP-B-62-39417 and JP-B-62-39418 are also suitably used. Furthermore, when addition-polymerizable compounds having an amino or sulfide structure within the molecule described in JP-A-63-277653, JP-A-63-260909 and JP-A-1-105238 are used, a photopolymerizable composition having very excellent photosensitization speed can be obtained.

Other examples include a polyfunctional acrylate or methacrylate such as polyester acrylates described in JP-A-48-64183, JP-B-49-43191 and JP-B-52-30490, and epoxy acrylates obtained by reacting an epoxy resin with a (meth) acrylic acid. Also, specific unsaturated compounds described in JP-B-46-43946, JP-B-1-40337 and JP-B-1-40336, a vinyl phosphonic acid-based compound described in JP-A-2-25493, and the like may be used. In some cases, a structure containing a perfluoroalkyl group described in JP-A-61-22048 is suitably used. Furthermore, those described as a photocurable monomer or oligomer in Adhesion, Vol. 20, No. 7, pp. 300-308 (1984) may also be used.

Specific examples of such a compound include NK Oligo U-4HA, U-4H, U-6HA, U-108A, U-1084A, U-200AX, U-122A, U-340A, U-324A and UA-100 (produced by Shin-Nakamura Chemical Co., Ltd.); UA-306H, AI-600, UA-101T, UA-101I, UA-306T and UA-3061 (produced by Kyoeisha Chemical Co., Ltd.); and Artresin UN-9200A, UN-3320HA, UN-3320HB, UN-3320HC, SH-380G, SH-500 and SH-9832 (produced by Negami Chemical Industrial Co., Ltd.).

Details of the manner of using these polymerizable compounds, such as structure, sole or combination use and amount added, can be freely selected in accordance with the designed performance of the final lithographic printing plate precursor and, for example, may be selected from the following standpoints.

In view of sensitivity, a structure having a large unsaturated group content per one molecule is preferred and in most cases, a bifunctional or greater functional compound is preferred. For increasing the strength of image area, namely, cured film, a trifunctional or greater functional compound is preferred. Also, a method of controlling both sensitivity and strength by using a combination of compounds differing in the functional number or in the polymerizable group (for example, an acrylic acid ester, a methacrylic acid ester, a styrene-based compound or a vinyl ether-based compound) is effective.

The selection and manner of use of the polymerizable compound are important factors also in view of compatibility and dispersibility with other components (e.g., binder polymer, polymerization initiator, colorant) in the photosensitive layer. For example, the compatibility may be enhanced by using a low-purity compound or using two or more kinds of compounds in combination. Also, a specific structure may be selected for the purpose of enhancing the adhesion to the support, protective layer which is described later, or the like.

The polymerizable compound is preferably used in an amount of 5 to 90 mass%, more preferably from 10 to 80 mass%, even more preferably from 25 to 75 mass% based on the entire solid content of the photosensitive layer. Also, one of these compounds may be used alone, or two or more thereof may be used in combination. Other than the above-described manner of use of the polymerizable compound, an appropriate structure, formulation or amount added can be freely selected by taking account of the degree of polymerization inhibition due to oxygen, resolution, fogging, change in refractive index, surface tackiness and the like. Depending on the case, a layer structure or coating method such as undercoat and overcoat may also be employed.

[Binder Polymer]

The binder polymer contained in the photosensitive composition of the present invention is a polymer serving as a film-forming agent for the photosensitive layer. Also, the binder polymer used is appropriately selected according to the embodiment of development process so that the non-image area of the photosensitive layer can be successfully removed in the plate-making process of the lithographic printing plate precursor. For example, in an embodiment where the development process is performed by using an alkali developer, the binder needs to be dissolved in an alkali developer

and therefore, an organic high molecular polymer soluble in or swellable with an alkali water is preferably used.

This binder polymer is preferably a polymer having at least a structural unit represented by any one of the following formulae (1) to (3):

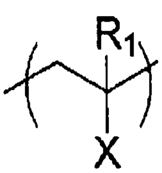
(1)

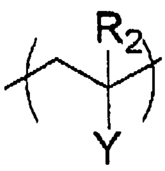
(2)

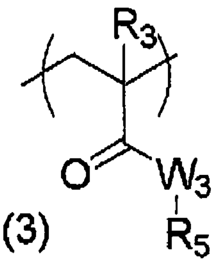
(3)

wherein $R_1$, $R_2$ and $R_3$ each independently represents a hydrogen atom or a C1-C6 alkyl group, X represents a functional group selected from -COOH, -CO-W1-L1-COOH and $-SO_3H$, W1 represents an oxygen atom, a sulfur atom or -NH- group, L1 represents a divalent organic group, Y represents $-CO-O-CH_2-CH=CH_2$ group or $-CO-W2-L2-O-CO-CR_4=CH_2$ group, W2 represents an oxygen atom, a sulfur atom or -NH- group, L2 represents a divalent organic group, $R_4$ represents a hydrogen atom or a C1-C6 alkyl group, W3 represents an oxygen atom, a sulfur atom or -NH- group, and $R_5$ represents a C1-C18 alkyl group, an alkyl group having a C5-C20 alicylcic structure, or a group having a C6-C20 aromatic ring.

Specific examples of the structural units represented by formulae (1) to (3) are set forth below, but the present invention is not limited thereto.

Specific examples of formula (1) include the structural units shown below.

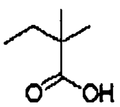
1-1

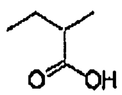
1-2

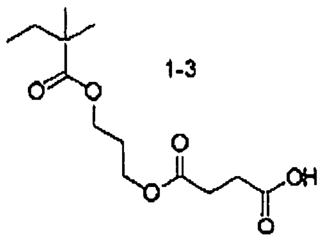
1-3

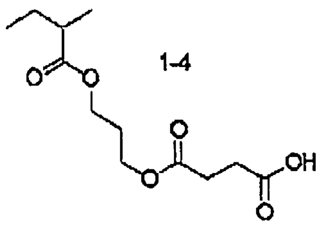
1-4

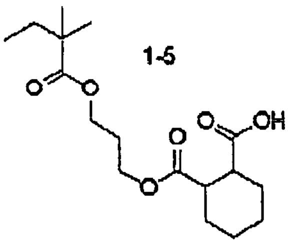
1-5

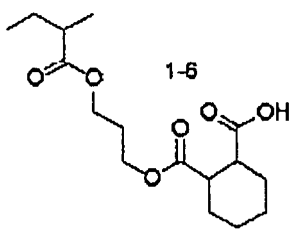
1-6

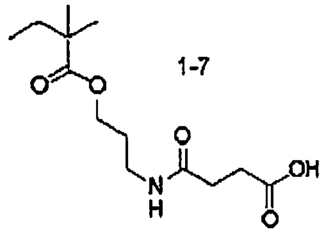
1-7

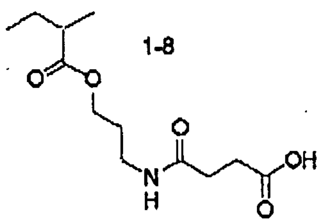
1-8

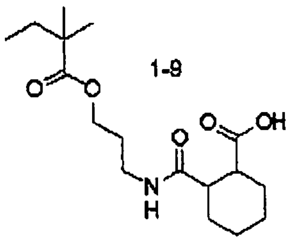
1-9

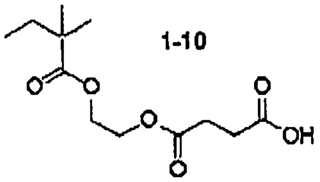
1-10

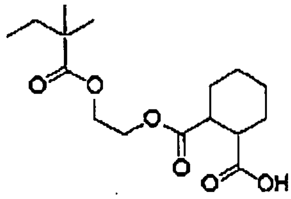
1-11

1-12
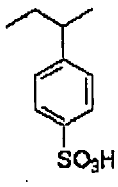

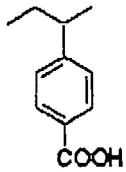
1-13

Specific examples of formula (2) include the structural units shown below.

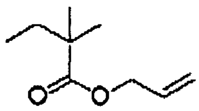
2-1

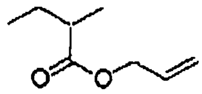
2-2

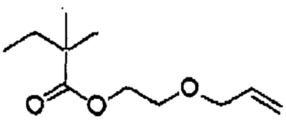
2-3

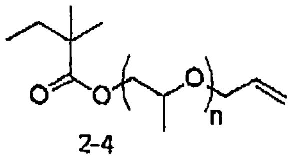
2-4

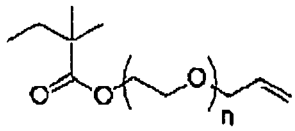
2-5

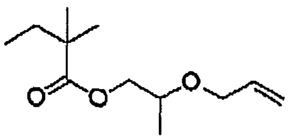
2-6

2-7
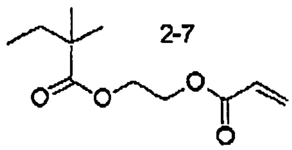

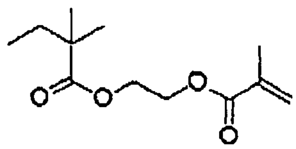
2-8

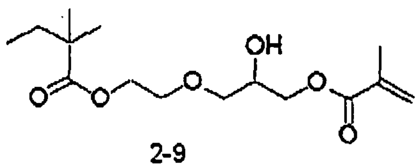
2-9

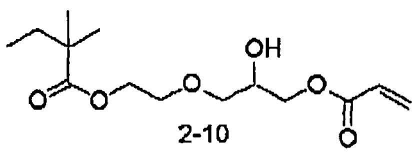
2-10

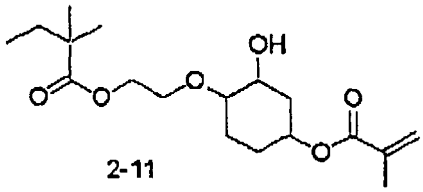
2-11

Specific examples of the monomer forming the structural unit of formula (3) include alkyl or aryl (meth)acrylates such as methyl (meth)acrylate, ethyl (meth)acrylate, isobutyl (meth)acrylate, n-butyl (meth)acrylate, isopropyl (meth) acrylate, cyclohexyl (meth)acrylate, n-hexyl (meth)acrylate, adamantyl (meth)acrylate, benzyl (meth)acrylate and phenethyl (meth)acrylate, and (meth)acrylates represented by the following formulae (in formulae, preferred examples of the substituent as R include a methyl group, an ethyl group, an isopropyl group, an n-butyl group, a tert-butyl group, a cyclohexyl group, a phenethyl group, a benzyl group and an n-hexyl group).

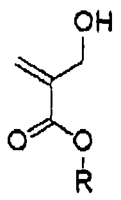 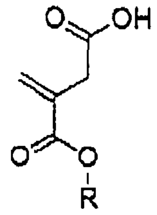 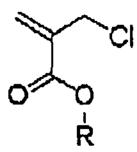 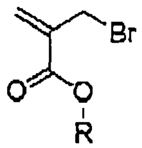 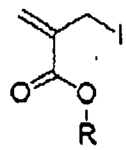

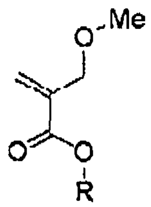 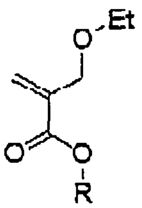 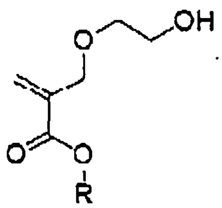 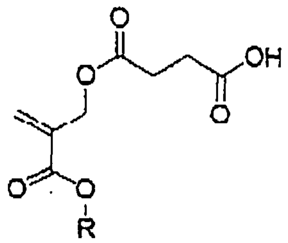

In order to maintain the developability of the photopolymerizable photosensitive layer, the binder polymer used preferably has appropriate molecular weight and acid value and is preferably a high molecular polymer having a weight average molecular weight of 5,000 to 300,000 and an acid value of 0.009 to 3.57 meq/g, more preferably 0.35 to 3.57 meq/g.

The structural units (1), (2) and (3) may be used in combination at any mixing ratio as long as the above-described molecular weight, acid value and amount of double bond are satisfied. Also, within the range of satisfying these, a structural unit other than (1) to (3) may also be further added.

A binder polymer may be contained in an arbitrary amount in the photosensitive layer, but if the content thereof exceeds 90 mass% based on all components in the photosensitive composition, a preferred result may not be obtained in view of image strength or the like. Therefore, the content of the binder polymer is preferably from 10 to 90 mass%, more preferably from 30 to 80 mass%.

In the present invention, a binder polymer other than those described above may also be mixed and used. The organic high molecular polymer includes various types, for example, a water-soluble organic high molecular polymer is used. Examples of such an organic high molecular polymer include an addition polymer having a carboxylic acid group in the side chain, such as polymers described in JP-A-59-44615, JP-B-54-34327, JP-B-58-12577, JP-B-54-25957, JP-A-54-92723, JP-A-59-53836 and JP-A-59-71048, that is, a methacrylic acid copolymer, an acrylic acid copolymer, an itaconic acid copolymer, a crotonic acid copolymer, a maleic acid copolymer and a partially esterified maleic acid copolymer; an acidic cellulose derivative having a carboxylic acid group in the side chain; a polymer obtained by adding a cyclic acid anhydride to an addition polymer having a hydroxyl group; a polyvinylpyrrolidone; a polyethylene oxide; and an alcohol-soluble polyamide and a polyether of 2,2-bis(4-hydroxyphenyl)propane and epichlorohydrin, which can increase the strength of cured film.

In addition, a polyurethane resin described in JP-B-7-120040, JP-B-7-120041, JP-B-7-120042, JP-B-8-12424, JP-A-63-287944, JP-A-63-287947, JP-A-1-271741 and JP-A-11-352691 can also be used in the present invention.

In an embodiment where the development process in the plate-making process is performed by using a developer at a pH of 2 to 10, a hydrophobic binder polymer is used as the binder polymer.

The hydrophobic binder polymer is preferably a water-insoluble polymer. Furthermore, the hydrophobic binder polymer which can be used is preferably a hydrophobic polymer substantially free of an acid group such as carboxyl group, sulfone group and phosphoric acid group, and the acid value (the acid content per g of the polymer expressed by the chemical equivalent number) of the binder polymer is preferably 0.3 meq/g or less, more preferably 0.1 meq/g or less.

That is, the hydrophobic binder polymer which can be used is preferably insoluble in water or in an aqueous

solution at a pH of 10 or more, and the solubility of the hydrophobic binder polymer in water or in an aqueous solution at a pH of 10 or more is preferably 0.5 mass% or less, more preferably 0.1 mass% or less. By virtue of using such a hydrophobic binder polymer, even in an embodiment where the development process is performed by using a developer at a pH of 2 to 10, the film strength, water resistance and inking property of the photosensitive layer are enhanced, and a prolonged press life can be obtained.

As for the hydrophobic binder polymer, conventionally known binder polymers preferably satisfying the above-described requirements can be used without limitation insofar as the performance of the lithographic printing plate precursor of the present invention is not impaired. A linear organic polymer having a film property is preferred.

Preferred examples of such a hydrophobic binder polymer include a polymer selected from an acrylic resin, a polyvinyl acetal resin, a polyurethane resin, a polyamide resin, an epoxy resin, a methacrylic resin, a styrene-based resin and a polyester resin. Among these, an acrylic resin is preferred, and a (meth)acrylic acid ester copolymer is more preferred. More specifically, a copolymer of an alkyl or aralkyl (meth)acrylate and a (meth)acrylic acid ester containing a $-CH_2CH_2O-$ unit or a $-CH_2CH_2NH-$ unit in R of the ester residue (-COOR) of the (meth)acrylic acid ester, is particularly preferred. The alkyl group in the alkyl (meth)methacrylate is preferably an alkyl group having a carbon number of 1 to 5, more preferably a methyl group. Preferred examples of the aralkyl (meth)acrylate include benzyl (meth)acrylate.

The hydrophobic binder polymer may be made to have a crosslinking property so as to enhance the film strength of the image area.

The crosslinking property may be imparted to the binder polymer by introducing a crosslinking functional group such as ethylenically unsaturated bond into the main or side chain of the molecule. The crosslinking functional group may be introduced by copolymerization or by a polymer reaction.

The crosslinking group as used herein means a group capable of crosslinking a polymer binder in the process of a radical polymerization reaction occurring in the photosensitive layer when the lithographic printing plate precursor is exposed. The crosslinking group is not particularly limited as long as it has such a function, but examples of the functional group capable of undergoing an addition-polymerization reaction include an ethylenically unsaturated bond group, an amino group and an epoxy group. The crosslinking group may also be a functional group which can be converted into a radical upon irradiation of light, and examples of such a crosslinking group include a thiol group, a halogen group and an onium salt group. Among these, an ethylenically unsaturated bond group is preferred, and a functional group represented by any one of the following formulae (1) to (3) is more preferred.

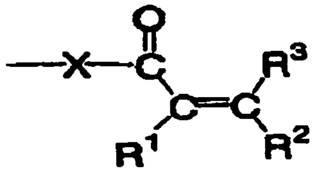

(1)

In formula (1), $R^1$ to $R^3$ each independently represents a hydrogen atom or a monovalent organic group. $R^1$ is preferably, for example, a hydrogen atom or an alkyl group which may have a substituent, and because of high radical reactivity, more preferably a hydrogen atom or a methyl group. $R^2$ and $R^3$ each is independently, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, and because of high radical reactivity, preferably a hydrogen atom, a carboxyl group, an alkoxycarbonyl group, an alkyl group which may have a substituent, or an aryl group which may have a substituent.

X represents an oxygen atom, a sulfur atom or $-N(R^{12})-$, and $R^{12}$ represents a hydrogen atom or a monovalent organic group. $R^{12}$ is, for example, an alkyl group which may have a substituent, and because of high radical reactivity, preferably a hydrogen atom, a methyl group, an ethyl group or an isopropyl group.

Examples of the substituent which can be introduced here include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

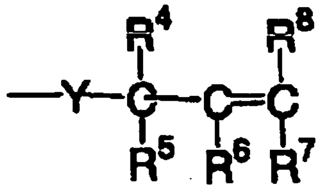

(2)

In formula (2), $R^4$ to $R^8$ each independently represents a hydrogen atom or a monovalent organic group. $R^4$ to $R^8$ each is preferably, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, preferably a hydrogen atom, a carboxyl group, an alkoxycarbonyl group, an alkyl group which may have a substituent, or an aryl group which may have a substituent.

Examples of the substituent which can be introduced are the same as those in formula (1). Y represents an oxygen atom, a sulfur atom or -N($R^{12}$)-, and $R^{12}$ has the same meaning as $R^{12}$ in formula (1), and preferred examples thereof are also the same.

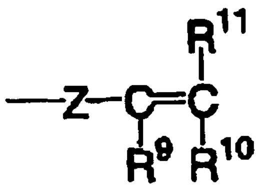

(3)

In formula (3), $R^9$ represents a hydrogen atom or a monovalent organic group, and $R^9$ is preferably, for example, a hydrogen atom or an alkyl group which may have a substituent, and because of high radical reactivity, more preferably a hydrogen atom or a methyl group. $R^{10}$ and $R^{11}$ each is independently, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, or an arylsulfonyl group which may have a substituent, and because of high radical reactivity, preferably a hydrogen atom, a carboxyl group, an alkoxycarbonyl group, an alkyl group which may have a substituent, or an aryl group which may have a substituent.

Examples of the substituent which can be introduced are the same as those in formula (1). Z represents an oxygen atom, a sulfur atom, -N($R^{13}$)- or a phenylene group which may have a substituent. $R^{13}$ is, for example, an alkyl group which may have a substituent, and because of high radical reactivity, preferably a methyl group, an ethyl group or an isopropyl group.

Among these, a (meth)acrylic acid copolymer having a crosslinking group in the side chain and polyurethane are more preferred.

In the hydrophobic binder polymer having a crosslinking property, for example, a free radical (a polymerization initiating radical or a radical grown in the process of polymerization of a polymerizable compound) is added to the crosslinking functional group to cause addition-polymerization between polymers directly or through a polymerization chain of the polymerizable compound, as a result, crosslinking is formed between polymer molecules and thereby curing is effected. Alternatively, an atom (for example, a hydrogen atom on the carbon atom adjacent to the functional crosslinking group) in the polymer is withdrawn by a free radical to produce a polymer radical and the polymer radicals combine with each other to form crosslinking between polymer molecules, thereby effecting curing.

The content of the crosslinking group (content of radical-polymerizable unsaturated double bond determined by iodine titration) in the hydrophobic binder polymer is preferably from 0.1 to 10.0 mmol, more preferably from 1.0 to 7.0 mmol, and most preferably from 2.0 to 5.5 mmol, per g of the hydrophobic binder polymer.

The binder polymer is preferably hydrophilic for enhancing the developability with an aqueous solution. Furthermore, for enhancing the press life, good compatibility with the polymerizable compound contained in the photosensitive layer is important, that is, the binder polymer is preferably lipophilic. From these standpoints, it is also effective in the present invention for enhancing the developability and press life that a hydrophilic group and a lipophilic group are

present together in the hydrophobic binder polymer. Suitable examples of the hydrophilic group include a hydroxy group, a carboxylate group, a hydroxyethyl group, an ethyleneoxy group, a hydroxypropyl group, a polyoxyethyl group, a polyoxypropyl group, an amino group, an aminoethyl group, an aminopropyl group, an ammonium group, an amide group and a carboxymethyl group.

The hydrophobic binder polymer preferably has a mass average molecular weight of 5,000 or more, more preferably from 10,000 to 300,000, and a number average molecular weight of 1,000 or more, more preferably from 2,000 to 250,000. The polydispersity (mass average molecular weight/number average molecular weight) is preferably from 1.1 to 10.

The hydrophobic binder polymer may be, for example, a random polymer, a block polymer or graft polymer but is preferably a random polymer.

One hydrophobic binder polymer may be used alone, or two or more hydrophobic binder polymers may be used as a mixture.

The content of the hydrophobic binder polymer is from 5 to 90 mass%, preferably from 10 to 70 mass%, more preferably from 10 to 60 mass%, based on the entire solid content of the photosensitive layer. Within this range, good strength of the image area and good image forming property are obtained.

[Organic Compound Having Mercapto Group]

In the present invention, when hexaarylbisimidazoles are used as the polymerization initiator, a specific mercapto compound is preferably used in combination.

The mercapto compound which can be preferably used in the present invention is a compound selected from 2-mercaptobenzothiazole, 2-mercaptobenzoxazole, 2-mercaptobenzimidazole and a compound represented by the following formula (4):

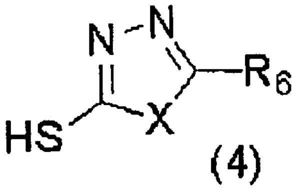

(4)

wherein $R_6$ represents a hydrogen atom, a C1-C18 linear or branched alkyl group, an alkyl group having a C5-C20 alicylcic structure, or a group having a C6-C20 aromatic ring, X represents an oxygen atom, a sulfur atom or -N-$R_7$, and $R_7$ represents a C1-C18 linear or branched alkyl group, an alkyl group having a C5-C20 alicylcic structure, or a group having a C6-C20 aromatic ring.

Suitable examples of the compound represented by formula (4) include the compounds shown below.

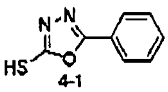

4-1

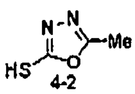

4-2

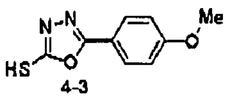

4-3

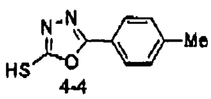

4-4

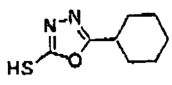

4-5

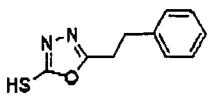

4-6

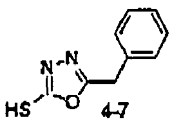

4-7

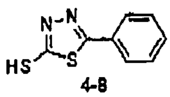
4-8
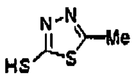
4-9
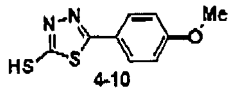
4-10
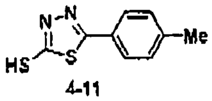
4-11
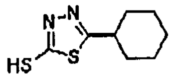
4-12
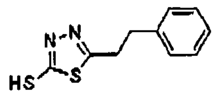
4-13
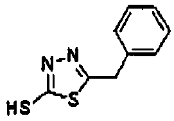
4-14
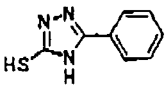
4-15
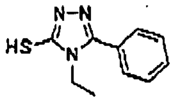
4-16
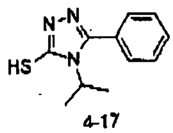
4-17
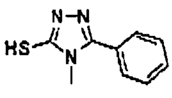
4-18
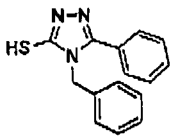
4-19
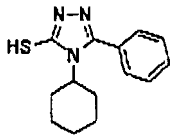
4-20
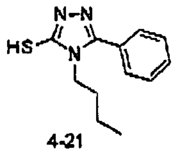
4-21
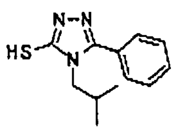
4-22
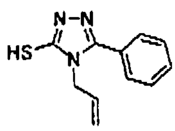
4-23
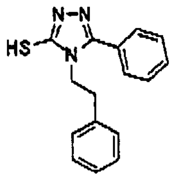
4-24
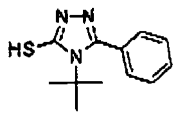
4-25
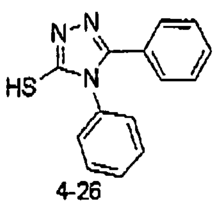
4-26
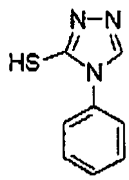
4-27
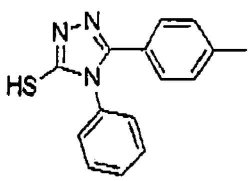
4-28
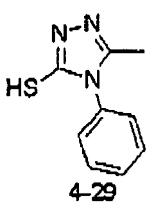
4-29
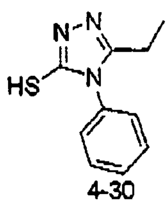
4-30
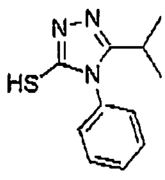
4-31
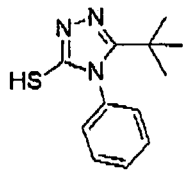
4-32

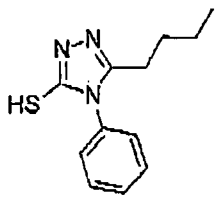

4-33

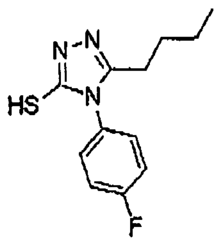

4-34

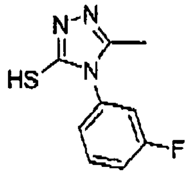

4-35

The amount used of the mercapto compound is preferably from 3 to 30 mass%, more preferably from 5 to 20 mass%, based on all components in the photosensitive composition.

(Co-sensitizer)

The sensitivity of the photosensitive layer can be further enhanced by using a certain kind of additive and in the present invention, such a compound is referred to as a co-sensitizer. The operation mechanism thereof is not clearly known but is considered to mostly rely on the following chemical process. That is, the co-sensitizer reacts with various intermediate active species (e.g., radical, peroxide, oxidant, reductant) generated in the process of photoreaction initiated by the light absorption of the photopolymerization initiation system described above and the subsequent addition-polymerization reaction, to produce a new active radical. Such compounds are roughly classified into (a) a compound capable of producing an active radical by being reduced, (b) a compound capable of producing an active radical by being oxidized, and (c) a compound capable of reacting with a radical having low activity to convert it into a more highly active radical or acting as a chain transfer agent. However, in many cases, a common view is not present about to which type of these types individual compounds belong.

(a) Compound capable of producing active radical by being reduced

Compound having carbon-halogen bond:

An active radical is considered to be generated by the reductive cleavage of carbon-halogen bond. Specific examples of this compound which can be suitably used include trihalomethyl-s-triazines and trihalomethyloxadiazoles.

Compound having nitrogen-nitrogen bond:

An active radical is considered to be generated by the reductive cleavage of nitrogen-nitrogen bond. Specific examples of this compound which can be suitably used include hexaarylbiimidazoles.

Compound having oxygen-oxygen bond:

An active radical is considered to be generated by the reductive cleavage of oxygen-oxygen bond. Specific examples of this compound which can be suitably used include organic peroxides.

Onium compound:

An active radical is considered to be generated by the reductive cleavage of carbon-hetero bond or oxygen-nitrogen bond. Specific examples of this compound which can be suitably used include diaryliodonium salts, triarylsulfonium salts and N-alkoxypyridinium (azinium) salts.

Ferrocene and iron arene complexes:

An active radical can be reductively produced.

(b) Compound capable of producing active radical by being oxidized

Alkylate complex:

An active radical is considered to be generated by the oxidative cleavage of carbon-hetero bond. Specific

examples of this compound which can be suitably used include triaryl alkylborates.

Alkylamine compound:

An active radical is considered to be generated by the oxidative cleavage of C-X bond on the carbon adjacent to nitrogen. X is preferably, for example, a hydrogen atom, a carboxyl group, a trimethylsilyl group or a benzyl group. Specific examples of this compound include ethanolannines, N-phenylglycines and N-trimethylsilylnaethylanilines.

Sulfur- or tin-containing compound:

This is a compound in which the nitrogen atom of the above-described amines is replaced by a sulfur atom or a tin atom. An active radical can be produced by the same action. Also, a compound having an S-S bond is known to effect sensitization by the S-S cleavage.

α-Substituted methylcarbonyl compound:

An active radical can be produced by the oxidative cleavage of carbonyl-α carbon bond. The compound in which the carbonyl is converted into an oxime ether also shows the same action. Specific examples of this compound include 2-alkyl-1-[4-(alkylthio)phenyl]-2-morpholinopronone-1 compounds and their oxime ethers resulting from reaction with hydroxyamines and subsequent etherification of N-OH.

Sulfinic acid salts:

An active radical can be reductively produced. Specific examples of this compound include sodium arylsulfinate.

(c) Compound capable of reacting with radical to convert it into more highly active radical or acting as chain transfer agent:

As for the compound capable of reacting with a radical to convert it into a more highly active radical or acting as a chain transfer agent, for example, compounds having SH, PH, SiH or GeH within the molecule are used. These compounds can donate hydrogen to a low activity radical species to produce a radical or can produce a radical by being oxidized and then deprotonated. Specific examples of this compound include 2-mercaptobenzimidazoles.

A large number of examples of the co-sensitizer are more specifically described, for example, in JP-A-9-236913 as the additive for enhancing the sensitivity. Some of these are set forth below, but the present invention is not limited thereto.

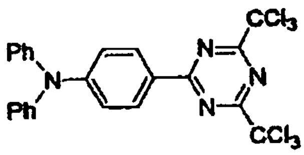 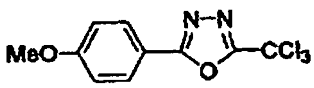 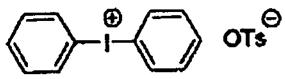

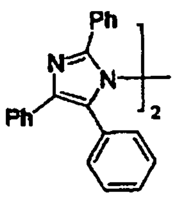 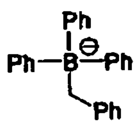 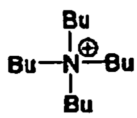 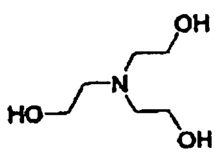

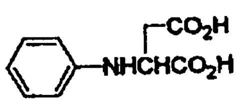 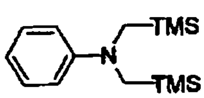 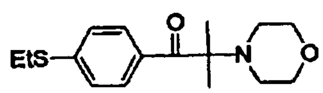

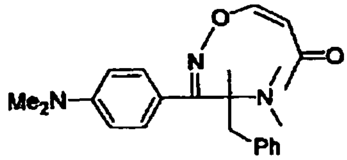

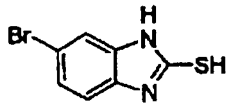

Similarly to the above-described sensitizing dye, such a co-sensitizer may be subjected to various chemical modifications so as to improve the properties of the photosensitive layer of the lithographic printing plate precursor. For example, a method such as binding to sensitizing dye, titanocene, addition-polymerizable unsaturated compound or other radical-generating parts, introduction of a hydrophilic moiety, introduction of a substituent for enhancing compatibility, inhibiting crystallization or improving adhesion, and polymer formation, may be used. One of these co-sensitizers can be used alone, or two or more thereof may be used in combination. The amount of the co-sensitizer used is suitably from 0.05 to 100 parts by mass, preferably from 1 to 80 parts by mass, more preferably from 3 to 50 parts by mass, per 100 parts by mass of the compound having an ethylenically unsaturated double bond.

(Microcapsule)

In the present invention, as for the method of incorporating the above-described constituent components of the photosensitive layer and other constituent components described later into the photosensitive layer, the constituent components may be partially enclosed in a microcapsule and added to the photosensitive layer as described, for example, in JP-A-2001-277740 and JP-A-2001-277742. In this case, the constituent components may be incorporated into the inside and outside of the microcapsule at an arbitrary ratio.
With respect to the method of microencapsulating the constituent components of the photosensitive layer, a known method may be applied. Examples of the production method of a microcapsule include, but are not limited to, a method utilizing coacervation described in U.S. Patents 2,800,457 and 2,800,458, a method by an interfacial polymerization process described in U.S. Patent 3,287,154, JP-B-38-19574 and JP-B-42-446, a method by the precipitation of polymer described in U.S. Patents 3,418,250 and 3,660,304, a method using an isocyanate polyol wall material described in U.S. Patent 3,796,669, a method using an isocyanate wall material described in U.S. Patent 3,914,511, a method using a urea-formaldehyde or urea-formaldehyde-resorcinol wall-forming material described in U.S. Patents 4,001,140, 4,087,376 and 4,089,802, a method using a wall material such as melamine-formaldehyde resin or hydroxy cellulose described in U.S. Patent 4,025,445, an *in situ* method by the monomer polymerization described in JP-B-36-9163 and JP-A-51-9079, a spray drying method described in British Patent 930,422 and U.S. Patent 3,111,407, and an electrolytic dispersion cooling method described in British Patents 952,807 and 967,074.
The microcapsule wall which is preferably used in the present invention is a microcapsule wall having a three-dimensionally crosslinked structure and being swellable with a solvent. From this standpoint, the wall material of the microcapsule is preferably polyurea, polyurethane, polyester, polycarbonate, polyamide or a mixture thereof, more preferably polyurea or polyurethane. Also, a compound having a crosslinking functional group such as ethylenically unsaturated bond, which can be introduced into the above-described water-insoluble polymer, may be introduced into the microcapsule wall.
The average particle diameter of the microcapsule is preferably from 0.01 to 3.0 μm, more preferably from 0.05 to 2.0 μm, still more preferably from 0.10 to 1.0 μm. Within this range, good resolution and good aging stability are obtained.

(Other Components of Photosensitive Layer)

The photosensitive layer of the present invention may further contain other additives, if desired. These additives are described below.

(Surfactant)

In the present invention, a surfactant is preferably used in the photosensitive layer so as to accelerate the development and enhance the coated surface state. The surfactant includes a nonionic surfactant, an anionic surfactant, a cationic surfactant, an amphoteric surfactant, a fluorine-containing surfactant and the like. One surfactant may be used alone, or two or more kinds of surfactants may be used in combination.
The nonionic surfactant for use in the present invention is not particularly limited and a conventionally known nonionic surfactant may be used. Examples thereof include polyoxyethylene alkyl ethers, polyoxyethylene alkylphenyl ethers, polyoxyethylene polystyrylphenyl ethers, polyoxyethylene polyoxypropylene alkyl ethers, glycerin fatty acid partial

esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerin fatty acid partial esters, polyoxyethylenated castor oils, polyoxyethylene glycerin fatty acid partial esters, fatty acid diethanolamides, N,N-bis-2-hydroxyalkylamines, polyoxyethylene alkylamine, a triethanolamine fatty acid ester, trialkylamine oxide, polyethylene glycol, and a copolymer of polyethylene glycol and polypropylene glycol.

The anionic surfactant for use in the present invention is not particularly limited and a conventionally known anionic surfactant may be used. Examples thereof include fatty acid salts, abietates, hydroxyalkanesulfonates, alkanesulfonates, dialkylsulfosuccinic ester salts, linear alkylbenzenesulfonates, branched alkylbenzenesulfonates, alkylnaphthalenesulfonates, alkylphenoxypolyoxyethylenepropylsulfonates, polyoxyethylenealkylsulfophenyl ether salts, N-methyl-N-oleyltaurine sodium salt, monoamide disodium N-alkylsulfosuccinate, petroleum sulfonates, sulfated beef tallow oil, sulfuric ester salts of fatty acid alkyl ester, alkylsulfuric ester salts, polyoxyethylene alkyl ether sulfuric ester salts, fatty acid monoglyceride sulfuric ester salts, polyoxyethylene alkylphenyl ether sulfuric ester salts, polyoxyethylene styrylphenyl ether sulfuric ester salts, alkylphosphoric ester salts, polyoxyethylene alkyl ether phosphoric ester salts, polyoxyethylene alkylphenyl ether phosphoric ester salts, partially saponified styrene/maleic anhydride copolymerization products, partially saponified olefin/maleic anhydride copolymerization products, and naphthalenesulfonate formalin condensates.

The cationic surfactant for use in the present invention is not particularly limited and a conventionally known cationic surfactant may be used. Examples thereof include alkylamine salts, quaternary ammonium salts, polyoxyethylenealkylamine salts and a polyethylene polyamine derivative.

The amphoteric surfactant for use in the present invention is not particularly limited and a conventionally known amphoteric surfactant may be used. Examples thereof include carboxybetaines, aminocarboxylic acids, sulfobetaines, aminosulfuric esters and imidazolines.

The term "polyoxyethylene" in the above-described surfactants can be instead read as "polyoxyalkylene" such as polyoxymethylene, polyoxypropylene and polyoxybutylene, and these surfactants can also be used in the present invention.

The surfactant is more preferably a fluorine-containing surfactant containing a perfluoroalkyl group within the molecule. This fluorine-containing surfactant includes an anionic type such as perfluoroalkylcarboxylatc, perfluoroalkylsulfonate and perfluoroalkylphosphoric ester, an amphoteric type such as perfluoroalkylbetaine; a cationic type such as perfluoroalkyltrimethylammonium salt; and a nonionic type such as perfluoroalkylamine oxide, perfluoroalkyl ethylene oxide adduct, oligomer containing a perfluoroalkyl group and a hydrophilic group, oligomer containing a perfluoroalkyl group and a lipophilic group, oligomer containing a perfluoroalkyl group, a hydrophilic group and a lipophilic group, and urethane containing a perfluoroalkyl group and a lipophilic group. In addition, fluorine-containing surfactants described in JP-A-62-170950, JP-A-62-226143 and JP-A-60-168144 may also be suitably used.

One surfactant may be used alone, or two or more kinds of surfactants may be used in combination.

The surfactant content is preferably from 0.001 to 10 mass%, more preferably from 0.01 to 7 mass%, based on the entire solid content of the photosensitive layer.

(Hydrophilic Polymer)

In the present invention, a hydrophilic polymer may contained for enhancing the developability or enhancing the dispersion stability of microcapsule.

Suitable examples of the hydrophilic polymer include a polymer having a hydrophilic group such as hydroxy group, carboxyl group, carboxylate group, hydroxyethyl group, polyoxyethyl group, hydroxypropyl group, polyoxypropyl group, amino group, aminoethyl group, aminopropyl group, ammonium group, amide group, carboxymethyl group, sulfonic acid group and phosphoric acid group.

Specific examples thereof include gum arabic, casein, gelatin, a starch derivative, carboxymethyl cellulose or a sodium salt thereof, cellulose acetate, sodium alginate, vinyl acetate-maleic acid copolymers, styrene-maleic acid copolymers, polyacrylic acids and a salt thereof, polymethacrylic acids and a salt thereof, a homopolymer or copolymer of hydroxyethyl methacrylate, a homopolymer or copolymer of hydroxyethyl acrylate, a homopolymer or copolymer of hydroxypropyl methacrylate, a homopolymer or copolymer of hydroxypropyl acrylate, a homopolymer or copolymer of hydroxybutyl methacrylate, a homopolymer or copolymer of hydroxybutyl acrylate, polyethylene glycols, hydroxypropylene polymers, polyvinyl alcohols, a hydrolyzed polyvinyl acetate having a hydrolysis degree of 60 mol% or more, preferably 80 mol% or more, polyvinyl formal, polyvinyl butyral, polyvinylpyrrolidone, a homopolymer or copolymer of acrylamide, a homopolymer or copolymer of methacrylamide, a homopolymer or copolymer of N-methylolacrylamide, polyvinylpyrrolidone, alcohol-soluble nylon, and a polyether of 2,2-bis-(4-hydroxyphenyl)-propane with epichlorohydrin.

The hydrophilic polymer preferably has a mass average molecular weight of 5,000 or more, more preferably from 10,000 to 300,000. The hydrophilic polymer may be a random polymer, a block polymer, a graft polymer or the like.

The content of the hydrophilic polymer in the photosensitive layer is preferably 20 mass% or less, more preferably 10 mass% or less, based on the entire solid content of the photosensitive layer.

(Colorant)

In the present invention, a dye having large absorption in the visible region may be used as a colorant for an image. Specific examples thereof include Oil Yellow #101, Oil Yellow #103, Oil Pink #312, Oil Green BG, Oil Blue BOS, Oil Blue #603, Oil Black BY, Oil Black BS; Oil Black T-505 (all produced by Orient Chemical Industry Co., Ltd.), Victoria Pure Blue, Crystal Violet (CI42555), Methyl Violet (CI42535), Ethyl Violet, Rhodamine B (CI145170B), Malachite Green (CI42000), Methylene Blue (CI52015), and dyes described in JP-A-62-293247. Also, pigments such as phthalocyanine-based pigment (e.g., C.I. Pigment Blue 15:3, 15:4, 15:6), azo-based pigment, carbon black and titanium oxide may be suitably used.

The colorant is preferably added, because the image area and the non-image area after image formation can be clearly distinguished. The amount of the colorant added is preferably from 0.01 to 10 mass% based on the entire solid content of the image recording material.

(Printing-Out Agent)

In the photosensitive layer of the present invention, a compound capable of changing in the color by the effect of an acid or a radical can be added so as to produce a printout image. As such a compound, various dyes of, for example, diphenylmethane type, triphenylmethane type, thiazine type, oxazine type, xanthene type, anthraquinone type, iminoquinone type, azo type and azomethine type, are effectively used.

Specific examples thereof include dyes such as Brilliant Green, Ethyl Violet, Methyl Green, Crystal Violet, Basic Fuchsine, Methyl Violet 2B, Quinaldine Red, Rose Bengale, Metanil Yellow, Thymolsulfophthalein, Xylenol Blue, Methyl Orange, Paramethyl Red, Congo Red, Benzopurpurine 4B, $\alpha$-Naphthyl Red, Nile Blue 2B, Nile Blue A, Methyl Violet, Malachite Green, Parafuchsine, Victoria Pure Blue BOH [produced by Hodogaya Chemical Co., Ltd.], Oil Blue #603 [produced by Orient Chemical Industry Co., Ltd.], Oil Pink #312 [produced by Orient Chemical Industry Co., Ltd.], Oil Red 5B [produced by Orient Chemical Industry Co., Ltd.], Oil Scarlet #308 [produced by Orient Chemical Industry Co., Ltd.], Oil Red OG [produced by Orient Chemical Industry Co., Ltd.], Oil Red RR [produced by Orient Chemical Industry Co., Ltd.], Oil Green #502 [produced by Orient Chemical Industry Co., Ltd.], Spiron Red BEH Special [produced by Hodogaya Chemical Co., Ltd.], m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carboxystearylamino-4-p-N,N-bis(hydroxyethyl)aminophenyliminonaphthoquinone, 1-phenyl-3-methyl-4-p-diethylaminophenylimino-5-pyrazolone and 1-$\beta$-naphthyl-4-p-diethylaminophenylimino-5-pyrazolone, and leuco dyes such as p,p',p''-hexamethyltriaminotriphenyl methane (Leuco Crystal Violet) and Pergascript Blue SRB (produced by Ciba-Geigy).

Other suitable examples include a leuco dye known as a material for heat-sensitive or pressure-sensitive paper. Specific examples thereof include Crystal Violet Lactone, Malachite Green Lactone, Benzoyl Leuco Methylene Blue, 2-(N-phenyl-N-methylatnino)-6-(N-p-tolyl-N-ethyl)aminofluorane, 2-anilino-3-methyl-6-(N-ethyl-p-toluidizto)fluorane, 3,6-dimethoxyfluorane, 3-(N,N-diethylamino)-5-methyl-7-(N,N-dibezxzylamino)fluorane, 3-(N-cyclohexyl-N-methylamino)-6-methyl-7-anilinofluorane, 3-(N,N-diethylamino)-6-methyl-7-anilinofluorane, 3-(N,N-diethylamino)-6-methyl-7-xytidinofluorane, 3-(N,N-diethylamino)-6-methyl-7-chlorofluorane, 3-(N,N-diethylannino)-6-methoxy-7-aminofluorane, 3-(N,N-diethylamino)-7-(4-chloroanilino)fluorane, 3-(N,N-diethylamino)-7-chorofluorane, 3-(N,N-diethylamino)-7-benzylaminofluorane, 3-(N,N-diethylamino)-7,8-benzofluorane, 3-(N,N-dibutylamino)-6-methyl-7-anilinofluorane, 3-(N,N-dibutylamxno)-6-methyl-7-xylidinofluorane, 3-piperidino-6-methyl-7-anilinofluorane, 3-pyrrolidino-6-methyl-7-anilinofluorane, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)4-phthalide and 3-(4-diethylaminophenyl)-3-(1-ethyl-2-methylindol-3-yl)phthalide.

The dye capable of changing in the color by the effect of an acid or a radical is suitably added in an amount of 0.01 to 15 mass% based on the solid content of the photosensitive layer.

(Polymerization Inhibitor)

In the photosensitive layer of the present invention, a small amount of a thermopolymerization inhibitor is preferably added so as to prevent unnecessary thermopolymerization of the polymerizable compound during the production or storage of the photosensitive layer.

Suitable examples of the thermopolymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tert-butylphenol) and N-nitroso-N-phenylhydroxylamine aluminum salt.

The amount of the thermopolymerization inhibitor added is preferably from about 0.01 to about 5 mass% based on the entire solid content of the photosensitive layer.

(Higher Fatty Acid Derivative, etc.)

In the photosensitive layer of the present invention, a higher fatty acid derivative such as behenic acid or behenic acid amide may be added and allowed to localize on the surface of the photosensitive layer in the process of drying after coating so as to prevent polymerization inhibition by oxygen. The amount of the higher fatty acid derivative added is preferably from about 0.1 to about 10 mass% based on the entire solid content of the photosensitive layer.

(Plasticizer)

The photosensitive layer of the present invention may contain a plasticizer. Suitable examples of the plasticizer include phthalic acid esters such as dimethyl phthalate, diethyl phthalate, dibutyl phthalate, diisobutyl phthalate, diocyl phthalate, octyl capryl phthalate, dicyclohexyl phthalate, ditridecyl phthalate, butyl benzyl phthalate, diisodecyl phthalate and diallyl phthalate; glycol esters such as dimethyl glycol phthalate, ethyl phthalylethyl glycolate, methyl phthalylethyl glycolate, butyl phthalylbutyl glycolate and triethylene glycol dicaprylic acid ester; phosphoric acid esters such as tricresyl phosphate and triphenyl phosphate; aliphatic dibasic acid esters such as diisobutyl adipate, dioctyl adipate, dimethyl sebacate, dibutyl sebacate, dioctyl azelate and dibutyl maleate; polyglycidyl methacrylate, triethyl citrate, glycerin triacetyl ester and butyl laurate. The plasticizer content is preferably about 30 mass% or less based on the entire solid content of the photosensitive layer.

(Inorganic Fine Particle)

The photosensitive layer of the present invention may contain an inorganic fine particle so as to enhance the cured film strength in the image area. Suitable examples of the inorganic fine particle include silica, alumina, magnesium oxide, titanium oxide, magnesium carbonate, calcium alginate and a mixture thereof. Such an inorganic fine particle can be used, for example, for strengthening the film or roughening the surface to enhance the adhesion at the interface, even if it has no light-to-heat converting property. The average particle diameter of the inorganic fine particle is preferably from 5 nm to 10 μm, more preferably from 0.5 to 3 μm. Within this range, the inorganic particle is stably dispersed in the photosensitive layer, so that the photosensitive layer can maintain sufficiently high film strength and the non-image area formed can have excellent hydrophilicity and exhibit antistaining property at printing.

Such an inorganic fine particle is easily available on the market as a colloidal silica dispersion or the like.

The inorganic fine particle content is preferably 20 mass% or less, more preferably 10 mass% or less, based on the entire solid content of the photosensitive layer.

(Low-Molecular Hydrophilic Compound)

The photosensitive layer of the present invention may contain a hydrophilic low-molecular compound so as to enhance the developability. Examples of the hydrophilic low-molecular compound include, as a water-soluble organic compound, glycols and ether or ester derivatives thereof, such as ethylene glycol, diethylene glycol, triethylene glycol, propylene glycol, dipropylene glycol and tripropylene glycol; polyhydxoxys such as glycerin and pentaerythritol; organic amines and salts thereof, such as triethanolamine, diethanolamine and monoethanolamine; organic sulfonic acids and salts thereof, such as toluenesulfonic acid and benzenesulfonic acid; organic phosphonic acids and salts thereof, such as phenylphosphonic acid; organic carboxylic acids and salts thereof, such as tartaric acid, oxalic acid, citric acid, malic acid, lactic acid, gluconic acid and amino acids; and an organic quaternary ammonium salt such as tetraethylamine hydrochloride.

Also, in the photosensitive layer of the lithographic printing plate precursor according to the present invention, for example, a UV initiator and a thermal crosslinking agent may be added to strengthen the effect of heating and exposure performed after development, which is described later, for the purpose of enhancing the film strength (press life).

The lithographic printing plate precursor is described below.

The lithographic printing plate precursor used in the present invention has at least a photosensitive layer on a support.

[Support]

As for the support used in the present invention, a conventionally known support employed for a lithographic printing plate precursor can be used without any limitation.

The support used is preferably a dimensionally stable plate-like material, for example, paper, paper laminated with plastic (e.g., polyethylene, polypropylene, polystyrene), a metal plate (e.g., aluminum, zinc, copper), a plastic film (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal), and paper or a plastic film having laminated or vapor-deposited thereon the above-described metal. If desired, the surface of such a support may be subjected to an appropriate known physical or chemical treatment for the purpose of imparting hydrophilicity, increasing strength or the like.

Preferred examples of the support include paper, a polyester film and an aluminum plate. Among these, an aluminum plate is more preferred because this has good dimensional stability, is relatively inexpensive and can provide a surface excellent in the hydrophilicity and strength by a surface treatment as needed. Furthermore, a composite sheet comprising a polyethylene terephthalate film having bonded thereon an aluminum sheet described in JP-B-48-18327 is also preferred.

The aluminum plate as a most suitable support in the present invention is a dimensionally stable metal plate mainly comprising aluminum, and this is selected from a pure aluminum plate, an alloy plate mainly comprising aluminum and containing trace of foreign elements, and a plastic film or paper having laminated or vapor-deposited thereon aluminum (or an alloy thereof). In the description below, the support comprising aluminum and the support comprising an aluminum alloy are collectively referred to as an aluminum support. Examples of the foreign element contained in the aluminum alloy include silicon, iron, manganese, copper, magnesium, chromium, zinc, bismuth, nickel and titanium. The foreign element content in the alloy is 10 mass% or less. In the present invention, a pure aluminum plate is preferred, but perfectly pure aluminum is difficult to produce in view of the refining technique and therefore, an aluminum plate containing a trace heteroelement may be used. Such an aluminum plate for use in the present invention is not particularly limited in its composition, and those formed of a conventionally known and commonly employed material such as JIS A 1050, JIS A 1100, JIS A 3103 or JIS A 3005 can be appropriately used.

The thickness of the aluminum support for use in the present invention is approximately from 0.1 to 0.6 mm. This thickness can be appropriately changed depending on the size of a printing press, the size of a printing plate or the demands of users.

The aluminum support may be subjected, if desired, to a surface treatment such as surface roughening treatment and anodization treatment described below. The surface treatment facilitates enhancing hydrophilicity and ensuring adhesion between the photosensitive layer and the support. In advance of surface-roughening treatment, a degreasing treatment with a surfactant, an organic solvent, an alkaline aqueous solution or the like is performed, if desired, for removing the rolling oil on the surface.

(Surface Roughening Treatment)

The surface-roughening treatment of the aluminum plate surface is performed by various methods and examples thereof include a mechanical surface-roughening treatment, an electrochemical surface-roughening treatment (a surface-roughening treatment of electrochemically dissolving the surface) and a chemical surface-roughening treatment (a surface-roughening treatment of chemically and selectively dissolving the surface). These surface-roughening treatments may be used individually or in combination.

The mechanical surface-roughening treatment may be performed by using a known method such as ball polishing, brush polishing, blast polishing and buff polishing.

The method for the electrochemical surface-roughening treatment includes, for example, a method of passing an alternating or direct current in an electrolytic solution containing an acid such as hydrochloric acid or nitric acid. Also, a method using a mixed acid described in JP-A-54-63902 may be used.

Among these methods, the method useful for the surface roughening is an electrochemical method of chemically roughening the surface in an electrolytic solution of hydrochloric acid or nitric acid. The anodic time electricity is suitably from 50 to 400 C/dm$^2$. More specifically, AC and/or DC electrolysis is preferably performed in an electrolytic solution containing from 0.1 to 50% hydrochloric acid or nitric acid under the conditions such that the temperature is from 20 to 80°C, the treating time is from 1 second to 30 minutes, and the electric current density is from 100 to 400 C/dm$^2$.

The aluminum support surface-roughened in this way may be chemically etched with an acid or an alkali. Suitable examples of the etching agent include sodium hydroxide, sodium carbonate, sodium aluminate, sodium metasilicate, sodium phosphate, potassium hydroxide and lithium hydroxide. The concentration and temperature are preferably in the range from 1 to 50% and in the range from 20 to 100°C, respectively. After the etching, washing with an acid is performed so as to remove scumming (smut) remaining on the surface. Examples of the acid used include a nitric acid, a sulfuric acid, a chromic acid, a hydrofluoric acid and a borohydrofluoric acid. As for the method for desmutting after the electrochemically surface roughening treatment, preferred examples thereof include a method of contacting the aluminum support with a sulfuric acid of 15 to 65 mass% at a temperature of 50 to 90°C described in JP-A-53-12739, and a method of etching the support with an alkali described in JP-B-48-28123. The method and conditions are not

particularly limited as long as the thus-treated surface has a surface roughness Ra of approximately from 0.2 to 0.5 μm.

(Anodizing Treatment)

The aluminum support treated in this way is then subjected to an anodizing treatment to form an oxide film.

In the anodizing treatment, sulfuric acid, phosphoric acid, oxalic acid and boric acid/sodium borate each in the form of an aqueous solution are used individually or in combination of two or more thereof as the main component of the electrolytic bath. In this case, at least ingredients ordinarily contained in the aluminum alloy plate, electrode, city water, ground water or the like may be of course contained in the electrolytic solution. Furthermore, a second or third component may be added. Examples of the second or third component as used herein include a cation such as ion of metal (e.g., Na, K, Mg, Li, Ca, Ti, Al, V, Cr, Mn, Fe, Co, Ni, Cu, Zn) and ammonium ion, and an anion such as nitrate ion, carbonate ion, chloride ion, phosphate ion, fluoride ion, sulfite ion, titanate ion, silicate ion and borate ion. The ion may be contained to a concentration of approximately from 0 to 10,000 ppm. The conditions of the anodizing treatment are not particularly limited, but the treatment is preferably performed by DC or AC electrolysis in 30 to 500 g/liter at a treating liquid temperature of 10 to 70°C with an electric current density of 0.1 to 40 $A/m^2$. The thickness of the anodic oxide film formed is from 0.5 to 1.5 μm, preferably from 0.5 to 1.0 μm. The treating conditions are preferably selected such that the anodic oxide film of the support produced by the treatment.has micropores having a pore diameter of 5 to 10 nm at a pore density of $8\times10^{15}$ to $2\times10^{16}$ pores/$m^2$.

A substrate having thereon an anodic oxide film after the above-described surface treatment may be used directly as the support for use in the present invention, but in order to more improve adhesion to the upper layer, hydrophilicity, antiscumming property, heat insulation and the like, treatments described in JP-A-2001-253181 and JP-A-2001-322365, such as a treatment for enlarging micropores of the anodic oxide film, a treatment for pore-sealing micropores and a surface-hydrophilizing treatment of dipping the substrate in an aqueous solution containing a hydrophilic compound, may be appropriately selected and applied. Of course, the enlarging treatment and pore-sealing treatment are not limited to those described in these patent publications, and any conventionally known method may be employed.

Other than the pore-sealing with vapor, the pore-sealing treatment may be a pore-sealing treatment with an aqueous solution containing an inorganic fluorine compound, such as treatment with fluorozirconic acid alone and treatment with sodium fluoride, a pore-sealing treatment with vapor having added thereto lithium chloride, or a pore-sealing treatment with hot water.

Among these, a pore-sealing treatment with an aqueous solution containing an inorganic fluorine compound, a pore-sealing treatment with water vapor, and a pore-sealing treatment with hot water are preferred.

As for the hydrophilizing treatment, an alkali metal silicate method described in U.S. Patents 2,714,066, 3,181,461, 3,280,734 and 3,902,734 is known. In this method, the support is subjected to a dipping treatment with an aqueous solution of sodium silicate or the like or an electrolysis treatment. Other examples of the hydrophilizing treatment include a method of treating the support with potassium fluorozirconate described in JP-B-36-22063, and a method of treating the support with a polyvinylphosphonic acid described in U.S. Patent 3,276,868, 4,153,461 and 4,689,272.

The hydrophilizing treatment of the support surface is preferably a hydrophilizing treatment with a silicate, a polyvinylphosphonic acid or the like. In this case, the film is formed to a coverage of 2 to 40 mg/$m^2$, more preferably from 4 to 30 mg/$m^2$, in terms of Si or P element amount. The coated amount can be measured by the fluorescent X-ray analysis method.

The hydrophilizing treatment is performed by immersing the aluminum support having formed thereon an anodic oxide film in an aqueous solution having an alkali metal silicate or polyvinylphosphonic acid concentration of 1 to 30 mass%, preferably from 2 to 15 mass%, and a pH at 25°C of 10 to 13, for example, at 15 to 80°C for 0.5 to 120 seconds.

Examples of the alkali metal silicate for use in the hydrophilizing treatment include sodium silicate, potassium silicate and lithium silicate. As for the hydroxide used for elevating the pH of the aqueous alkali metal silicate solution, examples thereof include sodium hydroxide, potassium hydroxide and lithium hydroxide. Also, an alkaline earth metal salt or a Group IVB metal salt may be blended in the treating solution. Examples of the alkaline earth metal salt include a water-soluble salt such as nitrate (e.g., calcium nitrate, strontium nitrate, magnesium nitrate, barium nitrate), sulfate, hydrochloride, phosphate, acetate, oxalate and borate. Examples of the Group IVB metal salt include titanium tetrachloride, titanium trichloride, potassium fluorotitanate, titanium potassium oxalate, titanium sulfate, titanium tetraiodide, zirconium chloride oxide, zirconium dioxide, zirconium oxychloride and zirconium tetrachloride.

One alkaline earth metal salt or Group IVB metal salt may be used alone, or two or more thereof may be used in combination. The amount of such a metal salt added is preferably from 0.01 to 10 mass%, more preferably from 0.05 to 5.0 mass%. Also, silicate electrodeposition described in U.S. Patent 3,658,662 is effective. Furthermore, a surface treatment comprising a combination of an electrolytically grained support disclosed in JP-B-46-27481, JP-A-52-58602 or JP-A-52-30503 with the above-described anodizing treatment and hydrophilizing treatment is also useful.

In the case where a support having insufficient surface hydrophilicity such as polyester film is used as the support of the present invention, a hydrophilic layer is preferably coated to render the surface hydrophilic. The hydrophilic

layer is preferably a hydrophilic layer formed by coating a coating solution containing a colloid of an oxide or hydroxide of at least one element selected from beryllium, magnesium, aluminum, silicon, titanium, boron, germanium, tin, zirconium, iron, vanadium, antimony and a transition metal described in JP-A-2001-199175, a hydrophilic layer having an organic hydrophilic matrix obtained by crosslinking or pseudo-crosslinking an organic hydrophilic polymer described in JP-A-2002-97772, a hydrophilic layer having an inorganic hydrophilic matrix obtained by sol-gel conversion comprising hydrolysis and condensation reaction of polyalkoxysilane, titanate, zirconate or aluminate, or a hydrophilic layer comprising an inorganic thin film having a surface containing a metal oxide. Among these, a hydrophilic layer formed by coating a coating solution containing a colloid of an oxide or hydroxide of silicon is preferred.

In the case where a polyester film or the like is used as the support of the present invention, an antistatic layer is preferably provided on the hydrophilic layer side of the support, on the opposite side, or on both sides. When an antistatic layer is provided between the support and the hydrophilic layer, the adhesion to the hydrophilic layer is also enhanced. As for the antistatic layer, for example, a polymer layer having dispersed therein a fine metal oxide particle or a matting agent described in JP-A-2002-79772 may be used.

The support preferably has a center line average roughness of 0.10 to 1.2 μm. Within this range, good adhesion to the photosensitive layer, good press life, and good antiscumming property are obtained.

The color density of the support is preferably from 0.15 to 0.65 in terms of the reflection density. Within this range, the halation at the image exposure is prevented, whereby good image-forming property and good suitability for plate inspection after development are obtained.

(Undercoat Layer)

In the lithographic printing plate precursor of the present invention, an undercoat layer comprising a compound having a polymerizable group is preferably provided on the support. In the case of using an undercoat layer, the photosensitive layer is provided on the undercoat layer. By virtue of providing an undercoat layer, in the exposed area, the adhesion between the support and the photosensitive layer is strengthened, whereas in the unexposed area, the photosensitive layer can be easily separated from the support and therefore, the developability is enhanced.

Specific suitable examples of the compound for the undercoat layer include a silane coupling agent having an addition-polymerizable ethylenic double bond reactive group described in JP-A-10-282679, and a phosphorus compound having an ethylenic double bond reactive group described in JP-A-2-304441. The compound is particularly preferably a compound having a polymerizable group such as methacryl group and allyl group, and a support-adsorptive group such as sulfonic acid group, phosphoric acid group and phosphoric acid ester group. A compound having a hydrophilicity-imparting group such as ethylene oxide group, in addition to a polymerizable group and a support-adsorptive group, is also preferred.

The coated amount (solid content) of the undercoat layer is preferably from 0.1 to 100 mg/$m^2$, more preferably from 1 to 30 mg/$m^2$.

Also, specific examples of the interlayer include those described in JP-B-50-7481, JP-A-54-72104, JP-A-59-101651, JP-A-60-149491, JP-A-60-232998, JP-A-3-56177, JP-A-4--282637, JP-A-5-16558, JP-A-5-246171, JP-A-7-159983, JP-A-7-314937, JP-A-8-202025, JP-A-8-320551, JP-A-9-34104, JP-A-9-236911, JP-A-9-269593, JP-A-10-69092, JP-A-10-115931, JP-A-10-161317, JP-A-10-260536, JP-A-10-282682, JP-A-11-84674, JP-A-11-38635, JP-A-11-38629, JP-A-10-282645, JP-A-10-301262, JP-A-11-24277, JP-A-11-109641, JP-A-10-319600, JP-A-11-84674, JP-A-11-327152, JP-A-2000-10292, JP-A-2000-235254, JP-A-2000-352824, JP-A-2001-209170 and JP-A-2001-175001.

[Backcoat Layer]

After a surface treatment is applied to the support or an undercoat layer is formed thereon, a backcoat layer may be provided on the back surface of the support, if desired.

Suitable examples of the backcoat layer include a coat layer comprising an organic polymer compound described in JP-A-5-45885 or comprising a metal oxide obtained by the hydrolysis and polycondensation of an organic or inorganic metal compound described in JP-A-6-35174. In particular, an alkoxy compound of silicon, such as $Si(OCH_3)_4$, $Si(OC_2H_5)_4$, $Si(OC_3H_7)_4$ and $Si(OC_4H_9)_4$, is preferably used, because the raw material is inexpensive and easily available.

[Production of Lithographic Printing Plate Precursor]

The lithographic printing plate precursor according to the present invention has a photosensitive layer on the support. Such a lithographic printing plate precursor can be produced by coating a coating composition for photosensitive layer, containing the above-described various components on the support.

At the time of providing the photosensitive layer by coating, the photosensitive composition is dissolved or

dispersed in an appropriate solvent (organic solvent, water) to prepare a coating solution for photosensitive layer, and the obtained coating solution is coated on the support or undercoat layer.

Examples of the solvent use here include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethylsulfoxide, γ-butyrolactone, methyl lactate and ethyl lactate. These solvents may be used individually or as a mixture thereof. The solid content concentration in the coating solution for the photosensitive layer is suitably from 2 to 50 mass%.

The coverage of the photosensitive layer affects mainly the sensitivity of photosensitive layer, the developability and the strength/press life of exposed film, and an appropriate coverage is preferably selected according to usage. If the coverage is too small, insufficient press life results, whereas if the coverage is excessively large, the sensitivity decreases and not only the exposure but also the development process disadvantageously take much time. In the case of a lithographic printing plate precursor for scanning exposure, the coverage is suitably from about 0.1 to about 10 $g/m^2$, preferably from 0.5 to 5 $g/m^2$, in terms of the mass after drying.

As for the coating method, various methods may be used and examples thereof include bar coater coating, rotary coating, spray coating, curtain coating, dip coating, air knife coating, blade coating and roll coating.

The properties of the photosensitive layer for use in the present invention are varied according to the embodiment of development process. For example, in an embodiment where the development process is performed by using an alkali developer, the development rate of the photosensitive layer in the unexposed area for an alkali developer at a pH of 10 to 13.5 is preferably 80 nm/sec or more and at the same time, the penetration rate of the alkali developer in the exposed area is preferably 50 nF/sec or less.

The methods for measuring the "development rate of the unexposed area for the alkali developer" and the "penetration rate of the alkali developer in the exposed area" employed in the present invention are described in detail below.

[Measurement of Development Rate of Unexposed Area for Alkali Developer]

The development rate of the unexposed area of the photosensitive layer for an alkali developer is a value obtained by dividing the thickness (nm) of the photosensitive layer by the time (sec) necessary for the development.

As for the method of measuring the development rate in the present invention, an aluminum support having provided thereon an unexposed photosensitive layer is immersed in an alkali developer (30°C) at a fixed pH in the range from 10 to 13.5, and the dissolution behavior of the photosensitive layer is examined by a DRM interference wave-measuring apparatus. A schematic view of the DRM interference wave-measuring apparatus for measuring the dissolution behavior of the photosensitive layer is shown. In the present invention, the change in the film thickness is detected by the interference using light at 640 nm. In the case where the development behavior is a non-swelling development from the photosensitive layer surface, the film thickness gradually decreases with respect to the development time and an interference wave according to the thickness is obtained. In the case of swelling dissolution (dissolution with removal of coating), the film thickness changes according to the penetration of the developer and therefore, an interface wave is not clearly obtained.

From the film thickness (nm) of the photosensitive layer and the time spent for the photosensitive layer to be completely removed and come to have a film thickness of 0 (development completion time) when the measurement is continued under those conditions, the development rate can be determined according to the following formula. As the development rate is larger, it is judged that the film is more easily removed by the developer and the developability is better.

$$\text{Development rate (of unexposed area)} = [\text{thickness (nm) of photosensitive layer/recording completion time (sec)}]$$

[Measurement of Penetration Rate of Alkali Developer in Exposed Area]

The penetration rate of the alkali developer in the exposed area is a value showing the rate of change in the electrostatic capacity (nF) when the above-described photosensitive layer is formed on an electrically conducting support and immersed in a developer.

The method for measuring the electrostatic capacity as an indication of penetration property in the present invention includes a method where an aluminum support after providing thereon a photosensitive layer through curing by exposure at a predetermined exposure amount is immersed in an alkali developer (28°C) at a fixed pH in the range of 10 to 13.5 to serve as one electrode and by connecting a conductor wire to the aluminum support and using a normal electrode as another electrode, a voltage is applied. After the voltage is applied, the developer penetrates into the interface between the support and the photosensitive layer with the elapse of the immersing time, and the electrostatic capacity changes.

From the time (sec) spent until the change in the electrostatic capacity becomes constant and the saturation value (nF) of the electrostatic capacity of the photosensitive layer, the penetration rate can be determined according to the following formula. As the penetration rate is smaller, it is judged that the penetration property of developer is lower.

**Developer penetration rate (of exposed area) = [saturation value (nF) of electrostatic capacity of photosensitive layer/time (sec) spent until change in electrostatic capacity becomes constant]**

As for the physical properties of the photosensitive layer in the lithographic printing plate precursor of the present invention, the development rate of the unexposed area by an alkali developer at a pH of 10 to 13.5 as measured as above is more preferably from 80 to 400 nm/sec, still more preferably from 90 to 200 nm/sec, and the penetration rate of the same alkali developer in the exposed area is more preferably from 0 to 50 nF/sec, still more preferably from 0 to 10 nF/sec.

The development rate of the unexposed area of the photosensitive layer and the penetration rate of the alkali developer into the cured photosensitive layer, namely, in the exposed area can be controlled by an ordinary method. Typically, addition of a hydrophilic compound is effective for elevating the development rate in the unexposed area, and addition of a hydrophobic compound is effective for suppressing the penetration of developer into the exposed area.

By using the above-described specific binder polymer, the development rate of the photosensitive layer and the penetration rate of the developer can be easily adjusted to respective preferred ranges.

On the other hand, in an embodiment where the development process in the production is performed by using a developer at a pH of 2 to 10 instead of the alkali developer described above, the physical property of the photosensitive layer measured by using a developer at a pH of 2 to 10 preferably falls into the similar range (the development rate in the unexposed area is 80 nm/sec or more and at the same time, the penetration rate of the alkali developer in the exposed area is preferably 50 nF/sec or less.).

[Protective Layer]

The photosensitive layer of the lithographic printing plate precursor according to the present invention is a polymerizable negative-working photosensitive layer as described above and for performing the exposure in the air, a protective layer (also called an "overcoat layer") is preferably provided on the photosensitive layer. The protective layer prevents a low molecular compound such as oxygen and basic substance present in the air, which inhibits the image forming reaction generated upon exposure in the photosensitive layer, from mingling into the photosensitive layer and enables exposure in the air. Accordingly, the property required of the protective layer is to exhibit low permeability to a low molecular compound such as oxygen. The protective layer for use in the present invention preferably has an oxygen permeability A of $1.0 \leq A \leq 20$ (mL/m$^2$·day) at 25°C under 1 atm. If the oxygen permeability A is less than 1.0 (mL/m$^2$·day) and extremely low, there arises a problem such that an unnecessary polymerization reaction occurs during production·stock storage or unnecessary fogging or thickening of image line may be generated at the image exposure, whereas if the oxygen permeability A exceeds 20 (mL/m$^2$.day) and is too high, this causes the reduction of sensitivity. The oxygen permeability A is more preferably $1.5 \leq A \leq 12$ (mL/m$^2$-day), still more preferably $2.0 \leq S \leq 10.0$ (mL/m$^2$·day). As for the property required of the protective layer, other than such an oxygen permeability, it is preferred that the protective layer does not substantially disturb the transmission of light used for exposure, exhibits excellent adhesion to the photosensitive layer and is easily removable in the development step after exposure. Various studies have been heretofore made on such a protective layer and are described in detail, for example, in U.S. patent 3,458,311 and JP-B-55-49729. As for the material which can be used for the protective layer, for example, a water-soluble polymer compound having relatively excellent crystallinity is preferably used. Specific known examples thereof include a water-soluble polymer such as polyvinyl alcohol, a vinyl alcohol/vinyl phthalate copolymer, a vinyl acetate/vinyl alcohol/vinyl phthalate copolymer, a vinyl acetate/crotonic acid copolymer, polyvinylpyrrolidone, acidic celluloses, gelatin, gum arabic, polyacrylic acid and polyacrylamide. These compounds may be used individually or as a mixture. Among these, when a polyvinyl alcohol is used as the main component, most excellent results are obtained with respect to basic properties such as oxygen-blocking property and development removability.

The polyvinyl alcohol used for the protective layer may be partially substituted by an ester, an ether or an acetal or may partially have another copolymerization component as long as it contains an unsubstituted vinyl alcohol unit for giving required oxygen-blocking property and water solubility to the protective layer. Examples of the polyvinyl alcohol include those having a hydrolysis degree of 71 to 100% and a polymerization degree of 300 to 2,400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-Z17E, PVA-220E, PVA-224E, PVA-405, PVA-420, PVA-613 and L-8 produced by Kuraray Co., Ltd. These may be used individually or as a mixture. In a preferred embodiment, the polyvinyl alcohol content in the protective layer is from 20 to 95 mass%, more preferably from 30 to 90 mass%.

Also, a known modified polyvinyl alcohol may be preferably used. Examples thereof include a polyvinyl alcohol having various polymerization degrees and randomly having various hydrophilic modified moieties such as anion-modified moiety modified by an anion (e.g., carboxyl, sulfo), cation-modified moiety modified by a cation (e.g., amino, ammonium), silanol-modified moiety and thiol-modified moiety; and a polyvinyl alcohol having various polymerization degrees and having various modified moieties at the polymer chain terminal, such as anion-modified moiety described above, cation-modified moiety described above, silanol-modified moiety, thiol-modified moiety, alkoxyl-modified moiety, sulfide-modified moiety, ester-modified moiety modified by an ester of vinyl alcohol and various organic acids, ester-modified moiety modified by an ester of anion-modified moiety described above and alcohols or the like, and epoxy modified moiety.

The component used by mixing it with the polyvinyl alcohol is preferably polyvinylpyrrolidone or a modified product thereof in view of oxygen-blocking property and development removability, and the content thereof in the protective layer is from 3.5 to 80 mass%, preferably from 10 to 60 mass%, more preferably from 15 to 30 mass%.

The components (for example, selection of PVA and use of additives), coated amount and the like of the protective layer are selected by taking account of fogging, adhesion, scratch resistance and the like in addition to the oxygen-blocking property and development removability. In general, as the PVA has a higher percentage of hydrolysis (namely, as the unsubstituted vinyl alcohol unit content in the protective layer is higher) or as the film thickness is larger, the oxygen-blocking property is more enhanced and this is advantageous in view of sensitivity. However, if the oxygen-blocking property is excessively intensified, unnecessary polymerization reaction may occur during production or stock storage or there may arise a problem that unnecessary fogging or thickening or the like of the image line is caused at the image exposure. The adhesion to the image area and scratch resistance of the protective layer are also very important in view of handling of the plate. More specifically, when a hydrophilic layer comprising a water-soluble polymer is stacked on the photosensitive layer, film separation readily occurs due to insufficient adhesive strength and in the separated portion, defects such as curing failure ascribable to polymerization inhibition by oxygen may be caused. In order to solve this problem, various proposals have been made with an attempt to improve the adhesive property between these two layers. For example, U.S. Patent Application Nos. 292,501 and 44,563 describe a technique of mixing from 20 to 60 mass% of an acrylic emulsion, a water-insoluble vinylpyrrolidone-vinyl acetate copolymer or the like in a hydrophilic polymer mainly comprising polyvinyl alcohol and stacking the resulting solution on the photosensitive layer, thereby obtaining sufficiently high adhesive property.

These known techniques all can be applied to the protective layer of the present invention. The coating method for the protective layer is described in detail, for example, in U.S. Patent 3,458,311 and JP-B-55-49729.

Accordingly, in the light of adhesive strength, sensitivity and unnecessary fogging, a polyvinyl alcohol and a polyvinylpyrrolidone are preferably used in combination. The ratio (by mass) of amounts added is preferably 3/1 or more as polyvinyl alcohol/polyvinyl-pyrrolidone, and the coated weight is preferably from 1.0 to 3.0 g/m$^2$.

As for other examples of the composition of the protective layer, glycerin, dipropylene glycol or the like may be added in an amount corresponding to several mass% based on the (co)polymer, and an anionic surfactant such as sodium alkylsulfate and sodium alkylsulfonate; an amphoteric surfactant such as alkylaminocarboxylate and alkylaminodicarboxylate; or a nonionic surfactant such as polyoxyethylene alkylphenyl ether, may be added in an amount of several mass% based on the (co)polymer.

Furthermore, the adhesive property to the image area and the scratch resistance are also very important in view of handling of the plate. More specifically, when a hydrophilic layer comprising a water-soluble polymer is laminated on a lipophilic photosensitive layer, separation of layers readily occurs due to insufficient adhesive strength and in the separated portion, defects such as film curing failure ascribable to polymerization inhibition by oxygen may be caused. To overcome such a problem, various proposals have been made with an attempt to improve the adhesive property between those two layers. For example, U.S. Patent Application Nos. 292,501 and 44,563 describe a technique of mixing from 20 to 60 mass% of an acrylic emulsion, a water-insoluble vinylpyrrolidone-vinyl acetate copolymer or the like in a hydrophilic polymer mainly comprising polyvinyl alcohol and laminating the resulting solution on the photosensitive layer, thereby obtaining sufficiently high adhesive property. These known techniques all can be applied to the protective layer of the present invention. The coating method for such a protective layer is described in detail, for example, in U.S. Patent 3,458,311 and JP-B-55-49729.

Furthermore, it is also preferred for the purpose of enhancing the oxygen-blocking property or photosensitive layer surface-protecting property to incorporate an inorganic layered compound into the protective layer of the lithographic printing plate precursor of the present invention.

The inorganic layered compound as used herein is a particle having a thin plate-like shape, and examples thereof include a mica family represented by the formula:

$$A(B,C)_{2-5}D_4O_{10}(OH,F,O)_2$$

[wherein A is any one of K, Na and Ca, B and C each is any one of Fe(II), Fe(III), Mn, Al, Mg and V, and D is Si or Al], such as natural mica and synthetic mica; talc represented by the formula: $3MgO \cdot 4SiO \cdot H_2O$; taeniolite; montmorillonite; saponite; hectorite; and zirconium phosphate.

In the mica family, examples of the natural mica include muscovite, paragonite, phlogopite, biotite and lepidolite, and examples of the synthetic mica include a non-swelling mica such as fluorophlogopite $KMg_3(AlSi_3O_{10})F_2$ and potassium tetrasilicic mica $KMg_{2.5}(Si_4O_{10})F_2$, and a swelling mica such as Na tetrasilicic mica $NaMg_{2.5}(Si_4O_{10})F_2$, Na or Li taeniolite $(Na,Li)Mg_2Li(Si_4O_{10})F_2$ and montmorillonite-based Na or Li hectorite $(Na,Li)_{1/8}Mg_{2/5}Li_{1/8}(Si_4O_{10})F_2$. Furthermore, synthetic smectite is also useful.

Among these inorganic layered compounds, a fluorine-based swelling mica which is a synthetic inorganic layered compound, is preferred in the present invention. More specifically, this swelling synthetic mica and swelling clay minerals such as montmorillonite, saponite, hectorite and bentonite have a laminate structure comprising a unit crystal lattice layer having a thickness of approximately from 10 to 15 Å, and the degree of metal atom substitution in the lattice is significantly higher than that of other clay minerals. As a result, a shortage of positive charge arises in the lattice layer and in order to compensate for the shortage, a cation such as $Na^+$, $Ca^{2+}$ and $Mg^{2+}$ is adsorbed between layers. This cation intervening between layers is called an exchangeable cation and can be exchanged with various cations. Particularly, in the case where the interlayer cation is $Li^+$ or $Na^+$, the ionic radius is small and therefore, the bond between layered crystal lattices is weak to allow for great swelling with water. When shearing is applied in this state, the bond is readily cleaved, and a sol which is stable in water is formed. The bentonite and swelling synthetic mica strongly show this tendency and are useful in the present invention. In particular, a swelling synthetic mica is preferred.

With respect to the profile of the inorganic layered compound for use in the present invention, from the standpoint of controlling the diffusion, the thickness is preferably smaller and as long as the smoothness of the coated surface or the transparency to actinic rays is not impaired, the plane size is preferably larger. Accordingly, the aspect ratio is 20 or more, preferably 100 or more, more preferably 200 or more. Incidentally, the aspect ratio is a ratio of thickness to long diameter of a particle and can be measured, for example, from a projection view by a microphotograph of particles. As the aspect ratio is larger, the effect obtained is higher.

With respect to the particle diameter of the inorganic layered compound for use in the present invention, the average long diameter is from 0.3 to 20 μm, preferably from 0.5 to 10 μm, more preferably from 1 to 5 μm. The average thickness of the particle is 0.1 μm or less, preferably 0.05 μm or less, more preferably 0.01 μm or less. For example, the swelling synthetic mica as a representative compound of the inorganic layered compound has a thickness of 1 to 50 nm and a plane size of approximately from 1 to 20 μm.

When an inorganic layered compound particle having such a large aspect ratio is incorporated into the protective layer, the coating film strength is enhanced and the permeation of oxygen or free water is effectively prevented, so that the protective layer can be prevented from deterioration due to deformation or the like and even when the lithographic printing plate precursor is stored for a long time under a high-humidity condition, good storage stability can be ensured without causing reduction of the image-forming property due to change in the humidity.

The content of the inorganic layered compound in the protective layer is preferably from 5/1 to 1/100 in terms of the mass ratio to the amount of the binder used in the protective layer. Also in the case of using a plurality of kinds of inorganic layered compounds in combination, the total amount of these inorganic layered compounds is preferably at the above-described mass ratio.

An example of the method generally employed for dispersing the inorganic layered compound for use in the protective layer is described below. First, from 5 to 10 parts by mass of a swelling layered compound described above as a preferred inorganic layered compound is added to 100 parts by mass of water and after being well wetted and swelled with water, dispersed by using a disperser. Examples of the disperser used here include various mills of effecting dispersion by directly applying a mechanical force, a high-speed stirring-type disperser having a large shearing force, and a disperser of giving a high-intensity ultrasonic energy. Specific examples thereof include a ball mill, a sand grinder mill, a visco-mill, a colloid mill, a homogenizer, a dissolver, a polytron, a homomixer, a homoblender, a KD mill, a jet agitator, a capillary-type emulsifier, a liquid siren, an electromagnetic strain-type ultrasonic generator, and an emulsifier with Paulman whistle. A dispersion containing from 5 to 10 mass% of the inorganic layered compound dispersed by the above-described method is in a highly viscous or gelled state, and its storage stability is remarkably good. At the time of preparing a coating solution for protective layer by using this dispersion, the dispersion is preferably diluted with water,

thoroughly stirred and blended with a binder solution.

Other than this inorganic layered compound, a surfactant for enhancing the coatability or a known additive such as water-soluble plasticizer for improving film properties, may be added to the coating solution for protective layer. Examples of the water-soluble plasticizer include propionamide, cyclohexanediol, glycerin and sorbitol. Also, a water-soluble (meth)acrylic polymer may be added. Furthermore, in this coating solution, known additives for enhancing the adhesive property to photosensitive layer or the aging stability of coating solution may be added.

The coating solution for protective layer prepared in this way is coated on the photosensitive layer provided on the support and dried to form a protective layer. The coating solvent may be appropriately selected in relation to the binder but in the case of using a water-soluble polymer, distilled water or purified water is preferably used. The coating method of the protective layer is not particularly limited, and a known method described, for example, in U.S. Patent 3,458,311 and JP-B-55-49729 may be applied. Specific examples of the coating method for the protective layer include a blade coating method, an air knife coating method, a gravure coating method, a roll coating method, a spray coating method, a dip coating method and a bar coating method.

The coated amount of the protective layer is, in terms of the coated amount after drying, preferably from 0.05 to 10 $g/m^2$, more preferably from 0.1 to 0.5 $g/m^2$ in the case of containing an inorganic layered compound, or from 0.5 to 5 $g/m^2$ in the case of not containing an inorganic layered compound.

<Plate-Making Method>

The plate-making method of a lithographic printing plate precursor of the present invention is described below.

The plate-making method of a lithographic printing plate precursor of the present invention is a plate-making method comprising exposing a lithographic printing plate precursor described above by using an inner drum exposure apparatus having mounted thereon a light source having an oscillation wavelength in the range from 360 to 450 nm, wherein the light source of the exposure apparatus emits a light beam of producing a light beam spot shape such that a light beam is divided in parallel into an ordinary ray and an extraordinary ray at an equivalent light quantity and two beam spots are adjacently arrayed in the sub-scanning direction to partially overlap, and the lithographic printing plate precursor is loaded on the inner drum exposure apparatus and then subjected to image recording by exposure having the light beam spot shape.

[Exposure]

The inner drum exposure apparatus for use in the present invention is described below.

In the inner drum exposure apparatus for use in the present invention, the light source of the exposure apparatus emits a light beam of producing a light beam spot shape such that a light beam is divided in parallel into an ordinary ray and an extraordinary ray at an equivalent light quantity and two beam spots are adjacently arrayed in the sub-scanning direction to partially overlap.

More specifically, this is an inner drum exposure apparatus of recording an image by deflecting a light beam modulated according to the image information on a reflecting mirror surface of scanning means and scanning the light beam on a recording medium (lithographic printing plate precursor) held on an arc-like inner circumferential surface formed on a drum support (see Fig. 1), wherein the exposure apparatus comprises a light source of emitting a light beam, a 1/4 wavelength plate disposed between the light source and the scanning means and capable of converting a linearly polarized light beam emitted from the light source into circularly polarized light, and an optical device of uniaxial crystal disposed between the 1/4 wavelength plate and the reflecting mirror surface while arranging the surface for injecting/ejecting a light beam to the reflecting mirror surface and the crystal optical axis to run nearly in parallel and mounted to rotate and move integrally with the reflecting mirror surface for producing a beam spot shape such that a light beam is divided in parallel into an ordinary ray and an extraordinary ray at an equivalent light quantity and two beam spots are adjacently arrayed in the sub-scanning direction to partially overlap.

In the inner drum exposure apparatus constituted as above, a light beam emitted from the light source as nearly linearly polarized light is converted into circularly polarized light on penetrating the 1/4 wavelength plate 32 disposed on the light path. The light beam converted into the circularly polarized light is beam-split into an ordinary ray and an extraordinary ray on penetrating the optical device of uniaxial crystal. These beam-split ordinary ray and extraordinary ray are beam-split at the same intensity, for example, in the sub-scanning direction. The ordinary ray and the extraordinary ray beam-split at an equivalent intensity in the sub-scanning direction are reflected on the reflecting mirror surface and collected to a condensing point on the recording medium, for example, a beam spot forming a nearly rectangular distribution with respect to the sub-scanning direction and having a steep edge part. In this inner drum exposure apparatus, the exposure process is performed while constantly maintaining the condition that the beam spot forming a nearly rectangular distribution and having a steep edge part after beam splitting is producing, for example, a long and thin beam spot shape in the sub-scanning direction (that is, the longitudinal direction of the nearly rectangular distribution of the

beam spot runs along the sub-scanning direction (direction orthogonal to the main scanning direction)). Accordingly, the intensity distribution of the beam spot on the recording medium comes to have a nearly rectangular form in the sub-scanning direction and the edge on both sides of the condensing point becomes sharp, so that the exposure can be almost free of the effect of fluctuation in the coloration threshold of recording medium, fluctuation in the laser beam intensity or the like, and the image unevenness with respect to the sub-scanning direction can be suitably suppressed. Therefore, the image obtained by recording an FM screen causes no fluctuation in the peripheral length of the recorded picture element due to, for example, recording conditions such as light power variation or number of printed sheets or development conditions such as development degree of the automatic developing machine, is prevented from abrupt change in the percentage of a halftone image (dot area percentage characteristics) and less fluctuates in the density, and the image can be stably recorded to express the middle tone by using an FM screen.

As for the inner drum exposure apparatus, the exposure may also be performed by using an inner drum exposure apparatus of recording an image by deflecting a light beam modulated according to the image information on a rotation-driven reflecting mirror surface of scanning means and scanning the light beam on a recording medium held on the arc-like inner circumferential surface, wherein the exposure apparatus comprises randomly polarizing means for injecting a randomly polarized light beam to the reflecting mirror surface of scanning means, and an optical device of uniaxial crystal disposed while arranging the surface for injecting/ejecting a randomly polarized light beam to the reflecting mirror surface and the plane containing the crystal optical axis and the normal line to become the same surface and mounted to rotate and move integrally with the reflecting mirror surface for producing a beam spot shape such that a light beam is beam-split into an ordinary ray and an extraordinary ray at an equivalent light quantity and these light rays are parallel-shifted with each other to cause two beam spots to be adjacently arrayed in the sub-scanning direction while partially overlapping.

In the inner drum exposure apparatus constituted as above, a light beam randomly polarized by the randomly polarizing means is beam-split into an ordinary ray and an extraordinary ray on penetrating the optical device of uniaxial crystal. These beam-split ordinary ray and extraordinary ray are beam-split at the same intensity, for example, in the sub-scanning direction. The ordinary ray and the extraordinary ray beam-split at an equivalent intensity in the sub-scanning direction are reflected on the reflecting mirror surface and collected to a condensing point on the recording medium, for example, a beam spot forming a nearly rectangular distribution thinly and long extending with respect to the sub-scanning direction and having a steep edge part. In this inner drum exposure apparatus, the exposure process is performed while constantly maintaining the condition that beam spot forming a nearly rectangular distribution and having a steep edge part after beam splitting is producing, for example, a long and thin beam spot shape in the sub-scanning direction (that is, the longitudinal direction of the nearly rectangular distribution of the beam spot runs along the sub-scanning direction (direction orthogonal to the main scanning direction)). Accordingly, the intensity distribution of the beam spot on the recording medium comes to have a nearly rectangular form in the sub-scanning direction and the edge on both sides of the condensing point becomes sharp, so that the exposure can be almost free of the effect of fluctuation in the coloration threshold of recording medium, fluctuation in the laser beam intensity or the like, and the image unevenness with respect to the sub-scanning direction can be suitably suppressed. Therefore, the image obtained by recording an FM screen causes no fluctuation in the peripheral length of the recorded picture element due to, for example, recording conditions such as light power variation or number of printed sheets or development conditions such as development degree of the automatic developing machine, is prevented from abrupt change in the percentage of a halftone image (dot area percentage characteristics) and less fluctuates in the density, and the image can be stably recorded to express the middle tone by using an FM screen.

As for the inner drum exposure apparatus, the exposure may also be performed by using an inner drum exposure apparatus of recording an image by holding a recording medium on an arc-like inner circumferential surface formed on a drum support, deflecting a plurality of light beams modulated according to the image information, and scanning the light beams on the recording medium held in the arc-like state, wherein the exposure apparatus comprises light beam outputting means of emitting a plurality of light beams, scanning means having a reflecting mirror surface with the rotation axis assigned to the center axis of the arc-like inner circumferential surface of the drum support and scanning the light beams on the recording medium by reflecting the plurality of light beams on the rotating reflecting mirror surface, light deflecting means of relatively and two-dimensionally deflecting the light beam in a plane orthogonal to the rotation axis of the scanning means to cause displacement of the main scanning direction and the sub-scanning direction on the recording medium, control means of synchronizing the displacement position of the light beam on the recording medium caused by the light deflecting means with the rotation of the reflecting mirror surface and thereby controlling the displacement position, a 1/4 wavelength plate disposed on the light path between the light beam outputting means and the scanning means and capable of converting the plurality of linearly polarized light beams emitted from the light beam outputting means each into circularly polarized light, and an optical device of uniaxial crystal disposed between the 1/4 wavelength plate and the reflecting mirror surface while arranging the surface for injecting/ejecting a light beam to the reflecting mirror surface and a plane containing the crystal optical axis and the normal line to become the same surface and mounted to rotate and move integrally with the reflecting mirror surface for producing a beam spot shape such that

the plurality of light beams each is divided into an ordinary ray and an extraordinary ray at an equivalent light quantity and two beam spots are adjacently arrayed in the sub-scanning direction to partially overlap.

By having a constitution as above, the control means synchronizes the displacement position of the light beam on a recording medium caused by the light deflecting means with the rotation of the reflecting mirror surface and thereby controls the displacement position, so that the plurality of light beams emitted from the light beam outputting means can be scanned on a recording medium while relatively and two-dimensionally deflecting a required number of light beams by the light deflecting means in a plane orthogonal to the rotation axis of the scanning means to cause displacement of the main scanning direction and the sub-scanning direction. At this time, the plurality of light beams emitted from the light beam outputting means as nearly linearly polarized light each is converted into circularly polarized light on passing through the 1/4 wavelength plate disposed on the light path leading to the light deflecting means. The plurality of light beams converted into the circularly polarized light each is beam-split into an ordinary ray and an extraordinary ray on penetrating the optical device of uniaxial crystal. These beam-split ordinary ray and extraordinary ray are beam-split at the same intensity, for example, in the sub-scanning direction. The ordinary ray and the extraordinary ray beam-split at an equivalent intensity in the sub-scanning direction are each reflected on the reflecting mirror surface and collected to respective condensing points on the recording medium, for example, beam spots forming a nearly rectangular distribution with respect to the sub-scanning direction and having steep edge parts. In this inner drum exposure apparatus, the exposure process is performed while constantly maintaining the condition that a plurality of beam spots forming a nearly rectangular distribution and having a steep edge part after beam splitting each is producing, for example, a long and thin beam spot shape in the sub-scanning direction (that is, the longitudinal direction of the nearly rectangular distribution of the beam spot runs along the sub-scanning direction (direction orthogonal to the main scanning direction)). Accordingly, the intensity distribution of each beam spot on the recording medium comes to have a nearly rectangular form in the sub-scanning direction and the edge on both sides of the condensing point becomes sharp, so that the exposure can be almost free of the effect of fluctuation in the coloration threshold of recording medium, fluctuation in the laser beam intensity or the like, and the image unevenness with respect to the sub-scanning direction can be suitably suppressed. Therefore, the image obtained by recording an FM screen causes no fluctuation in the peripheral length of the recorded picture element due to, for example, recording conditions such as light power variation or number of printed sheets or development conditions such as development degree of the automatic developing machine, is prevented from abrupt change in the percentage of a halftone image (dot area percentage characteristics) and less fluctuates in the density, and the image can be stably recorded to express the middle tone by using an FM screen.

In the exposure apparatus for use in the present invention, a light source having an oscillation wavelength in the range of 360 to 450 nm, particularly, a 405-nm laser commercially available, for example, from Nichia Corp., is preferred.

By using the above-described inner drum exposure apparatus and simultaneously recording an image with a plurality of light beams emitted from the light beam outputting means, a high-precision image can be recorded at a high speed.

Furthermore, use of the above-described inner drum exposure apparatus also provides an effect that the image recording can be performed by an FM screen at the exposure and a midtone expression can be stably recorded by utilizing an FM screen.

The inner drum exposure apparatus for use in the present invention and the exposure method using the exposure apparatus are specifically described below by referring to the drawings, but the present invention is not limited thereto.

A first embodiment of the inner drum exposure apparatus is described by referring to Figs. 1 to 5. The inner drum exposure apparatus according to this first embodiment is constituted to enable stable midtone recording by using an FM screen. When the peripheral length of the recorded picture element is changed even a little depending on, for example, the recording conditions such as light power variation or number of printed sheets or development conditions such as development degree of the automatic developing machine, the percentage of a halftone image (dot area percentage characteristics) is liable to abruptly change and the density readily fluctuates. In order to prevent such a trouble, the inner drum exposure apparatus of this embodiment takes a measure of producing a rectangular recording spot shape in the sub-scanning direction and at the same time, making the spot diameter in the main scanning direction to be smaller than the recorded picture element.

As shown in the schematic structural view of Fig. 1, the inner drum exposure apparatus 10 is based on a drum support 12 having an arced inner circumferential surface shape (a shape constituting a part of a cylindrical inner circumferential surface), and a recording medium 14 (for example, lithographic printing plate precursor) is supported along the inner circumferential surface of this drum support.

Incidentally, in this inner drum exposure apparatus 10, an operation of feeding an unrecorded recording medium 14 by a feed/discharge unit (not shown) for a recording medium 14, anchoring the recording medium in the state of unfailingly contacting with and following the inner circumferential surface of the drum support 12, performing the exposure process, and discharging the exposed recording medium 14 outside from the drum support 12, is implemented.

In this inner drum exposure apparatus 10, a spinner mirror unit 16 as scanning means is provided in the arc center position of the drum support 12. The spinner mirror unit 16 comprises a columnar rotation axis 18 and is fabricated to be rotatable around and movable along the center axis (coinciding with the arc center axis of the drum support 12) of the rotation axis by a motor 20 as the driving source. At the end part of the rotation axis 18 of this spinner mirror unit 16, a reflecting mirror surface 18A making an angle of 45° with respect to the rotation axis is formed.

The spinner mirror unit 16 as the scanning means is moved for scanning at a uniform rate in the axis line direction (in Fig. 1, the transverse direction shown by the arrow C direction) of the arc center axis of the drum support 12 by sub-scanning moving means (not shown). In this spinner mirror unit 16, the rotation of the motor 20 is controlled by a spinner driver 22, and the moving in the sub-scanning direction is controlled by sub-scanning moving means (not shown).

Furthermore, the inner drum exposure apparatus 10 is constituted such that main scanning on the recording surface of a recording medium 14 disposed on the inner circumferential surface of the drum support 12 is performed through beam splitting.

Therefore, on the spinner mirror unit 16 side, an optical device 26 of uniaxial crystal is disposed by a holder 24 fixed to be rotatable and movable integrally with the rotation axis 18. The holder 24 has, for example, a cylindrical shape and is produced by perforating a through hole 24 (shown in Fig. 2) for passing a light beam reflected on the reflecting mirror surface 18A to the recording medium 14 side.

The optical device 26 of uniaxial crystal may also be disposed on the light path between a condenser lens 28 on the light source side and the reflecting mirror surface 18A of the spinner mirror unit 16, and mounted and constituted to rotate and move integrally with the reflecting mirror surface 18A by supporting means. Incidentally, this inner drum exposure apparatus 10 may be variously constituted by using, for example, an optical device 26 of uniaxial crystal capable of parallel-dividing a light beam by beam displaying prism.

For example, as shown in Fig. 2, an optical device 26 of uniaxial crystal where the crystal optical axis of the beam displaying prism is inclined at 45° with respect to the normal line of the incident surface, is used.

When a circularly polarized light beam (may be a randomly polarized light beam modulated based on an image signal by randomly polarizing means (not shown)) is made incident on the optical device 26 of uniaxial crystal, as shown in Fig. 3, the light beam undergoes beam splitting into an ordinary ray Po and an extraordinary ray Pe at an equivalent light quantity. In this case, the ordinary ray Po and the extraordinary ray Pe are parallel-shifted with each other. For example, in the case of obtaining a shift amount (split width) of 5.5 $\mu$m at a light wavelength of 405 nm by this optical device 26 of uniaxial crystal, this may be attained by using a rock crystal as the material for the optical device 26 of uniaxial crystal and setting the thickness thereof to about 0.904 mm. The rock crystal used as the material of the optical device 26 of uniaxial crystal is advantageously a stable and inexpensive material and applicable even to a size where the diameter of a circle is 30 mm.

In the case of producing a beam spot shape such that a light beam is beam-split into an ordinary ray Po and an extraordinary ray Pe at an equivalent light quantity and parallel-shifted with each other (this may also be an angle dividing system) to overlap two beam spots (in the case of forming a beam spot by beam splitting), for example, as shown in Fig. 4, two Gauss beams with a half-value width of 5 $\mu$m are overlapped by the shifting of 5.5 $\mu$m (beam-split state), as a result, a shape nearly rectangular with respect to the sub-scanning direction and at the same time, sharp with respect to the main scanning direction (a beam spot having a steep edge part) is produced.

When compared with Comparative Example of Fig. 5 showing a conventional Gauss-distributed beam spot shape where the half-value width is 8.8 $\mu$m ($l/e^2$ width: 15 $\mu$m), the conventional Gauss-distributed beam spot shape is a circular transverse cross-sectional shape and does not extend in the sub-scanning direction and moreover, the beam spot shape is gradually broadened toward the end and in turn becomes gentle with respect to the main scanning direction (a beam spot having a gentle edge part). Thus, the difference in the effect is apparent.

As shown in Fig. 3, this inner drum exposure apparatus 10 is constituted such that the optical device 26 of uniaxial crystal is disposed while arranging the surface for injecting/ejecting a light beam to the reflecting mirror surface 18A of the spinner mirror unit 16 and the plane containing the crystal optical axis and the normal line in the optical device 26 of uniaxial crystal to become the same surface and thereby two beam spots are overlapped in the sub-scanning direction (two beam spots are adjacently arrayed in the sub-scanning direction to partially overlap).

As shown in Fig. 1, in this inner drum exposure apparatus 10, an optical system of projecting a light beam or a randomly polarized light beam to the spinner mirror unit 16 side for performing main scanning on the recording surface of a recording medium 14 through beam splitting is provided on the light source side.

The optical system on the light source side comprises a semiconductor laser light source (LD) 30 of outputting a laser beam L comprising nearly linearly polarized light, and a condensing optical system of condensing a laser beam L emitted from the semiconductor laser light source 30 on the exposure surface of a recording medium 14. For this semiconductor laser light source 30, a single transverse-mode semiconductor laser having a high center light intensity and having an intensity distribution that the light intensity gradually decreases with distance from the center, can be used.

The optical system on the light source side is constituted by arranging a 1/4 wavelength plate 32, a reflecting

mirror 34, a reflecting mirror 36 and a condenser lens 28 in this order from the semiconductor laser light source 30 side.

As for the 1/4 wavelength plate 32, a laser beam L comprising linearly polarized light emitted from the semiconductor laser light source 30 is converted into circularly polarized light by penetrating the 1/4 wavelength plate 32. The laser beam L converted into circularly polarized light is condensed by the condenser lens 28 and penetrates the optical device 26 of uniaxial crystal, and the circularly polarized laser beam L is thereby beam-split at an equivalent light quantity. The split light beams are parallel-shifted with each other to allow for overlapping of two beam spots in the sub-scanning direction, injected to the direction of making the direction after beam-splitting at an equivalent light quantity and parallel-shifting with each other to be parallel to a predetermined injection/reflection surface in the reflecting mirror surface 18A of the spinner mirror unit 16, reflected on the reflecting mirror surface 18A, and condensed to a condensing point on a recording medium 14 placed on the inner circumferential surface of the drum support 12, thereby effecting irradiation. In this way, the exposure process is performed.

Incidentally, in the case where the semiconductor laser light source 30 emits a circularly polarized or randomly polarized laser beam L, the optical system on the light source side does not use a 1/4 wavelength plate 32.

As shown in Fig. 1, in the inner drum exposure apparatus 10, the operation of recording an image on a recording medium 14 is performed while controlling the spinner mirror unit 16 and the semiconductor laser light source 30 by a central control unit 40. In this inner drum exposure apparatus 10, when image information to be exposed is input from an inputting unit (not shown) and a command to start the exposure process is sent to the central control unit 40, the central control unit 40 generates an image signal based on the image information to be exposed and sends this image signal to a laser driver 42. The laser driver 42 then causes emission of a laser beam L modulated based on the image signal by controlling the drive of the semiconductor laser light source 30, and the laser beam is irradiated to the spinner mirror unit 16 side by the optical system on the light source side.

At the same time, the central control unit 40 rotates the reflection mirror surface 18A by controlling the rotation of the motor 20 to reflect the laser beam L made incident on the reflecting mirror surface 18A from the optical system on the light source side and perform the scanning exposure of a recording medium 14 in the main scanning direction, and also sends a control signal to the spinner driver 22. The spinner driver 22 after receiving the control signal causes the spinner mirror unit 16 to move for scanning at a uniform rate in the axis line direction (in Fig. 1, the transverse direction shown by the arrow C direction) of the arc center axis of the support 12 by controlling the sub-scanning moving means (not shown). In this way, the spinner mirror unit 16 is moved in the sub-scanning direction while performing scanning exposure in the main scanning direction by the spinner mirror unit 16, whereby the processing of recording a two-dimensional image on the entire recording surface of a recording medium 14 is performed.

The mode and operation of the inner drum exposure apparatus according to this first embodiment are described below.

In this inner drum exposure apparatus 10, the laser beam L modulated according to the image information and outputted from the semiconductor laser light source 30 which is controlled by the central control unit 40 and the laser driver 42, enters the 1/4 wavelength plate 32. The laser beam L entered the 1/4 wavelength plate 32 as nearly linearly polarized light is converted into circularly polarized light, reflected on the reflecting mirrors 34 and 36, condensed by the condenser lens 28, and injected into the optical device 26 of uniaxial crystal. The circularly polarized laser beam L is beam-split into an ordinary ray Po and an extraordinary ray Pe on penetrating the optical device 26 of uniaxial crystal. The refraction angle of the extraordinary ray Pe can be arbitrarily adjusted by the thickness of the optical device of uniaxial crystal 26 with respect to the optical axis direction or the construction material thereof. The optical device 26 of uniaxial crystal is set such that the ordinary ray Po and the extraordinary ray Pe beam-split in the sub-scanning direction have the same intensity.

The ordinary ray Po and the extraordinary ray Pe beam-split in the sub-scanning direction by the optical device 26 of uniaxial crystal and adjusted in intensity are reflected on the reflecting mirror surface 18A and collected to a condensing point on a recording medium 14 by forming a nearly rectangular distribution with respect to the sub-scanning direction. More specifically, in this inner drum exposure apparatus 10, the exposure process is performed while constantly maintaining the condition that the beam spot forming a nearly rectangular distribution and having a steep edge part after beam splitting is thinly elongated in the sub-scanning direction (that is, the longitudinal direction of the nearly rectangular distribution of the beam spot runs along the sub-scanning direction (direction orthogonal to the main scanning direction)). Therefore, the image obtained by recording an FM screen causes no fluctuation in the peripheral length of the recorded picture element due to, for example, recording conditions such as light power variation or number of printed sheets or development conditions such as development degree of the automatic developing machine, is prevented from abrupt change in the percentage of a halftone image (dot area percentage characteristics) and less fluctuates in the density, and the image can be stably recorded to express the middle tone by using an FM screen.

A second embodiment of the inner drum exposure apparatus is described below by referring to Figs. 6 to 9. The principle of the inner drum exposure apparatus according to the second embodiment is described below by referring to Figs. 7A to 7C and Figs. 8A and 8B.

In the case where the reflecting mirror surface 18A of the spinner mirror unit 16 as scanning means is arranged

in the direction shown in Fig. 7A (the short axis of the reflecting mirror surface 18A coincides with the Y axis), when a laser beam L0 incident on the center of the reflecting mirror surface 18A along the Z axis is deviated in its incident direction by -θX to the X axis direction with respect to the spinner mirror unit 16, the reflected laser beam L0 is displaced by +Δz to the Z direction in a predetermined plane orthogonal to the X axis Also, as shown in Fig. 7B, when the laser beam L0 is deviated by +θY to the Y axis direction with respect to the spinner mirror unit 16, the reflected laser beam L0 is displaced by +Δy to the Y direction in a predetermined plane orthogonal to the X axis. Accordingly, as shown in Fig. 7C, by deviating the laser beam L0 by θXY to the X-Y axis direction, the reflected laser beam L0 can be relatively and two-dimensionally displaced on a recording medium 14. Incidentally, the spinner mirror unit may be constituted such that the reflected laser beam is relatively and two-dimensionally displaced on a recording medium by deviating two laser beams to respective directions by respective distances.

Here, by deviating the laser beam #1 to the minus direction of the X axis and the plus direction of the Y axis each in a predetermined amount, the reflected laser beams #1 and #2 can be modified and arrayed along the Z axis direction on the X-Z plane shown in Fig. 8A. Similarly, when the reflecting mirror surface 18A of the spinner mirror unit 16 is arranged in the direction shown in Fig. 8B, by deviating the laser beam #1 to the plus direction of the X axis and the plus direction of the Y axis each in a predetermined amount, the reflected laser beams #1 and #2 can be modified and arrayed on the X-Z plane as shown in Fig. 8B.

In this way, by two-dimensionally adjusting the incident direction of the laser beam #1 with respect to the reflecting mirror surface 18A, the spots of respective laser beams #1 and #2 on a recording sheet S can be constantly arrayed in the Z axis direction. Accordingly, as shown in Fig. 9, the scanning lines recorded on a recording medium 14 by these laser beams #1 and #2 can be formed as parallel straight lines over the entire scanning region and at the same time, the scanning line lengths can be made equal.

As shown in Fig. 10A, when the spots of the laser beams #1 and #2 incident on the reflecting mirror surface 18A of the spinner mirror unit 16 are projected on a surface S' conjugate with a recording medium 14, the trajectory of the laser beam #1 on the conjugate surface S' associated with the rotation of the spinner mirror unit 16 becomes, as shown in Fig. 10B, a circle represented by:

$$\left.\begin{aligned} X &= -W\cdot\cos\omega t \\ Y &= -W\cdot\sin\omega t \end{aligned}\right\} \quad \text{trajectory of laser beam \#1}$$

assuming that the angular velocity of the spinner mirror unit 16 is ω, and the split width of the laser beams #1 and #2 on the scanning surface (the distance between the position of the beam spot on the scanning surface by the laser beam #1 and the position of the beam spot on the scanning surface by the laser beam #2) is W (shown in Fig. 9). Accordingly, by deflecting the laser beam #1 according to this formula and guiding it to a light scanner 2, as shown in Fig. 9, a plurality of scanning lines spaced apart at a constant distance of the split width W can be formed on the scanning surface.

The constitution of the inner drum exposure apparatus according to the second embodiment is described below by referring to Fig. 6. In the inner drum exposure apparatus according to the second embodiment, first and second two semiconductor laser light sources 30A and 30B (light beam outputting means) are used. More specifically, the first and second semiconductor laser light sources 30A and 30B emit linearly polarized light beams (laser beams) La and Lb, respectively, and these two light beams are each converted into parallel beams by passing through collimating lenses (collimator lenses) 44 and 46, respectively.

The first laser beam La emitted from the first semiconductor laser light source 30A is guided to a polarizing beam splitter 48 and coupled with the second laser beam Lb. Similarly to the inner drum exposure apparatus of the first embodiment shown in Fig. 1, these coupled light beams La and Lb are guided by a 1/4 wavelength plate 32, a reflecting mirror 34, a reflecting mirror 36 and a condenser lens 28 constituting the optical system on the light source side, to a spinner mirror unit 16 of a scanning optical system comprising an optical device 26 of uniaxial crystal. Incidentally, in the case of using two semiconductor laser light sources 30A and 30B as the light source, a laser driver 42A for the first semiconductor laser light source 30A and a laser driver 42B for the second semiconductor laser light source 30B are separately prepared, and each image signal separately produced by a central control unit 40 is sent to respective laser drivers 42A and 42B. Then, the laser drivers 42A and 42B control the drive of the first semiconductor laser light source 30A and the second semiconductor laser light source 30B, respectively, to emit laser beams La and Lb modulated based on respective corresponding image signals, and the laser beams are irradiated on the spinner mirror unit 16 by the optical system on the light source side.

In the optical system on the light source side for the semiconductor laser light source 30B, the second laser beam emitted from the second semiconductor laser light source 30B and converted into parallel beams by the collimating lens 46 passes through an acoustooptic device 52X as light deflecting means of deflecting the light beam in the X axis

direction of the spinner mirror unit 16 and an acoustooptic device 52Y as light deflecting means of deflecting the second laser beam Lb in the Y axis direction, then guided to a polarizing beam splitter 48, and coupled with the first laser beam La. These coupled light beams La and Lb each is converted into right circularly polarized light or left circularly polarized light and, as described above, irradiated on the spinner mirror unit 16 by the optical system on the light source side.

The acoustooptic devices 52X and 52Y as the light deflecting means each is controlled by the circuit shown in Fig. 1. This circuit as the control means comprises a control circuit 54 of generating a control clock signal based on the signal from an encoder (not shown) provided in the spinner mirror unit 16, a cosine-wave signal generating circuit 56a of generating a cosine-wave voltage signal ($X=-a\cdot\cos\omega t$) according to the control clock signal, a sine-wave signal generating circuit 56b of generating a sine-wave voltage signal ($Y=-a\cdot\sin\omega t$) according to the control clock signal, a voltage control oscillator 58a of generating a frequency modulated signal from the cosine-wave voltage signal, a voltage control oscillator 58b of generating a frequency modulated signal from the sine-wave voltage signal, an amplifier 60a of amplifying the frequency modulated signal generated from the voltage control oscillator 58a and supplying the signal to the acoustooptic device 52X, and an amplifier 60b of amplifying the frequency modulated signal generated from the voltage control oscillator 58b of generating a frequency modulated signal from the sine-wave signal, and supplying the signal to the acoustooptic device 52Y.

The mode and operation of the inner drum exposure apparatus according to the second embodiment constituted as above are described below.

The second laser beam Lb emitted from the second semiconductor laser light source 30B (light beam outputting means) and converted into parallel beams by the collimating lens 46 is deflected in the X axis direction by the acoustooptic device 52X as the light deflecting means and then deflected in the Y axis direction by the acoustooptic device 52Y as the light deflecting means (see, Figs. 8A and 8B). Furthermore, the second laser beam Lb is guided to the polarizing beam splitter 48 and coupled with the first laser beam 1a. Thereafter, the second laser beam Lb is introduced into the spinner mirror unit 16 by the optical system on the light source side.

In the spinner mirror unit 16, the second laser beam Lb (#1) is reflected and deflected on the reflecting mirror surface 18A rotating around the Z axis and guided to a recording medium 14.

On the other hand, the first laser beam La (#2) emitted from the first semiconductor laser light source 30A is introduced along the rotation axis of the spinner mirror unit 16, then reflected and deflected on the reflecting mirror surface 18A and guided to a recording medium 14.

The control of the second laser beam Lb (#1) emitted from the second semiconductor light source 30B is described in detail below by referring to Fig. 11.

The control circuit 54 as the control means supplies a control clock signal to the cosine-wave signal generating circuit 56a based on the position signal from an encoder (not shown) provided in the spinner mirror unit 16. The cosine-wave voltage signal ($X=-a\cdot\cos\omega t$) output from the cosine-wave signal generating circuit 56a is converted into a frequency modulated signal by the voltage control oscillator 58a and then supplied to the acoustooptic device 52X through the amplifier 60a. At this time, the second laser beam Lb (#1) is deflected by the acoustooptic device 52X in the X axis direction shown in Figs. 8A and 8B based on the cosine-wave voltage signal.

Also, the control circuit 54 supplies a control clock signal to the sine-wave signal generating circuit 56b. The sine-wave voltage signal ($Y=-a\cdot\sin\omega t$) output from the sine-wave signal generating circuit 56b is converted into a frequency modulated signal by the voltage control oscillator 58b and then supplied to the acoustooptic device 52Y through the amplifier 60b. At this time, the second laser beam Lb (#1) modulated in the X axis direction by the acoustooptic device 52X based on the sine-wave voltage signal is deflected by the acoustooptic device 52Y in the Y axis direction shown in Figs. 8A and 8B based on the sine-wave voltage signal.

As a result, the second laser beam Lb (#1) guided to the reflecting mirror surface 18A of the spinner mirror unit 16 synchronizes with the rotational operation of the spinner mirror unit 16 and, as shown in Figs. 10A and 10B, draws a nearly circular trajectory on the surface S' orthogonal to the rotation axis 18 of the spinner mirror unit 16.

Also, the first laser beam La (#2) emitted from the first semiconductor laser light source 30A is guided on a recording medium 14 without moving the position on the surface S' orthogonal to the rotation axis 18.

In this way, as shown in Fig. 9, the first laser beam La (#2) and the second laser beam Lb (#1) spaced apart at a controlled constant distance are guided to a recording medium 14 and an image is recorded. In this case, the distance between these laser beams can be easily adjusted by the amplification factors set for the amplifiers 60a and 60b.

That is, as shown in Fig. 9, two parallel scanning lines at a constant distance with a fixed length are formed on a recording medium 14. At the same time, similarly to the first embodiment, two scanning lines each is subjected to beam splitting of nearly equally distributing the beam spot at an equivalent light quantity in the sub-scanning direction by the action of the 1/4 wavelength plate 32 and the optical device 26 of uniaxial crystal and overlapping the beam spots with shift to form a nearly rectangular beam spot so as to constantly maintain the condition that each beam spot of two scanning lines forms a nearly rectangular distribution and has a steep edge part and each beam spot is thinly elongated in the sub-scanning direction (that is, the longitudinal direction of the nearly rectangular distribution of the beam spot runs along the sub-scanning direction (direction orthogonal to the main scanning direction)).

In this inner drum exposure apparatus according to the second embodiment, since the exposure process is performed by the two scanning lines each beam-split as described above, the image obtained by recording an FM screen causes no fluctuation in the peripheral length of the recorded picture element due to, for example, recording conditions such as light power variation or number of printed sheets or development conditions such as development degree of the automatic developing machine, is prevented from abrupt change in the percentage of a halftone image (dot area percentage characteristics) and less fluctuates in the density, and the image can be stably and rapidly recorded to express the middle tone by using an FM screen. Furthermore, in the second embodiment, the reliability of accuracy in the recording by scanning can also be enhanced by increasing the number of light beams and setting low the rotation number of the scanning means.

In the above-described second embodiment, the acoustooptic device 52X and the acoustooptic device 52Y as the light deflecting means are separately provided, but these may be integrally fabricated to constitute the light deflecting means such that deflection in the X axis and Y axis directions is realized by one acoustooptic device. Also, an electrooptic device may be used in place of the acoustooptic device. Furthermore, three or more semiconductor laser light sources may be provided to record an image by using a plurality of laser beams emitted therefrom. In addition, an image may be recorded with use of a laser beam obtained by dividing a laser beam emitted from a semiconductor laser light source into a required plural number of beams by a beam splitter.

The constitution, mode of operation and effect of the second embodiment other than described above are the same as those of the first embodiment, and the same reference number is used for the same constituent element, but description thereof is omitted here.

In the present invention, the entire surface of the lithographic printing plate precursor after the above-described exposure process may be, if desired, heated between exposure and development. This heating is advantageous in that the image forming reaction in the photosensitive layer is accelerated, the sensitivity and press life are enhanced, and the sensitivity is stabilized. Also, in the case of having a protective layer on the photosensitive layer, a water washing treatment may be performed before development process.

[Development Process]

The lithographic printing plate precursor on which an image is recorded by performing the exposure with use of the inner drum exposure apparatus described above, is then subjected to development process so as to remove the non-image area. The development process may be in either wet system or dry system. In the case of wet development, an alkali developer or a developer at a pH of 2 to 10 is appropriately selected by taking account of properties of the photosensitive layer of the lithographic printing plate precursor.

The processing rate at the development process, namely, the transportation speed (line speed) of the lithographic printing plate precursor at the development process, is preferably 1.00 m/min or more, more preferably 1.10 m/m or more. The upper limit of the transportation speed is not particularly limited but in view of stability of transportation, is preferably 3 m/min or less.

The alkali developer usable in the present invention is described below.

The alkali developer is not particularly restricted. However, for example, a solution containing an inorganic alkali salt and a surfactant and having a pH of from 11.0 to 12.5 is preferably used.

The inorganic alkali salt is appropriately used. Examples thereof include an inorganic alkali agent, for example, sodium hydroxide, potassium hydroxide, ammonium hydroxide, lithium hydroxide, sodium silicate, potassium silicate, ammonium silicate, lithium silicate, sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate and ammonium borate. The inorganic alkali salts may be used individually or in combination of two or more thereof.

In the case of using the silicate, developing property can be easily adjusted by selecting a mixing ratio of silicon oxide ($SiO_2$) to alkali oxide ($M_2O$ (wherein M represents an alkali metal or an ammonium group)), which are the components of the silicate, and the concentration thereof. An aqueous alkali solution having the mixing ratio of silicon oxide ($SiO_2$) to alkali oxide ($M_2O$) ($SiO_2/M_2O$ in molar ratio) of from 0.5 to 3.0 is preferred, and that of from 1.0 to 2.0 is more preferred. The concentration of the silicate is preferably from 1 to 10 mass%, more preferably from 3 to 8 mass%, most preferably from 4 to 7 mass%, based on the weight of the aqueous alkali solution. When the concentration is 1 mass% or more, there arise no reduction in the developing property and processing ability, and When the concentration is 10 mass% or less, no formation of precipitates and crystals, and no gelation at neutralization of waste liquor of the developer, thereby causing no troubles in treatment of the waste liquor.

Also, an organic alkali agent may be suppleuxentarily used for the purposes of delicate adjustment of alkali concentration and of assisting dissolution of the photosensitive layer. Examples of the organic alkali agent includes monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolimine, diisopropanolanaine, ethyleneimine, ethylenediamine, pyridine and tetramethylammonium hydroxide. The organic alkali agents may be used individually or in combination of two or more thereof.

The surfactant is appropriately used. Examples thereof include nonionic surfactants, for example, a nonionic surfactant having polyoxyalkylene ether group, a polyoxyethylene alkyl ester (e.g., polyoxyethylene stearate), a sorbitan alkyl ester (e.g., sorbitan monolaurate, sorbitan monostearate, sorbitan distearate, sorbitan monooleate, sorbitan sesquioleate or sorbitan trioleate) and a monoglyceride alkyl ester (e.g., glycerol monostearate or glycerol monooleate); anionic surfactants, for example, an alkylbenzenesulfonate (e.g., sodium dodecylbenzenesulfonate), an alkylnaphthalenesulfonate (e.g., sodium butylnaphthalenesulfonate, sodium pentylnaphthalenesulfonate, sodium hexylnaphthalenesulfonate or sodium octylnaphthalenesulfonate), an alkylsulfate (e.g., sodium laurylsulfate), an alkylsulfonate (e.g., sodium dodecylsulfonate) and a sulfosuccinic acid ester salt (e.g., sodium dilaurylsulfosuccinate); and amphoteric surfactants, for example, an alkylbetaine (e.g., laurylbetaine or stearylbetaine) and an amino acid. Nonionic surfactants having a polyoxyalkylene ether group are particularly preferred.

As the surfactant having a polyoxyalkylene ether group, compounds having the structure represented by formula (VI) shown below are preferably used.

$$R_{40}\text{-O-}(R_{41}\text{-O})_pH \qquad \text{(VI)}$$

In the formula, $R_{40}$ represents an alkyl group having from 3 to 15 carbon atoms, an aromatic hydrocarbon group having from 6 to 15 carbon atoms or a heteroaromatic ring group having from 4 to 15 carbon atoms. Each of these groups may have a substituent, and examples of the substituent include an alkylene group having from 1 to 20 carbon atoms, a halogen atom, e.g., Br, Cl or I, an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms and an acyl group having from 2 to 15 carbon atoms. $R_{41}$ represents an alkylene group having from 1 to 100 carbon atoms, which may have a substituent. Examples of the substituent include an alkyl group having from 1 to 20 carbon atoms and an aromatic hydrocarbon group having from 6 to 15 carbon atoms. p represents an integer from 1 to 100.

In the definition of the formula (VI), specific examples of the "aromatic hydrocarbon group" include a phenyl group, a tolyl group, a naphthyl group, an anthryl group, a biphenyl group and a phenanthryl group, and specific examples of the "heteroaromatic ring group" include a furyl group, a thionyl group, an oxazolyl group, an itnidazolyl group, a pyranyl group, a pyridinyl group, an acridinyl group, a benzofuranyl group, a benzothionyl group, a benzopyranyl group, a benzoxazolyl group and a benzimidazolyl group.

Also, the moiety of $(R_{41}\text{-O})_p$ in the formula (VI) may comprise two or three kinds of groups within the above-described scope. Specifically, there may be illustrated a random or block chain of a combination of ethyleneoxy group and propyleneoxy group, a combination of ethyleneoxy group and isopmpyleneoxy group, a combination of ethyleneoxy group and butyleneoxy group, and a combination of ethyleneoxy group and isobutyleneoxy group. In the invention, the surfactants having polyoxyalkylene ether group are used individually or in combination thereof. The surfactant is effectively added in an amount from I to 30 mass%, preferably from 2 to 20 mass%, to the developer. In the above-described range, the developing property is good and printing durability of a printing plate is also good.

Examples of the nonionic surfactant having polyoxyalkylene ether group represented by formula (VI) include a polyoxyethylene alkyl ether, e.g., polyoxyethylene lauryl ether, polyoxyethylene cetyl ether or polyoxyethylene stearyl ether; a polyoxyethylene aryl ether, e.g., polyoxyethylene phenyl ether or polyoxyethylene naphthyl ether; and a polyoxyethylene alkylaryl ether, e.g., polyoxyethylene methylphenyl ether, polyoxyethylene octylphenyl ether or polyoxyethylene nonylphenyl ether.

The surfactants can be used individually or in combination thereof. Also, the amount of the surfactant used in the developer is preferably in the range from 0.1 to 20 mass% in terms of the solid content.

In the alkali developer for use in the present invention, the pH at 25°C is preferably from 10 to 12.5, more preferably from 11 to 12.5. The developer for use in the present invention contains the above-described surfactant and therefore, even when such a low pH alkali developer is used, the non-image area expresses excellent developability. When the developer has such a relatively low pH value, the damage on the image area at the development is reduced and at the same time, excellent handleability of the developer is obtained.

Also, the electric conductivity x of the developer is preferably $2<x<30$ mS/cm, more preferably from 5 to 25 mS/cm.

At this time, an electric conductivity adjusting agent for adjusting the electric conductivity, such as alkali metal salts of an organic acid, and alkali metal salts of an inorganic acid, is preferably added.

This developer can be used as a developer and a development replenisher for the exposed lithographic printing plate precursor and may also be applied to an automatic developing machine. In the case of performing the development by using an automatic developing machine, the developer is exhausted according to the amount processed and therefore, the processing capacity may be restored by using a replenisher or a fresh developer. This replenishing system is

preferably employed also in the plate-making method of the present invention.

In order to restore the processing capacity of the developer by using an automatic developing machine, the replenishment is preferably performed by the method described in U.S. Patent 4,882,246. The developers described in JP-A-50-26601, JP-A-58-54341, JP-B-56-39464, JP-B-56-42860 and JP-B-57-7427 are also preferred.

According to another embodiment of the development process in the present invention, the lithographic printing plate precursor after image exposure is then subjected to a treatment of rubbing the plate surface with a rubbing member in the presence of a developer at a pH of 2 to 10 to remove the photosensitive layer (when a protective layer is formed, remove also the protective layer) in the unexposed area, whereby an image can be formed on the surface of the aluminum plate support.

The developer used here is an aqueous solution at a pH of 2 to 10. For example, an aqueous solution comprising water alone or mainly comprising water (containing water in a proportion of 60 mass% or more) is preferred. In particular, an aqueous solution having the same composition as the generally known fountain solution, an aqueous solution containing a surfactant (e.g., anionic, nonionic, cationic), or an aqueous solution containing a water-soluble polymer compound is preferred, and an aqueous solution containing both a surfactant and a water-soluble polymer compound is more preferred. The pH of the developer is preferably from 3 to 8, more preferably from 4 to 7.

Examples of the anionic surfactant used include fatty acid salts, abietates, hydroxyalkanesulfonates, allcanesulfonates, dialkylsulfosuccinatec, linear alkylbenzenesulfonates, branched alkylbenzenesulfonates, alkylnaphthalenesulfonates, alkylphenoxypolyoxyethylenepropylsulfonates, polyoxyethylenealkylsulfophenyl ether salts, N-methyl-N-oleyltaurine sodium salts, monoamide disodium N-alkylsulfosuccinates, petroleum sulfonates, sulfated castor oil, sulfated beef tallow oil, sulfuric ester salts of fatty acid alkyl ester, alkylsulfuric ester salts, polyoxyethylene alkyl ether sulfuric ester salts, fatty acid monoglyceride sulfuric ester salts, polyoxyethylene alkylphenyl ether sulfuric ester salts, polyoxyethylene styrylphenyl ether sulfuric ester salts, alkylphosphoric ester salts, polyoxyethylene alkyl ether phosphoric ester salts, polyoxyethylene alkylphenyl ether phosphoric ester salts, partially saponified styrene-maleic anhydride copolymerization products, partially saponified olefin-maleic anhydride copolymerization products, and naphthalenesulfonate formalin condensates. Among these, preferred are dialkylsulfosuccinates, alkylsulfuric ester salts and alkylnaphthalenesulfonates.

The cationic surfactant used is not particularly limited and a conventionally known cationic surfactant may be used. Examples thereof include alkylamine salts, quaternary ammonium salts, polyoxyethylenealkylamine salts and polyethylene polyamine derivatives.

Examples of the nonionic surfactant used include a polyethylene glycol-type higher alcohol ethylene oxide adduct, an alkylphenol ethylene oxide adduct, a fatty acid ethylene oxide adduct, a polyhydric alcohol fatty acid ester ethylene oxide adduct, a higher alkylamine ethylene oxide adduct, a fatty amide ethylene oxide adduct, an ethylene oxide adduct of fat or oil, a polypropylene glycol ethylene oxide adduct, a dimethylsiloxane-ethylene oxide block copolymer, a dimethylsiloxane-(propylene oxide-ethylene oxide) block copolymer, a fatty acid ester of polyhydric alcohol-type glycerol, a fatty acid ester of pentaerythritol, a fatty acid ester of sorbitol or sorbitan, a fatty acid ester of sucrose, an alkyl ether of polyhydric alcohol, and a fatty amide of alkanolamines.

One of these nonionic surfactants may be used alone, or two or more thereof may be mixed and used. In the present invention, an ethylene oxide adduct of sorbitol and/or sorbitan fatty acid ester, a polypropylene glycol ethylene oxide adduct, a dimethylsiloxane-ethylene oxide block copolymer, a dimethylsiloxane-(propylene oxide-ethylene oxide) block copolymer, and a fatty acid ester of polyhydric alcohol are more preferred.

In view of stable solubility in water or turbidity, the HLB (hydrophile-lipophile balance) value of the nonionic surfactant for use in the developer is preferably 6 or more, more preferably 8 or more. Furthermore, the proportion of the nonionic surfactant contained in the developer is preferably from 0.01 to 10 mass%, more preferably from 0.01 to 5 mass%.

Furthermore, for example, an acetylene glycol-based or acetylene alcohol-based oxyethylene adduct, or a fluorine-containing or silicon-containing surfactant may also be similarly used.

In view of bubble suppression, the surfactant for use in the developer is preferably a nonionic surfactant.

Examples of the water-soluble polymer compound include soybean polysaccharides, denatured starch, gum arabic, dextrin, a cellulose derivative (e.g., carboxymethyl cellulose, carboxyethyl cellulose, methyl cellulose) or a denatured product thereof, pullulan, polyvinyl alcohol or a derivative thereof, polyvinylpyrrolidone, a polyacrylamide or acrylamide copolymer, a vinyl methyl ether/maleic anhydride copolymer, a vinyl acetate/maleic anhydride copolymer, and a styrene/maleic anhydride copolymer.

As for the soybean polysaccharides, a known compound may be used. For example, Soyafive (trade name, produced by Fuji Oil Co., Ltd.) is commercially available and those in various grades can be used, but a product of giving an aqueous 10 mass% solution having a viscosity of 10 to 100 mPa/sec is preferred.

The denatured starch can also be a known compound and may be produced, for example, by a method where a starch such as corn, potato, tapioca, rice and wheat is decomposed with an acid, an enzyme or the like in the range of a glucose residue number of 5 to 30 per molecule, and an oxypropylene is further added in an alkali.

The water-soluble polymer compounds may also be used in combination of two or more thereof. The content of the water-soluble polymer compound in the developer is preferably from 0.1 to 20 mass%, more preferably from 0.5 to 10 mass%.

The developer may contain an organic solvent. Examples of the organic solvent which can be contained include aliphatic hydrocarbons (e.g., hexane, heptane, "Isopar E, H, G" (produced by ESSO Kagaku K.K.), gasoline, kerosene), aromatic hydrocarbons (e.g., toluene, xylene), halogenated hydrocarbons (e.g., methylene dichloride, ethylene dichloride, trichlene, monochlorobenzene), and a polar solvent.

Examples of the polar solvent include alcohols (e.g., methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenyl carbinol, n-amyl alcohol, methylamyl alcohol), ketones (e.g., acetone, methyl ethyl ketone, ethyl butyl ketone, methyl isobutyl ketone, cyclohexanone), esters (e.g., ethyl acetate, propyl acetate, butyl acetate, amyl acetate, benzyl acetate, methyl lactate, butyl lactate, ethylene glycol monobutyl acetate, propylene glycol monomethyl ether acetate, diethylene glycol acetate, diethyl phthalate, butyl levulinate), and others (e.g., triethyl phosphate, tricresyl phosphate, N-phenylethanolamine, N-phenyldiethanolamine).

When the organic solvent is insoluble in water, the organic solvent may be solubilized in water by using a surfactant or the like and then used. In the case of containing an organic solvent in the developer, from the standpoint of safety and flammability, the solvent concentration is preferably less than 40 mass%

In addition to these components, the developer may contain an antiseptic, a chelating compound, a defoaming agent, an organic acid, an inorganic acid, an inorganic salt and the like.

Examples of the antiseptic which can be preferably used include phenol or a derivative thereof, formalin, an imidazole derivative, sodium dehydroacetate, a 4-isothiazolin-3-one derivative, benzisothiazolin-3-one, a benzotriazole derivative, an amidine guanidine derivative, quaternary ammonium salts, a derivative of pyridine, quinoline or guanidine, diazine, a triazole derivative, oxazole, an oxazine derivative, and an nitrobromoalcohol-based compound such as 2-bromo-2-nitropropane-1,3-diol, 1,1-dibromo-1-nitro-2-ethanol and 1,1-dibromo-1-nitro-2-propanol.

Examples of the chelating compound include organic phosphonic acids and phosphonoalkanetricarboxylic acids, such as ethylenediaminetetraacetic acid, and potassium and sodium salts thereof; diethylenetriaminepentaacetic acid, and potassium and sodium salts thereof; triethylenetetraminehexaacetic acid, and potassium and sodium salts thereof; hydroxyethylethylenediaminetriacetic acid, and potassium and sodium salts thereof; nitrilotriacetic acid and a sodium salt thereof; 1-hydroxyethane-1,1-diphosphonic acid, and potassium and sodium salts thereof, and aminotri (methylenephosphonic acid), and potassium and sodium salts thereof In place of the sodium or potassium salt of these chelating agents, an organic amine salt is also effective.

As for the defoaming agent, a compound such as a silicon-based self-emulsifying or emulsifying defoaming agent in general or a nonionic surfactant having an HLB of 5 or less, may be used. A silicon defoaming agent is preferred.

The defoaming agent may be any type such as emulsion-dispersing type or solubilizing type.

Examples of the organic acid include a citric acid, an acetic acid, an oxalic acid, a malonic acid, a salicylic acid, a caprylic acid, a tartaric acid, a malic acid, a lactic acid, a levulinic acid, a p-toluenesulfonic acid, a xylenesulfonic acid, a phytic acid and an organic phosphonic acid. The organic acid may also be used in the form of its alkali metal salt or ammonium salt.

Examples of the inorganic acid and inorganic salt include a phosphoric acid, a metaphosphoric acid, an ammonium primary phosphate, an ammonium secondary phosphate, a sodium primary phosphate, a sodium secondary phosphate, a potassium primary phosphate, a potassium secondary phosphate, a sodium tripolyphosphate, a potassium pyrophosphate, a sodium hexametaphosphate, a magnesium nitrate, a sodium nitrate, a potassium nitrate, an ammonium nitrate, a sodium sulfate, a potassium sulfate, an ammonium sulfate, a sodium sulfite, an ammonium sulfite, a sodium bisulfate and a nickel sulfate.

The above-described developer may be used as a developer and a development replenisher for the exposed negative lithographic printing plate precursor and is preferably applied to an automatic processor described later. In the case of performing the development by using an automatic processor, the developer is exhausted according to the amount processed and therefore, the processing capacity may be restored by using a replenisher or a fresh developer. This replenishing system is preferably employed also in the plate-making method of the lithographic printing plate precursor of the present invention.

In the present invention, the development process with an aqueous solution at a pH of 2 to 10 can be suitably performed by an automatic processor equipped with developer supply means and a rubbing member. Examples of the automatic processor include an automatic processor described in JP-A-2-220061 and JP-A-60-59351, in which the rubbing treatment is performed while transporting the lithographic printing plate precursor after recording of an image; and an automatic processor described in U.S. Patents 5,148,746 and 5,568,768 and British Patent 2,297,719, in which the lithographic printing plate precursor after recording of an image is set on a cylinder and then rubbed while rotating

the cylinder. Among these, an automatic processor using a rotating brush roller as the rubbing member is preferred.

The rotating brush roller which can be preferably used in the present invention can be appropriately selected by taking account of, for example, scratch resistance of the image area and nerve strength of the support of the lithographic printing plate precursor. As for the rotating brush roller, a known rotating brush roller produced by implanting a brush material in a plastic or metal roller can be used. For example, a rotating brush roller described in JP-A-58-159533 and JP-A-3-100554, or a brush roller described in JP-U-B-62-167253 (the term "JP-UM-B" as used herein means an "examined Japanese utility model publication"), in which a metal or plastic groove-type member having implanted therein in rows a brush material is gaplessly radially wound around a plastic or metal roller working out to a core, can be used.

As for the brush material, a plastic fiber (for example, a polyester-based synthetic fiber such as polyethylene terephthalate and polybutylene terephthalate; a polyamide-based synthetic fiber such as nylon 6.6 and nylon 6.10; a polyacrylic synthetic fiber such as polyacrylonitrile and alkyl poly(meth)acrylate; and a polyolefin-based synthetic fiber such as polypropylene and polystyrene) can be used. For example, a brush material having a fiber bristle diameter of 20 to 400 μm and a bristle length of 5 to 30 mm can be suitably used.

The outer diameter of the rotating brush roller is preferably from 30 to 200 mm, and the peripheral velocity at the tip of the brush rubbing the plate surface is preferably from 0.1 to 5 m/sec.

The rotating brushing rollers is preferably used in a plural number of two or more.

The rotation direction of the rotating brush roller for use in the present invention may be the same as or opposite the transportation direction of the lithographic printing plate precursor of the present invention, but when two or more rotating brush rollers are used as in an automatic processor shown in Fig. 12, it is preferred that at least one rotating brush roller rotates in the same direction and at least one rotating brush roller rotates in the opposite direction. By such rotation, the thermosensitive layer in the non-image area can be more unfailingly removed. Furthermore, a technique of rocking the rotating brush roller in the rotation axis direction of the brush roller is also effective.

The developer may be used at an arbitrary temperature, but the developer temperature is preferably from 10 to 50°C.

The thus-developed lithographic printing plate precursor can be after-treated with washing water, a rinsing solution containing a surfactant and the like, or a desensitizing solution containing gum arabic, a starch derivative and the like, as described, for example, in JP-A-54-8002, JP-A-55-115045 and JP-A-59-58431. The after-treatment of the lithographic printing plate precursor according to the present invention may be performed by variously combining these treatments.

In the plate-making method of a lithographic printing plate precursor of the present invention, the image after development may be subjected to after-heating or exposure of the entire surface.

The heating after development can employ very strong conditions and is usually performed at a heating temperature of 200 to 500°C. If the temperature at the hating after development is low, a sufficiently high effect of strengthening the image may not be obtained, whereas if it is too high, there may arise a problem such as deterioration of support and thermal decomposition of image area.

The lithographic printing plate obtained after such a treatment is loaded on an offset printing press and used for printing of a large number of sheets.

As for the plate cleaner used for removing scumming on the plate at the printing, a conventionally known plate cleaner for PS plates is used and examples thereof include CL-1, CL-2, CP, CN-4, CN, CG-1, PC-1, SR and IC (produced by Fuji Photo Film Co., Ltd.).

[Examples]

The present invention is described below by referring to Examples, but the present invention is not limited thereto.

[Examples 1 to 2 and Comparative Example 1]

(Production of Support)

An aluminum plate (according to JIS A1050) having a thickness of 0.30 mm and a width of 1,030 mm was subjected to the following surface treatment.

<Surface Treatment>

In the surface treatment, the following treatments (a) to (f) were continuously performed. Incidentally, the liquid was squeezed out by nip rollers after each processing and water washing.

(a) The aluminum plate was etched under the conditions that the sodium hydroxide concentration was 26 mass%

(containing 6.5 mass% of aluminum ion ) and the temperature was 70°C, to dissolve 5 g/m$^2$ of the aluminum plate and then washed with water.

(b) The aluminum plate was desmutted by spraying an aqueous solution having a nitric acid concentration of 1 mass% (containing 0.5 mass% of aluminum ion) at a temperature of 30°C and then washed with water.

(c) The aluminum plate was subjected to a continuous electrochemical surface roughening treatment by using an AC voltage of 60 Hz. At this time, the electrolytic solution was an aqueous 1 mass% nitric acid solution (containing 0.5 mass% of aluminum ion and 0.007 mass% of ammonium ion) at a temperature of 30°C. The electrochemical surface roughening treatment was performed by using an AC power source of giving a rectangular wave AC having a trapezoidal waveform such that the time TP necessary for the current value to reach the peak from zero was 2 msec and the duty ratio was 1:1, and disposing a carbon electrode as the counter electrode. The auxiliary anode was ferrite. The current density was 25 A/dm$^2$ in terms of the peak value of current, and the quantity of electricity was 250 C/dm$^2$ in terms of a total quantity of electricity when the aluminum plate was serving as the anode. Also, 5% of the current flowing from the power source was split to the auxiliary anode. Thereafter, the aluminum plate was washed with water.

(d) The aluminum plate was etched at 35°C by spraying under the conditions such that the sodium hydroxide concentration was 26 mass% (containing 6.5 mass% of aluminum ion) to dissolve 0.2 g/m$^2$ of the aluminum plate, thereby removing the smut component mainly comprising aluminum hydroxide produced at the previous electrochemical surface roughening with use of AC. Also, the edge portion of the produced pit was dissolved to smoothen the edge part. Thereafter, the aluminum plate was washed with water

(e) The aluminum plate was desmutted by spraying an aqueous solution having a sulfuric acid concentration of 25 mass% (containing 0.5 mass% of aluminum ion) at a temperature of 60°C and then washed with water by spraying.

(f) The aluminum plate was subjected to an anodization treatment for 50 seconds under the conditions such that the sulfuric acid concentration was 170 g/liter (containing 0.5 mass% of aluminum ion), the temperature was 33°C and the current density was 5 (A/dm$^2$), and then washed with water. At this time, the weight of the anodic oxide film was 2.7 g/m$^2$.

The thus-obtained aluminum support had a surface roughness Ra of 0.27 (measuring meter: Surfcom manufactured by Tokyo Seimitsu Co., Ltd., probe tip diameter: 2 μm).

<Undercoat Layer>

The following undercoat solution was coated on the support by using a bar coater to have a dry coated amount of 2 mg/m$^2$ and dried at 80°C for 20 seconds.

[Undercoat Solution]

| | |
|---|---|
| Polymer (P1) | 0.3 g |
| Pure water | 60.0 g |
| Methanol | 939.7 g |

Polymer (P1):

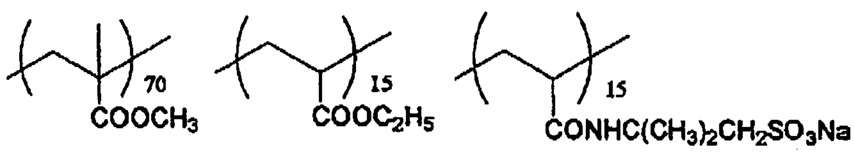

[Production of Lithographic Printing Plate Precursor 1]

A photosensitive composition (1) according to the following formulation was coated on the support by using a bar coater and dried at 100°C for 1 minute. The mass of the photosensitive layer after drying was 1.1 g/m$^2$.

(Photosensitive Composition (1))

| | |
|---|---|
| Polymerizable compound: Ethylenically Unsaturated Bond-Containing Compound (A-1) | 0.46 parts by mass |
| Binder Polymer (B-1) | 0.51 parts by mass |
| Sensitizing Dye (D39) | 0.03 parts by mass |
| Polymerization initiator (C-1): (produced by Kurogane Kasei Co., Ltd.) | 0.12 parts by mass |
| Dispersion of ε-Phthalocyanine (F-1) | 0.47 parts by mass |
| Mercapto Compound (S-1) | 0.09 parts by mass |
| Fluorine-containing nonionic surfactant (Megafac F-780F, produced by Dai-Nippon Ink & Chemicals, Inc.) | 0.009 parts by mass |
| N-nitrosophenylhydroxylamine aluminum salt (Cupferron produced by Wako Pure Chemical Industries, Ltd.) | 0.003 parts by mass |
| Methyl ethyl ketone | 7.4 parts by mass |
| Propylene glycol monomethyl ether | 7.4 parts by mass |

Coating Solution (1) for Protective Layer having the following composition was coated on the photosensitive layer by a bar coater to give a dry coated mass of 2.4 $g/m^3$ and dried at 120°C for 1 minute to obtain Lithographic Printing Plate Precursor 1.

(Coating Solution (1) for Protective Layer)

| | |
|---|---|
| Polyvinyl alcohol (PVA 205, produced by Kuraray Co., Ltd., saponification degree: 88 mol%, polymerization degree: 500) | 5.0 parts by mass |
| Nonionic surfactant (EMALEX 710, produced by produced by Nihon Emulsion Co., Ltd.) | 0.09 parts by mass |
| Pure water | 94.91 parts by mass |

[Production of Lithographic Printing Plate Precursor 2]

A photosensitive composition (2) according to the following formulation was coated on the support by using a bar coater and dried at 100°C for 1 minute. The mass of the photosensitive layer after drying was 1.3 $g/m^2$.

(photosensitive Composition (2))

| | |
|---|---|
| Polymerizable compound: Ethylenically Unsaturated Bond-Containing Compound (A-1) | 1.5 parts by mass |
| Binder Polymer (B-2) | 1.6 parts by mass |
| Sensitizing Dye (D29) | 0.15 parts by mass |
| Photopolymerization Initiator (C-2) | 0.12 parts by mass |
| Dispersion of ε-Phthalocyanine (F-1) | 0.02 parts by mass |
| Sensitization Aid (G-1) | 0.5 parts by mass |
| Fluorine-containing nonionic surfactant (Megafac F-780F, produced by bai-Nippon Ink & Chemicals, Inc.) | 0.02 parts by mass |
| Methyl ethyl ketone | 26.0 parts by mass |
| Propylene glycol monomethyl ether | 26.3 parts by mass |

Coating Solution (2) for Protective Layer having the following composition was coated on the photosensitive layer by a bar coater to give a dry coated mass of 2.5 $g/m^2$ and dried at 120°C for 1 minute to obtain Lithographic Printing Plate Precursor 2.
(Coating Solution (2) for Protective Layer)

| | |
|---|---|
| Polyvinyl alcohol (saponification degree: 98 mol%, polymerization degree: 500) | 5.0 parts by mass |
| Nonionic surfactant (EMALEX 710, produced by produced by Nihon Emulsion Co., Ltd.) | 0.09 parts by mass |
| Pure water | 94.91 parts by mass |

Structures of Ethylenically Unsaturated Bond-Containing Compound (A,-1), ε-Phthalocyanine (F-1), Photopolymerization Initiator (C-1) and (C-2), Sensitization Aid (G-1), Binder Polymers (B-1) and (B-2) and Mercapto Compound (S-1) used in Photosensitive Compositions (1) and (2) are shown below. Sensitizing Dyes (D39) and (D29) are compounds set forth as specific examples above.

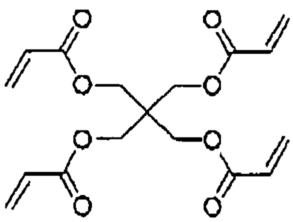

A-1

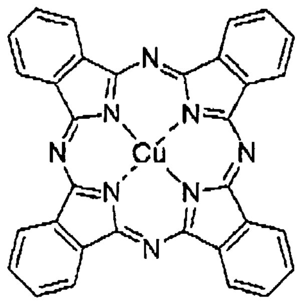

F-1

(C-1)

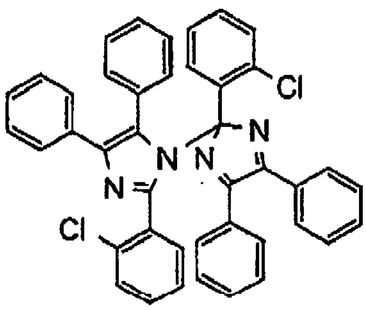

(C-2)

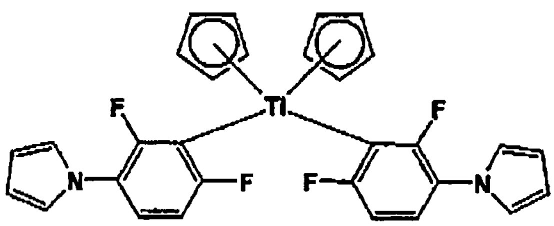

(G-1)

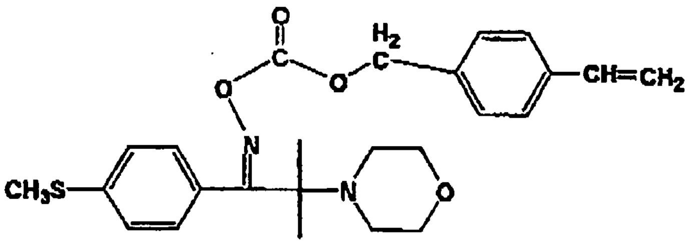

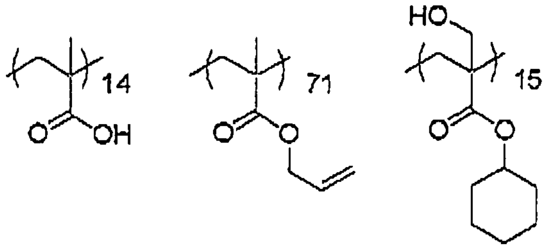

B-1

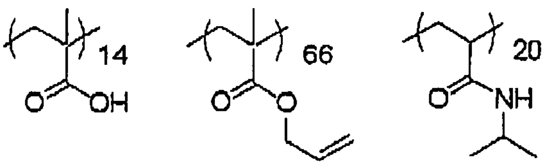

B-2

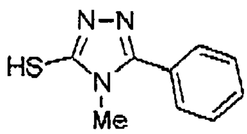

S-1

[Evaluation of Flat Tint Unevenness]

The lithographic printing plate precursor obtained above was subjected to drawing of a 35% flat tint image with an exposure amount of 90 μJ/cm$^2$ at a resolution of 2,438 dpi by FM Screen TAFFETA 20 manufactured by Fuji Photo Film Co., Ltd. As for the exposure apparatus, Violet Semiconductor Laser Setter Vx9600 (InGaN-based semiconductor laser, light emission: 405 nm±10 nm, output: 30 mW) manufactured by FUJIFILM Electronic Imaging Ltd., and an exposure apparatus prepared by modifying Vx9600 and mounting a light source having a beam shape of the present invention and shown in Fig. 1, were used. After the exposure, by using an automatic developing machine LP1250PLX, the plate was subjected to heating at 100°C for 10 seconds, removal of the PVA protective layer by water washing, and then development at 28°C for 20 seconds. As for the developer, a developer prepared by 5-fold diluting DV-2 produced by Fuji Photo Film Co., Ltd. with water was charged. The pate after development was washed in a rinsing bath and transferred to a gumming bath. A gumming solution prepared by 2-fold diluting FP-2W produced by Fuji Photo Film Co., Ltd. with water was used. The plate after gumming was dried with hot air and discharged to obtain a lithographic printing plate having drawn thereon a 35% flat tint image of an FM screen. The flat tint area percentage of the obtained lithographic printing plate was measured by CC-dot 5 (produced by CEN TURFAX Ltd.), and the difference (δdot) between the maximum area and the minimum area was calculated. The δdot is preferably smaller and in practice, preferably 2.0% or less. If the difference is 3.0% or more, this is a level of practically causing a problem.

The results are shown in Table 1.

Table 1

| | Lithographic Printing Plate Precursor | Exposure Apparatus | δdot |
|---|---|---|---|
| Example 1 | (1) | Exposure Apparatus of the present invention | 0.5% |
| Example 2 | (2) | Exposure Apparatus of the present invention | 1.0% |
| Comparative Example 1 | (2) | Vx9600 | 3.5% |

As apparent from Table 1, in Examples 1 and 2 according to the plate-making method of the present invention using the specific exposure apparatus described above, the flat tint area difference (δdot) is as small as 1.0% or less, and good results with less flat tint fluctuation are obtained. On the other hand, in the plate-making method of Comparative Example, the flat tint area difference is as large as 3.5% and this is a level of flat tint fluctuation of causing a problem in practice.

[Examples 3 to 10 and Comparative Example 2]

(Preparation of Support)

A 0.3 mm-thick aluminum plate (construction material: JIS1050) was degreased with an aqueous 10 mass% sodium aluminate solution at 50°C for 30 seconds to remove the rolling oil on the surface. Thereafter, the aluminum plate surface was grained by using three nylon brushes implanted with bundled bristles having a diameter of 0.3 mm and a pumice-water suspension (specific gravity: 1.1 g/cm$^3$) having a median diameter of 25 μm, and then thoroughly washed with water. This plate was etched by dipping it in an aqueous 25 mass% sodium hydroxide solution at 45°C for 9 seconds and after washing with water, dipped in 20 mass% nitric acid at 60°C for 20 seconds, followed by washing with water. At this time, the etched amount of the grained surface was about 3 g/m$^2$.

Subsequently, the aluminum plate was subjected to continuous electrochemical surface-roughening treatment by using an AC voltage at 60 Hz. The electrolytic solution used here was an aqueous 1 mass% nitric acid solution (containing 0.5 mass% of aluminum ion) at a liquid temperature of 50°C. In this electrochemical surface-roughening treatment, an AC power source of giving a trapezoidal rectangular wave AC such that the time TP necessary for the current value to reach the peak from zero was 0.8 msec and the duty ratio was 1:1, was used and a carbon electrode was disposed as the counter electrode. For the auxiliary anode, ferrite was used. The current density was 30 A/dm$^2$ in terms of the peak value of current, and 5% of the current flowing from the power source was split to the auxiliary anode. The quantity of electricity at the nitric acid electrolysis was 175 C/dm$^2$ when the aluminum plate was serving as the anode. Thereafter, the aluminum plate was water-washed by spraying.

Subsequently, the aluminum plate was subjected to electrochemical surface-roughening treatment in the same manner as in the nitric acid electrolysis above by using an electrolytic solution comprising an aqueous 0.5 mass% hydrochloric acid solution (containing 0.5 mass% of aluminum ion) at a liquid temperature of 50°C under the conditions such that the quantity of electricity was 50 C/dm$^2$ when the aluminum plate was serving as the anode, and then water-washed by spraying. This plate was treated in 15 mass% sulfuric acid (containing 0.5 mass% of aluminum ion) as the electrolytic solution at a current density of 15 A/dm$^2$ to provide a DC anodic oxide film of 2.5 g/m$^2$, then washed with water and dried.

The center line average roughness (Ra) of the thus-obtained support was measured by using a needle having a diameter of 2 μm and found to be 0.51 μm.

Thereafter, the following undercoat solution was bar-coated to have a dry coated amount of 10 mg/m$^2$, and then dried in an oven at 80°C for 10 seconds to produce a support having an undercoat layer.

<Undercoat Solution>

| | |
|---|---|
| Undercoat Compound (1) | 0.017 g |
| Methanol | 9.00 g |
| Water | 1.00 g |

Undercoat Compound (1):

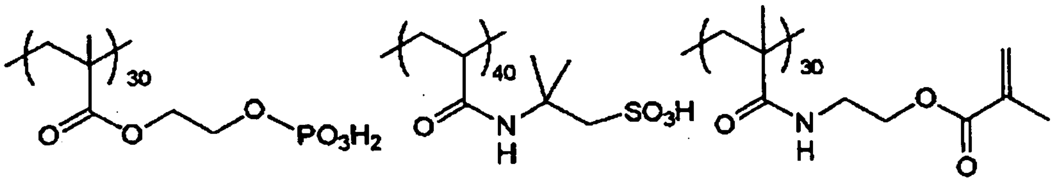

[Production of Lithographic Printing Plate Precursor (3)]

On the support with an undercoat layer prepared above, Coating Solution (3) for Photosensitive Layer having the following composition was bar-coated and then dried in an oven at 70°C for 60 seconds to form a photosensitive layer having a dry coated amount of 1.1 g/m$^2$. On this photosensitive layer, Coating Solution (3) for Protective Layer having the following composition was coated by using a bar to give a dry coated amount of 0.75 g/m$^2$ and then dried at 125°C for 70 seconds to form a protective layer, thereby obtaining Lithographic Printing Plate Precursor (3).

<Coating Solution (3) for Photosensitive Layer>

| | | |
|---|---|---|
| Binder Polymer (1) shown below (average molecular weight: 80,000) | | 0.54 g |
| Polymerizable compound: | | 0.40 g |
| | isocyanuric acid EO-modified triacrylate (Aronics M-315, produced by Toa Gosei Co., Ltd.) | |
| Polymerizable compound: | | 0.08 g |
| | ethoxylated trimethylolpropane triacrylate (SR9035, produced by Nippon Kayaku Co., Ltd., EO addition molar number: 15, molecular weight: 1,000) | |
| Sensitizing Dye (1) shown below | | 0.06 g |
| Polymerization Initiator (1) shown below | | 0.18 g |
| Co-Sensitizer (1) | | 0.07 g |
| Dispersion of ε-phthalocyanine pigment | | 0.40 g |
| | (pigment: 15 parts by mass, Binder Polymer (1) as the dispersant: 10 parts by mass, cyclohexanonelmethoxypropyl acetate/1-methoxy-2-propanol as solvents = 15 parts by mass/20 parts by mass/40 parts by mass) | |
| Thermopolymerization inhibitor | | 0.01 g |
| | N-nitrosophenylhydroxylamine aluminum salt | |
| Fluorine-Containing Surfactant (1) | | 0.001 g |
| Polyoxyethylene-polyoxypropylene condensate (Pluronic L44, produced by Asahi Denka Co., Ltd.) | | 0.04 g |
| Tetraethylamine hydrochloride | | 0.01 g |
| 1-Methoxy-2-propanol | | 3.5 g |
| Methyl ethyl ketone | | 8.0 g |

Binder Polymer (1):

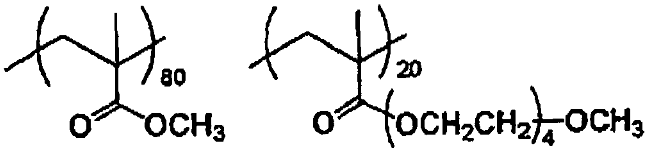

Sensitizing Dye (1):

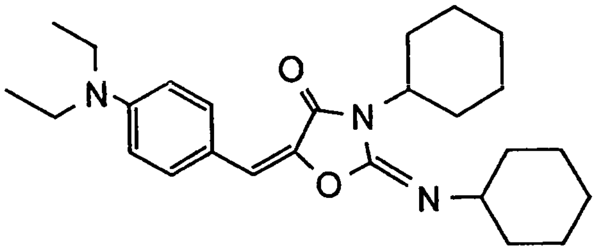

Polymerization Initiator (1):

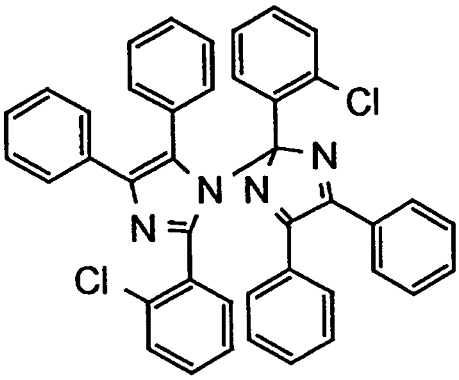

Co-Sensitizer (1):

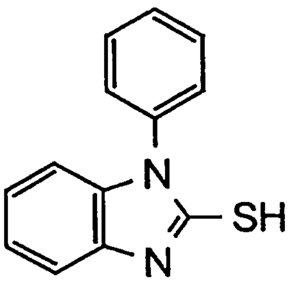

Fluorine-Containing Surfactant (1):

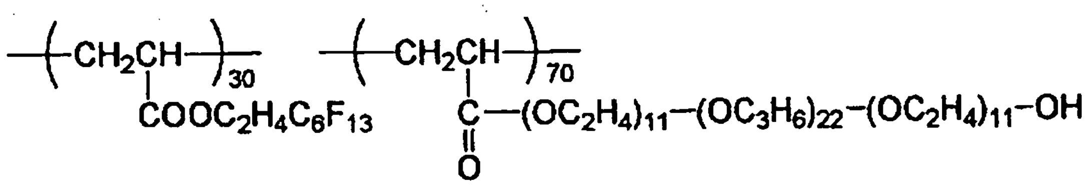

Coating Solution (3) for Protective Layer:

| | |
|---|---|
| Polyvinyl alcohol (saponification degree: 98 mol%, polymerization degree: 500) | 40 g |
| Polyvinylpyrrolidone (molecular weight: 50,000) | 5 g |
| Poly(vinylpyrrolidone/vinyl acetate (1/1)), molecular weight: 70,000 | 0.5 g |
| Surfactant (EMALEX 710, produced by produced by Nihon Emulsion Co., Ltd.) | 0.5 g |
| Water | 950 g |

[Production of Lithographic Printing Plate Precursor (4)]

Lithographic Printing Plate Precursor (4) was obtained in the same manner as in Production of Lithographic Printing Plate Precursor (3) except that Sensitizing Dye (1), Polymerization Initiator (1) and Co-Sensitizer (1) of Coating Solution (3) for Photosensitive Layer were changed to the following Sensitizing Dye (2), Polymerization Initiator (2) and Co-Sensitizer (2), respectively.

Sensitizing Dye (2):

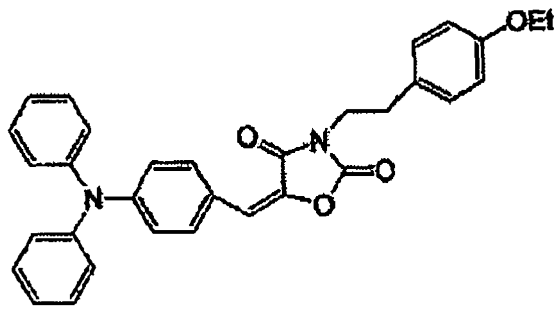

Polymerization Initiator (2):

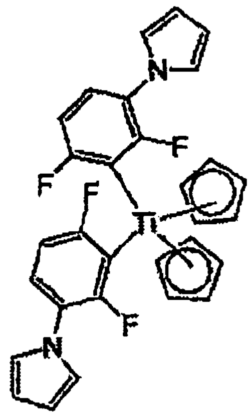

Co-Sensitizer (2):

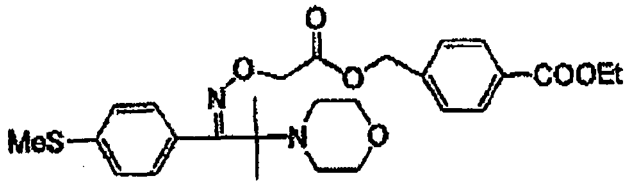

[Production of Lithographic Printing Plate Precursor (5)]

Lithographic Printing Plate Precursor (5) was obtained in the same manner as in Production of Lithographic Printing Plate Precursor (3) except that Coating Solution (3) for Photosensitive Layer was changed to Coating Solution (4) for Photosensitive Layer having the following composition.

<Coating Solution (4) for Photosensitive Layer >

| | |
|---|---|
| Polymerization Initiator (1) | 0.2 g |
| Sensitizing Dye (1) | 0.1 g |
| Binder Polymer (1) (average molecular weight: 80,000) | 3.0 g |
| Polymerizable compound: isocyanuric acid EO-modified diacrylate (Aronics M-215, produced by Toa Gosei Co., Ltd.) | 6.2 g |
| Leuco Crystal Violet | 0.2 g |
| Fluorine-Containing Surfactant (1) | 0.1 g |
| Aqueous dispersion of Microcapsule (1) shown below | 25.0 g |
| Methyl ethyl ketone | 35.0 g |
| 1-Methoxy-2-propanol | 35.0 g |

(Preparation of Aqueous Dispersion of Microcapsule (1))

As the oil phase component, 10 g of trimethylolpropane and xylene diisocyanate adduct (Takenate D-110N, produced by Mitsui Takeda Chemicals, Inc.), 4.15 g of isocyanuric acid EO-modified diacrylate (Aronics M-215, produced by Toa Gosei Co., Ltd.) and 0.1 g of Pionin A-41C (produced by Takemoto Oil & Fat Co., Ltd.) were dissolved in 17 g of ethyl acetate. As the aqueous phase component, 40 g of an aqueous 4 mass% PVA-205 solution was prepared. The oil phase component and the aqueous phase component were mixed and emulsified by using a homogenizer at 12,000 rpm for 10 minutes. The resulting emulsified product was added to 25 g of distilled water and the mixture was stirred at

room temperature for 30 minutes and then stirred at 40°C for 3 hours. The thus-obtained microcapsule solution was diluted with distilled water to a solid content concentration of 20 mass%. The average particle diameter was 0.25 μm.

[Production of Lithographic Printing Plate Precursor (6)]

Lithographic Printing Plate Precursor (6) was obtained in the same manner as Lithographic Printing Plate Precursor (3) except that the polymerizable compound, Aronics M-315, in Coating Solution (3) for Photosensitive Layer was changed to PLEX 6661-O (produced by Rohm GmbH & KG, 7,7,9-trimethyl-4,13-dioxo-3,14-dioxa-5,12-diazahexadecane-1,16-diyl dimethacrylate).

[Production of Lithographic Printing Plate Precursor (7)]

Lithographic Printing Plate Precursor (7) was obtained in the same manner as Lithographic Printing Plate Precursor (3) except for changing Binder Polymer (1) in Coating Solution (3) for Photosensitive Layer to Binder Polymer (2) shown below.

[Production of Lithographic Printing Plate Precursor (8)]

Lithographic Printing Plate Precursor (8) was obtained in the same manner as Lithographic Printing Plate Precursor (3) except for changing Binder Polymer (1) in Coating Solution (3) for Photosensitive Layer to Binder Polymer (3) shown below.

[Production of Lithographic Printing Plate Precursor (9)]

Lithographic Printing Plate Precursor (9) was obtained in the same manner as Lithographic Printing Plate Precursor (3) except for changing Binder Polymer (1) in Coating Solution (3) for Photosensitive Layer to Binder Polymer (4) shown below.

Binder Polymer (2):

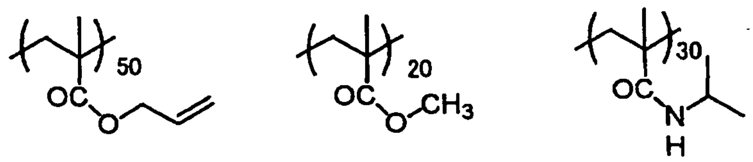

Binder Polymer (3):

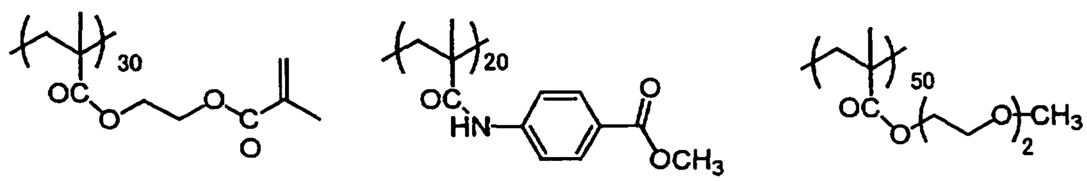

Binder Polymer (4):

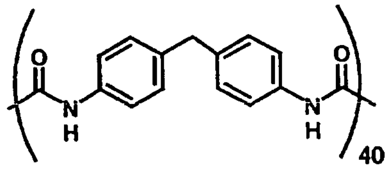 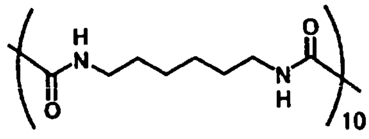

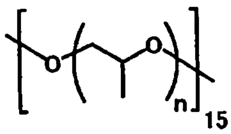 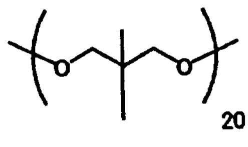 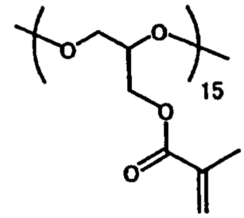

[Production of Lithographic Printing Plate Precursor (10)]

Lithographic Printing Plate Precursor (10) was obtained in the same manner as Lithographic Printing Plate Precursor (3) except that Coating Solution (4) for Protective layer having the following composition was used in place of Coating Solution (3) for Protective Layer and coated by using a bar to give a dry coated amount of 0.2 g/m$^2$.

Coating Solution (4) for Protective Layer:

| | |
|---|---|
| Aqueous Mica Dispersion (1) shown below | 13.0 g |
| Polyvinyl alcohol (saponification degree: 98 mol%, polymerization degree: 500) | 1.3 g |
| Sodium 2-ethylhexylsulfosuccinate | 0.2 g |
| Poly(vinylpyrrolidone/vinyl acetate (1/1)), molecular weight: 70,000 | 0.05 g |
| Surfactant (EMALEX 710, produced by produced by Nihon Emulsion Co., Ltd.) | 0.05 g |
| Water | 133 g |

(Preparation of Aqueous Mica Dispersion (1))

In 368 g of water, 32 g of synthetic mica (SOMASIF ME-100, produced by CO-OP Chemical Co., Ltd., aspect ratio: 1,000 or more) was added and dispersed by using a homogenizer until the average particle diameter (as determined by the laser scattering method) became 0.5 μm to obtain Aqueous Mica Dispersion (1).

(1) Exposure

Lithographic Printing Plate Precursors (3) to (10) each was subjected to drawing of a 35% flat tint image with an exposure amount of 90 μJ/cm$^2$ at a resolution of 2,438 dpi by FM Screen (TAFFETA 20) manufactured by Fuji Photo Film Co., Ltd.

As for the exposure apparatus, a violet semiconductor laser setter (Vx9600 (InGaN-based semiconductor laser, light emission: 405 nm±10 nm, output: 30 mW)) manufactured by FUJIFILM Electronic Imaging Ltd., and an exposure apparatus (InGaN-based semiconductor laser, light emission: 405 nm±10 nm, output: 30 mW) prepared by modifying Vx9600 and mounting a light source having a beam shape of the present invention shown in Fig. 1, were used.

(2) Development

The lithographic printing plate precursor after exposure was developed in an automatic development processor having a structure shown in Fig. 12 by using Developer (1) having the following composition. The pH of the developer was 5. The automatic development processor was an automatic processor having two rotating brush rollers. As for the rotating brush rollers used, the first brush roller was a brush roller having an outer diameter of 90 mm and produced by implanting a polybutylene terephthalate-made fiber (bristle diameter: 200 μm, bristle length: 17 mm), and this brush

roller was rotated at 200 rpm in the same direction as the transportation direction (peripheral velocity at the tip of brush: 0.94 m/sec). The second brush roller was a brush roller having an outer diameter of 60 mm and produced by implanting a polybutylene terephthalate-made fiber (bristle diameter: 200 μm, bristle length: 17 mm), and this brush roller was rotated at 200 rpm in the direction opposite the transportation direction (peripheral velocity at the tip of brush: 0.63 m/sec). The lithographic printing plate precursor was transported at a transportation speed of 100 cm/min.

The developer was supplied to the plate surface by showering from a spray pipe with use of a circulating pump. The tank volume for developer was 10 liter.

Developer (1)

| | |
|---|---|
| Water | 100 g |
| Benzyl alcohol | 1 g |
| Polyoxyethylene naphthyl ether (average oxyethylene number n = 13) | 1 g |
| Sodium salt of dioctylsulfosuccinic acid ester | 0.5 g |
| Gum arabic | 1 g |
| Ethylene glycol | 0.5 g |
| Ammonium primary phosphate | 0.05 g |
| Citric acid | 0.05 g |
| Ethylenediaminetetraacetate tetrasodium salt | 0.05 g |

(3) Evaluation of Flat Tint Unevenness

The flat tint area percentage of the lithographic printing plate obtained after the development was measured by a dot analyzer, CC-dot5 (manufactured by CENTURFAX Ltd.), and the difference (Δdot) between the maximum area and the minimum area was calculated. The Δdot is preferably smaller and in practice, preferably 2.0% or less. If the difference is 3.0% or more, this is a level of practically causing a problem. The results are shown in Table 2.

Table 2

| | Lithographic Printing Plate Precursor | Exposure Apparatus | Δdot (%) |
|---|---|---|---|
| Example 3 | (3) | Exposure Apparatus of the present invention | 1.0 |
| Example 4 | (4) | Exposure Apparatus of the present invention | 1.5 |
| Comparative Example 2 | (4) | Vx9600 | 4.0 |
| Example 5 | (5) | Exposure Apparatus of the present invention | 0.5 |
| Example 6 | (6) | Exposure Apparatus of the present invention | 1.0 |
| Example 7 | (7) | Exposure Apparatus of the present invention | 0.5 |
| Example 8 | (8) | Exposure Apparatus of the present invention | 0.5 |
| Example 9 | (9) | Exposure Apparatus of the present invention | 0.5 |
| Example 10 | (10) | Exposure Apparatus of the present invention | 1.0 |

[Example 11]

The image exposure, development process and evaluation of flat tint unevenness were performed in the same manner as in Example 3 except that the polyoxyethylene naphthyl ether of Developer (1) was changed to an anionic surfactant shown below and 0.1 g of a defoaming agent, FS Antifoam DR110N (produced by Dow Corning, silicone-based emulsion), was added. As a result, Δdot was 1.0%. The pH of the developer was 5.

Anionic Surfactant:

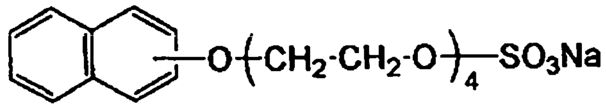

[Example 12]

The image exposure, development process and evaluation of flat tint unevenness were performed in the same manner as in Example 3 except for changing Developer (1) to Developer (2) shown below, as a result, Δdot was 1.0%. The pH of the developer was 4.5.

Developer (1)

| | |
|---|---|
| Water | 100 g |
| Sodium alkylnaphthalenesulfonate (PELEX NB-L, produced by Kao Corp.) | 5 g |
| Gum arabic | 1 g |
| Ammonium primary phosphate | 0.05 g |
| Citric acid | 0.05 g |
| Ethylenediaminetetraacetate tetrasodium salt | 0.05 g |

As apparent from Table 2, in Examples 3 to 12 according to the plate-making method of the present invention using the specific exposure apparatus described above, the flat tint area difference (Δdot) is as small as 1.5% or less, and good results with less flat tint fluctuation are obtained. On the other hand, in the plate-making method of Comparative Example, the flat tint area difference is as large as 4.0% and this is a level of flat tint fluctuation of causing a problem in practice.

According to the present invention, a plate-making method of a lithographic printing plate precursor can be provided, where even when a lithographic printing plate precursor having a photosensitive layer allowing for writing by a laser light source having an oscillation wavelength in the range from 360 to 450 nm is subjected to drawing of an image of an FM screen, a high-precision image can be stably obtained.

The entire disclosure of each and every foreign patent application from which the benefit of foreign priority has been claimed in the present application is incorporated herein by reference, as if fully set forth.

## Claims

1. A plate-making method of a lithographic printing plate precursor, which comprises exposing a lithographic printing plate precursor comprising a support and a photosensitive layer by utilizing an inner drum exposure apparatus having mounted thereon a light source having an oscillation wavelength in a range from 360 to 450 nm,
wherein the photosensitive layer comprises a photosensitive composition comprising: a sensitizing dye capable of absorbing light at 360 to 450 nm; a polymerization initiator; a polymerizable compound; and a binder polymer,
wherein the inner drum exposure apparatus produces a light beam spot shape of a light beam emitted from the light source in which the light beam is divided into an ordinary ray and an extraordinary ray parallel to each other at an equivalent light quantity, and two beam spots of the ordinary ray and the extraordinary ray are adjacently arrayed

in a sub-scanning direction so as to partially overlap with each other, and
wherein the lithographic printing plate precursor is loaded on the inner drum exposure apparatus and then subjected to image recording by exposure with the light beam spot shape.

**2.** The plate-making method according to claim 1,
wherein the image recording at the exposure is performed by utilizing an FM screen.

**3.** The plate-making method according to claim 1,
wherein a wet or dry development process is performed after the image recording.

**4.** The plate-making method according to claim 3,
wherein wet development by alkali development or water development is performed at the development process.

**5.** The plate-making method according to claim 1,
wherein the lithographic printing plate precursor further comprises a protective layer on the photosensitive layer.

**6.** A plate-making method of a lithographic printing plate precursor, which comprises: exposing a lithographic printing plate precursor comprising a support and a photosensitive layer by utilizing an inner drum exposure apparatus having mounted thereon a light source having an oscillation wavelength in a range from 360 to 450 nm; and then removing a photosensitive layer in an unexposed area by rubbing the plate surface with a rubbing member in a presence of a developer at a pH of 2 to 10 in an automatic processor equipped with a rubbing member,
wherein the photosensitive layer comprises a photosensitive composition comprising: a sensitizing dye capable of absorbing light at 360 to 450 nm; a polymerization initiator; a polymerizable compound; and a hydrophobic binder polymer,
wherein the inner drum exposure apparatus produces a light beam spot shape of a light beam emitted from the light source in which the light beam is divided into an ordinary ray and an extraordinary ray parallel to each other at an equivalent light quantity, and two beam spots of the ordinary ray and the extraordinary ray are adjacently arrayed in a sub-scanning direction so as to partially overlap with each other, and
wherein the lithographic printing plate precursor is loaded on the inner drum exposure apparatus and then subjected to image recording by exposure with the light beam spot shape.

**7.** The plate-making method according to claim 6,
wherein the image recording at the exposure is performed by utilizing an FM screen.

**8.** The plate-making method according to claim 6,
wherein the lithographic printing plate precursor further comprises a protective layer on the photosensitive layer.

**9.** The plate-making method according to claim 6,
wherein the hydrophobic binder polymer has an acid value of 0.3 meq/g or less.

**10.** The plate-making method according to claim 6,
wherein the hydrophobic binder polymer is at least one member selected from a (meth)acrylic copolymer having a crosslinking group in a side chan and a polyurethane resin having a crosslinking group in a side chain.

**11.** The plate-making method according to claim 6,
wherein constituent components of the photosensitive layer are partially or entirely enclosed in a microcapsule.

**12.** The plate-making method according to claim 6,
wherein the rubbing member comprises at least two rotating brush rollers.

**13.** The plate-making method according to claim 6,
wherein a pH of the developer is from 3 to 8.

**14.** The plate-making method according to claim 1,
wherein the polymerization initiator is a hexaarylbiimidazole.

**15.** The plate-making method according to claim 6,
wherein the polymerization initiator is a hexaarylbiimidazole.

FIG. 1

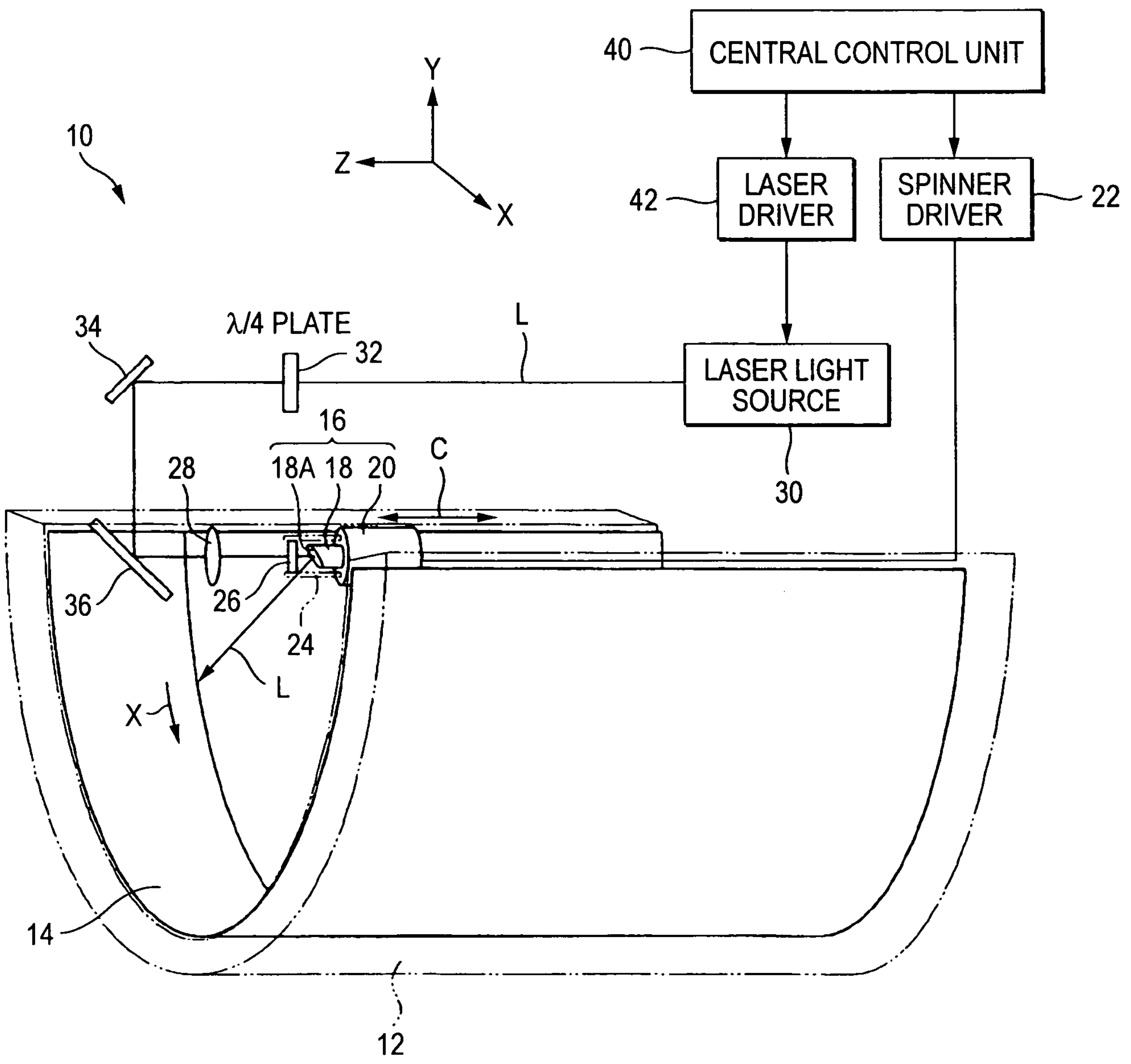
40
CENTRAL CONTROL UNIT
Y
Z
X
10
42
LASER DRIVER
SPINNER DRIVER
22
34
λ/4 PLATE
32
L
LASER LIGHT SOURCE
16
C
28
18A 18 20
30
36
26
24
L
X
14
12

FIG. 2

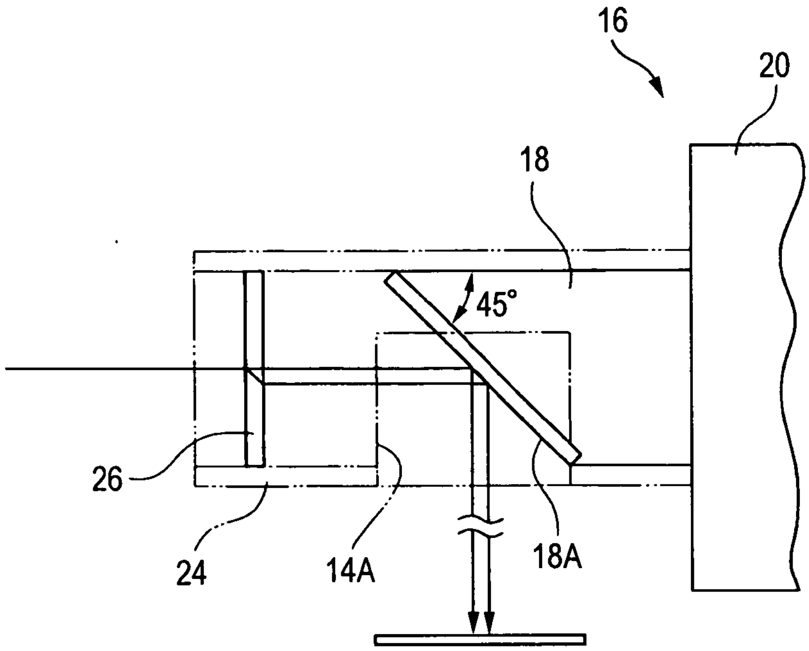

FIG. 3

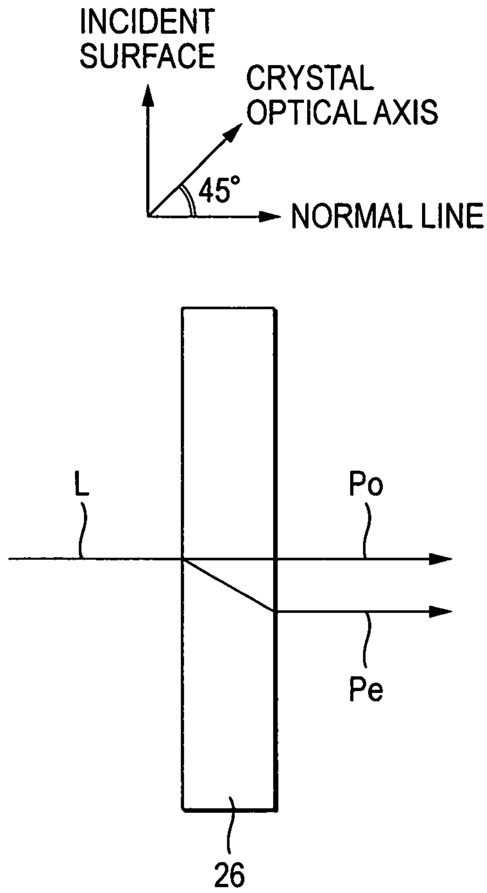
INCIDENT
SURFACE
CRYSTAL
OPTICAL AXIS
45°
NORMAL LINE
L
Po
Pe
26

FIG. 4

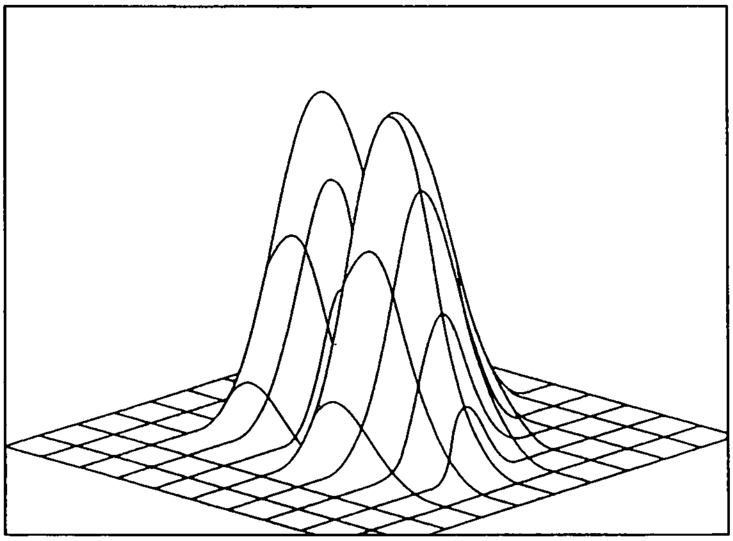

FIG. 5

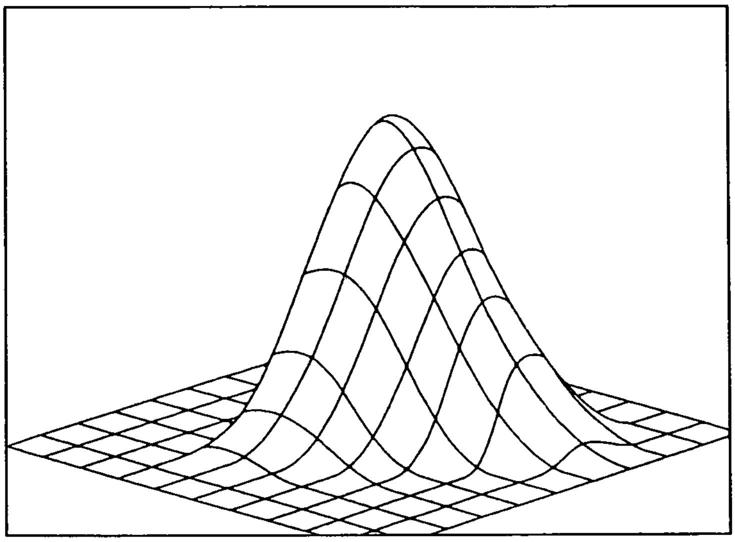

FIG. 6

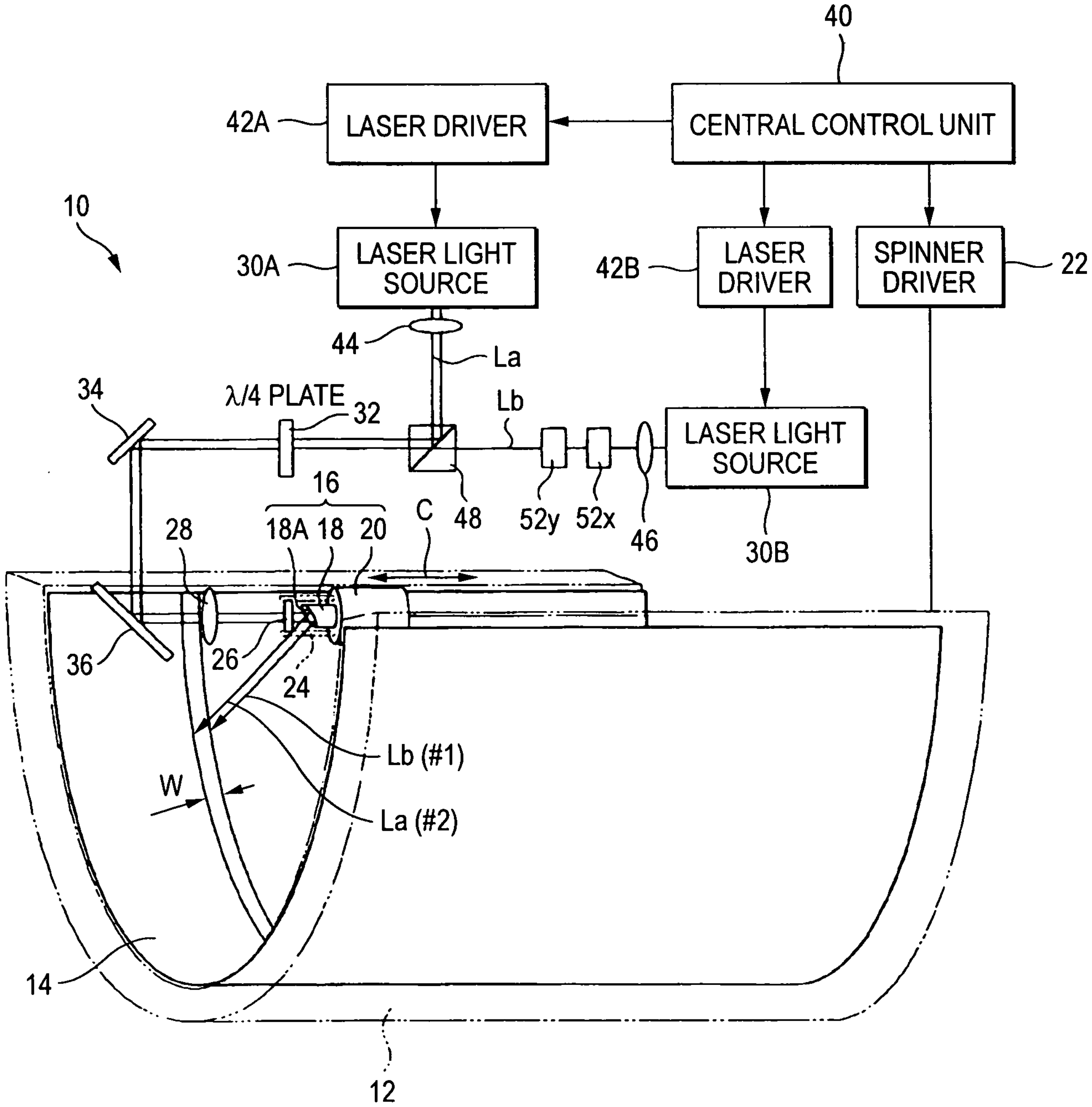
40
CENTRAL CONTROL UNIT
42A
LASER DRIVER
10
30A
LASER LIGHT SOURCE
42B
LASER DRIVER
SPINNER DRIVER
22
44
La
34
λ/4 PLATE
32
Lb
LASER LIGHT SOURCE
16
18A 18 20
C
48
52y 52x
46
30B
28
36
26
24
Lb (#1)
W
La (#2)
14
12

FIG. 7A

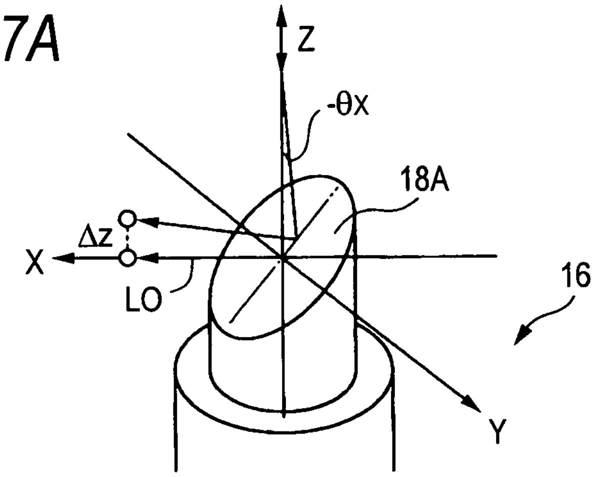


FIG. 7B

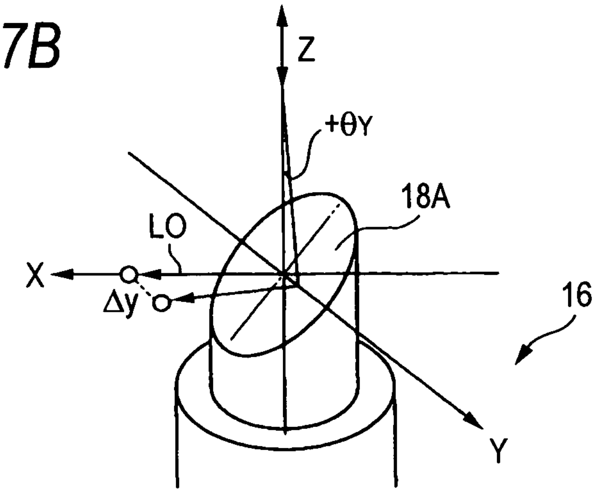


FIG. 7C

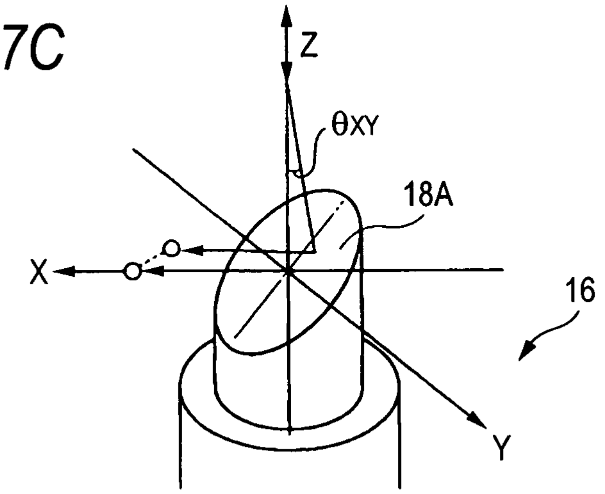

FIG. 8A

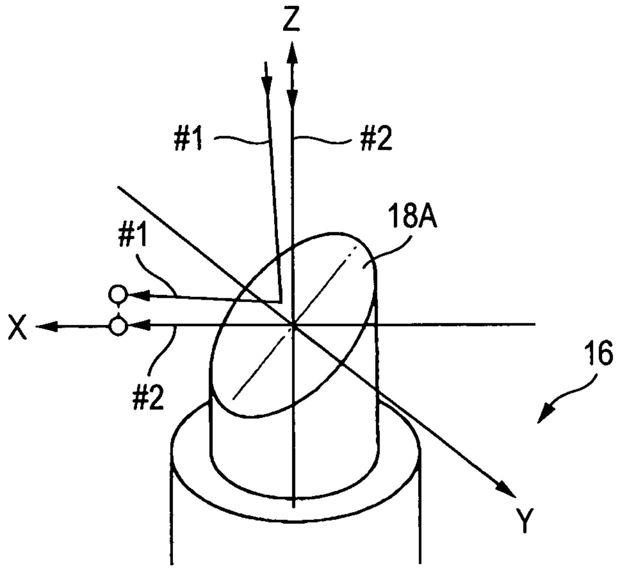


FIG. 8B

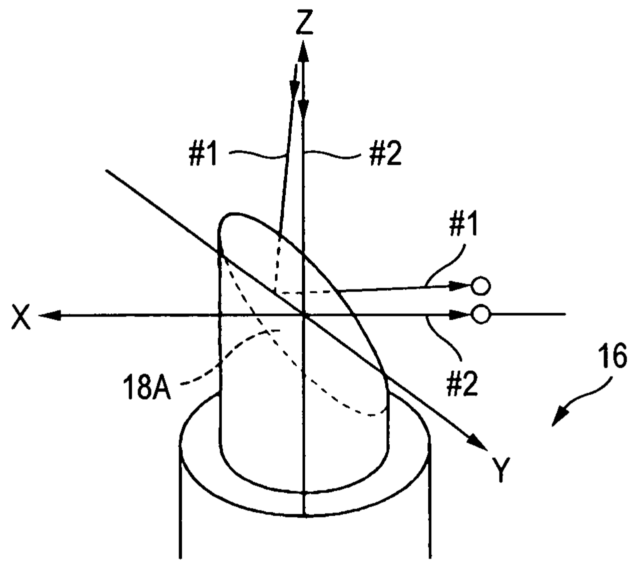

FIG. 9

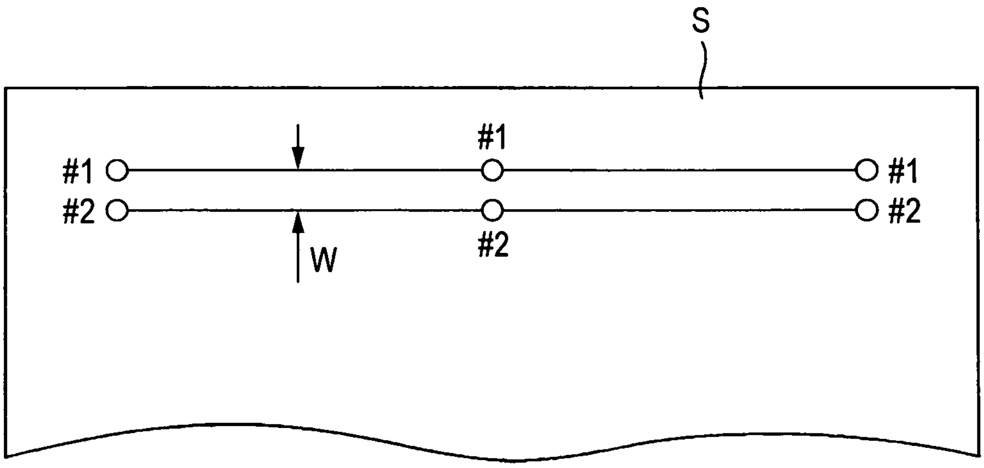

FIG. 10A

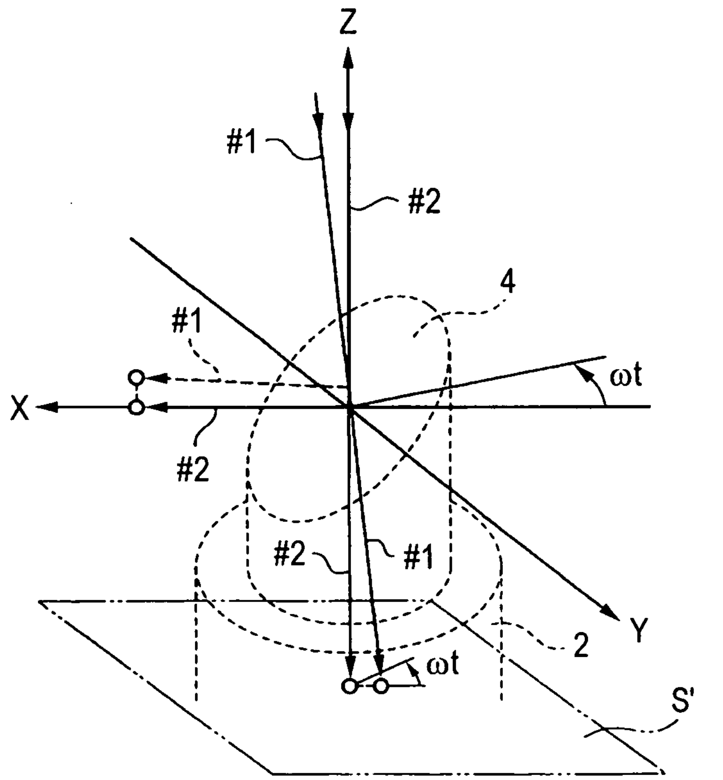


FIG. 10B

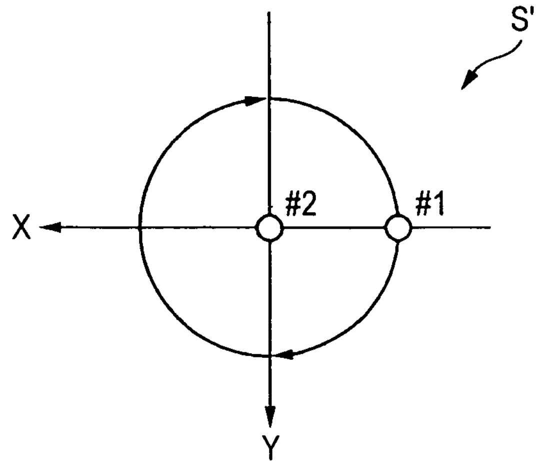

# FIG. 11

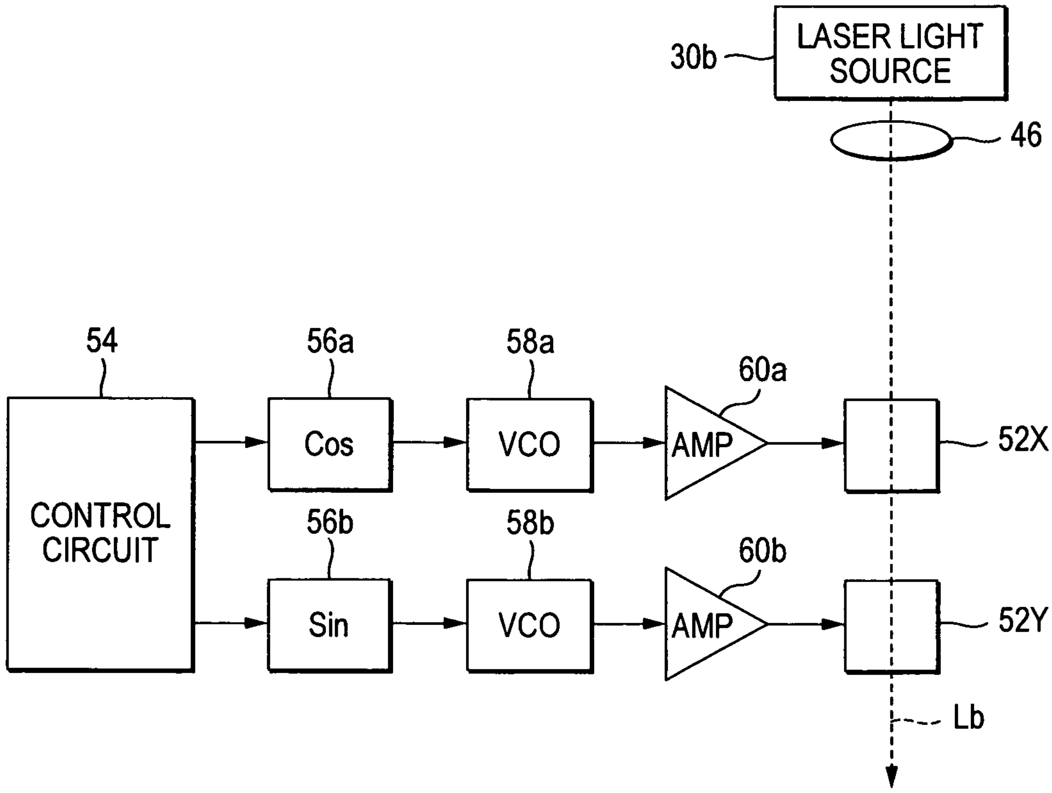
LASER LIGHT SOURCE
30b
46
54
CONTROL CIRCUIT
56a
Cos
58a
VCO
60a
AMP
52X
56b
Sin
58b
VCO
60b
AMP
52Y
Lb

*FIG. 12*

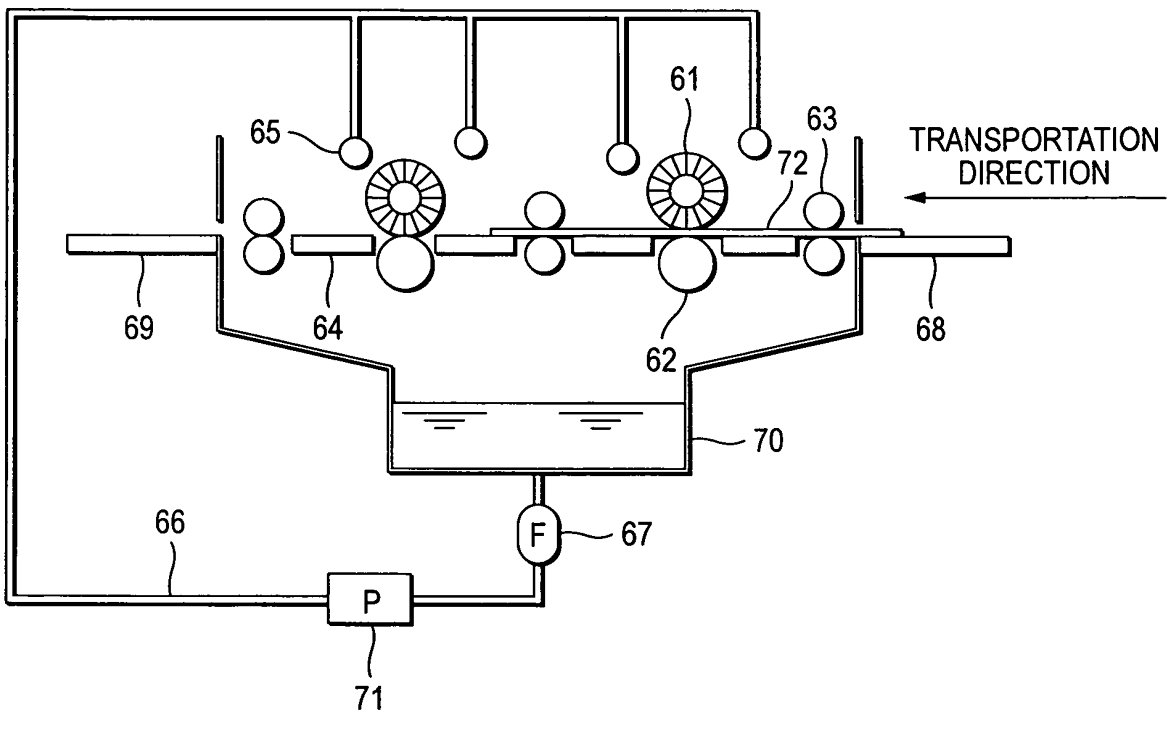

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003043703 A
- JP 10133132 A
- JP 3296759 A
- JP 59028329 B
- US 2850445 A
- JP 4420189 B
- JP 4537377 B
- JP 47002528 B
- JP 54155292 A
- JP 48084183 A
- JP 54151024 A
- JP 52112681 A
- JP 58015503 A
- JP 59140203 A
- JP 59001504 A
- JP 59189340 A
- JP 62174203 A
- JP 62001641 B
- US 4766055 A
- JP 63178105 A
- JP 63258903 A
- JP 2063054 A
- JP 62143044 A
- JP 62150242 A
- JP 6413140 A
- JP 6413141 A
- JP 6413142 A
- JP 6413143 A
- JP 6413144 A
- JP 6417048 A
- JP 1229003 A
- JP 1298348 A
- JP 1138204 A
- JP 2179643 A
- JP 2244050 A
- US 3905815 A
- JP 46004605 B
- JP 48036281 A
- JP 53133428 A
- JP 55032070 A
- JP 60239736 A
- JP 61169835 A
- JP 61169837 A
- JP 62058241 A
- JP 62212401 A
- JP 63070243 A
- JP 63298339 A
- JP 8108621 A
- JP 59152396 A
- JP 61151197 A
- JP 63041484 A
- JP 2000249 A
- JP 2004705 A
- JP 5083588 A
- JP 1304453 A
- JP 1152109 A
- JP 6029285 B
- US 3479185 A
- US 4311783 A
- US 4622286 A
- DD 1470154
- EP 24629 A
- EP 107792 A
- US 4410621 A
- EP 215453 A
- DD 3211312
- JP 9188685 A
- JP 9188686 A
- JP 9188710 A
- JP 2000131837 A
- JP 2002107916 A
- JP 2764769 B
- JP 2002116539 A
- JP 6157623 A
- JP 6175564 A
- JP 6175561 A
- JP 6175554 A
- JP 6175553 A
- JP 6348011 A
- JP 7128785 A
- JP 7140589 A
- JP 7306527 A
- JP 7292014 A
- JP 61166544 A
- JP 2003328465 A
- JP 2000066385 A
- JP 2000080068 A
- US 4069055 A
- JP 4365049 A
- US 4069056 A
- EP 104143 A
- US 339049 A
- US 410201 A
- JP 2150848 A
- JP 2296514 A
- EP 370693 A
- EP 390214 A
- EP 233567 A

- EP 297443 A
- EP 297442 A
- US 4933377 A
- US 161811 A
- US 4760013 A
- US 4734444 A
- US 2833827 A
- DE 2904626
- DE 3604580
- DE 3604581
- JP 2001343742 A
- JP 2002148790 A
- JP 51047334 B
- JP 57196231 A
- JP 59005240 A
- JP 59005241 A
- JP 2226149 A
- JP 1165613 A
- JP 54021726 B
- JP 48041708 B
- JP 51037193 A
- JP 2032293 B
- JP 2016765 B
- JP 58049860 B
- JP 56017654 B
- JP 62039417 B
- JP 62039418 B
- JP 63277653 A
- JP 63260909 A
- JP 1105238 A
- JP 48064183 A
- JP 49043191 B
- JP 52030490 B
- JP 46043946 B
- JP 1040337 B
- JP 1040336 B
- JP 2025493 A
- JP 61022048 A
- JP 59044615 A
- JP 54034327 B
- JP 58012577 B
- JP 54025957 B
- JP 54092723 A
- JP 59053836 A
- JP 59071048 A
- JP 7120040 B
- JP 7120041 B
- JP 7120042 B
- JP 8012424 B
- JP 63287944 A
- JP 63287947 A
- JP 1271741 A
- JP 11352691 A
- JP 9236913 A
- JP 2001277740 A
- JP 2001277742 A
- US 2800457 A
- US 2800458 A
- US 3287154 A
- JP 3819574 B
- JP 42446 B
- US 3418250 A
- US 3660304 A
- US 3796669 A
- US 3914511 A
- US 4001140 A
- US 4087376 A
- US 4089802 A
- US 4025445 A
- JP 369163 B
- JP 51009079 A
- GB 930422 A
- US 3111407 A
- GB 952807 A
- GB 967074 A
- JP 62170950 A
- JP 62226143 A
- JP 60168144 A
- JP 62293247 A
- JP 48018327 B
- JP 54063902 A
- JP 53012739 A
- JP 48028123 B
- JP 2001253181 A
- JP 2001322365 A
- US 2714066 A
- US 3181461 A
- US 3280734 A
- US 3902734 A
- JP 3622063 B
- US 3276868 A
- US 4153461 A
- US 4689272 A
- US 3658662 A
- JP 46027481 B
- JP 52058602 A
- JP 52030503 A
- JP 2001199175 A
- JP 2002097772 A
- JP 2002079772 A
- JP 10282679 A
- JP 2304441 A
- JP 50007481 B
- JP 54072104 A
- JP 59101651 A
- JP 60149491 A
- JP 60232998 A
- JP 3056177 A
- JP 4282637 A
- JP 5016558 A
- JP 5246171 A
- JP 7159983 A
- JP 7314937 A
- JP 8202025 A
- JP 8320551 A
- JP 9034104 A

- JP 9236911 A
- JP 9269593 A
- JP 10069092 A
- JP 10115931 A
- JP 10161317 A
- JP 10260536 A
- JP 10282682 A
- JP 11084674 A
- JP 11038635 A
- JP 11038629 A
- JP 10282645 A
- JP 10301262 A
- JP 11024277 A
- JP 11109641 A
- JP 10319600 A
- JP 11327152 A
- JP 2000010292 A
- JP 2000235254 A
- JP 2000352824 A
- JP 2001209170 A
- JP 2001175001 A
- JP 5045885 A
- JP 6035174 A
- US 3458311 A
- JP 55049729 B
- US 292501 A
- US 44563 A
- US 4882246 A
- JP 50026601 A
- JP 58054341 A
- JP 56039464 B
- JP 56042860 B
- JP 57007427 B
- JP 2220061 A
- JP 60059351 A
- US 5148746 A
- US 5568768 A
- GB 2297719 A
- JP 58159533 A
- JP 3100554 A
- JP 62167253 B
- JP 54008002 A
- JP 55115045 A
- JP 59058431 A

**Non-patent literature cited in the description**

- **L.G. BROOKER et al.** *J. Am. Chem. Soc.,* 1951, vol. 73, 5326-5358
- **WAKABAYASHI et al.** *Bull. Chem. Soc. Japan,* 1969, vol. 42, 2924
- **M.P. HUTT.** *Journal of Heterocyclic Chemistry,* 1970, vol. 1 (3
- **MARTIN KUNZ.** *Rad Tech '98. Proceeding,* 19 April 1998
- **J. C.S. PERKIN II.** *J.C.S. Perkin II,* 1979, 1653-1660
- **J. C.S. PERKIN II.** *J.C.S. Perkin II,* 1979, 156-162
- *Journal of Photopolymer Science and Technology,* 1995, 202-232
- **S.I. SCHLESINGER.** *Photogr. Sci. Eng.,* 1974, vol. 18, 387
- **T.S. BAL et al.** *Polymer,* 1980, vol. 21, 423
- **J.V. CRIVELLO et al.** *Macromolecules,* 1977, vol. 10 (6), 1307
- **J.V. CRIVELLO et al.** *J. Polymer Sci., Polymer Chem. Ed.,* 1979, vol. 17, 1047
- **C.S. WEN et al.** *Teh. Proc. Conf. Rad. Curing ASIA,* October 1988, 478
- **ADHESION.** *Adhesion,* 1984, vol. 20 (7), 300-308